# EUROPEAN PATENT APPLICATION

(11) **EP 4 815 678 A1**
(43) Date of publication of application: **30.09.2026**
(21) Application number: 25188321.1
(22) Date of filing: 09.07.2025
(51) Int. Cl.: H10F 10/166, H10F 71/00, H10F 77/14, H10F 77/70

(54) **PHOTOVOLTAIC CELL, METHOD FOR MANUFACTURING THE SAME, AND PHOTOVOLTAIC MODULE**

(30) Priority: 28.03.2025 CN 202510389501; 28.03.2025 CN 202510399185; 28.03.2025 CN 202510388205; 28.03.2025 CN 202510397862
(71) Applicant: Zhejiang Jinko Solar Co., Ltd., Haining, Zhejiang 314416 (CN)
(72) Inventor: LIU, Feng, Haining, Zhejiang 314416 (CN); ZHANG, Yuanfang, Haining, Zhejiang 314416 (CN); WANG, Zhao, Haining, Zhejiang 314416 (CN); ZHANG, Liqin, Haining, Zhejiang 314416 (CN); ZHENG, Peiting, Haining, Zhejiang 314416 (CN); YANG, Jie, Haining, Zhejiang 314416 (CN); ZHANG, Xinyu, Haining, Zhejiang 314416 (CN)
(74) Representative: Balder IP Law, S.L.

(57) **Abstract**

A photovoltaic cell is provided and includes a substrate, having a first surface and a second surface opposite to each other. The first surface includes first regions and second regions alternately arranged in a first direction. The photovoltaic cell includes grooves, located in the substrate at the second regions and recessed into the substrate. A single groove includes a bottom surface, and a side wall connecting the bottom surface to a first region adjacent to the bottom surface. The side wall includes at least one slope inclined towards the first region. The bottom surface is provided as a first textured surface including a plurality of first pyramids, the side wall includes a second textured surface including a plurality of second pyramids, and a single first pyramid of the plurality of first pyramids has a height greater than a height of a single second pyramid of the plurality of second pyramids.

## Description

### TECHNICAL FIELD

Various embodiments described in this document relate in general to the field of photovoltaics, and in particular to a photovoltaic cell, a method for manufacturing the photovoltaic cell and a photovoltaic module.

### BACKGROUND

With gradual depletion of fossil energy sources, photovoltaic cells are being used more and more widely as a new energy alternative, which convert light energy from the sun into electrical energy. The photovoltaic cells utilize the photovoltaic principle to generate carriers, and then use electrodes to draw the carriers out, thereby facilitating efficient utilization of the electrical energy.

In order to enhance the electrical performance of photovoltaic cells, the regions of the photovoltaic cells that are directly opposite to the electrodes and the regions that are not directly opposite to the electrodes are generally designed differently. For example, a stepped structure is formed on a surface of a substrate, and the electrodes are located on the protruding portion of the substrate.

However, due to the differences in the formation methods of the stepped structure and the differences in the specific morphology of the stepped structure, the absorption and utilization rate of light by the stepped structure will be affected. In order to further improve the photoelectric conversion efficiency of the photovoltaic cells, it is necessary to conduct further research on the stepped structure with lower reflectivity.

### SUMMARY

Embodiments of the present disclosure provide a photovoltaic cell, a method for manufacturing the photovoltaic cell, and a photovoltaic module, which are at least beneficial to improving the absorption and utilization rate of light in the second regions, thereby improving the photoelectric conversion efficiency of the photovoltaic cell. The invention is set out in the appended sets of claims.

According to some embodiments of the present disclosure, a photovoltaic cell is provided. The photovoltaic cell includes a substrate having a first side and a second side opposite to each other, and the first side has first regions and second regions alternately arranged in a first direction. The photovoltaic cell includes grooves recessed into the substrate. A respective groove of the grooves is located in a respective second region of the second regions on the first side and has a bottom surface, and a side wall connecting the bottom surface to two adjacent first regions sandwiching the respective second region, at least one section of the side wall is inclined towards one of the two adjacent first regions connected to the sidewall. The bottom surface has a first textured surface that includes a plurality of first pyramids, the side wall has a second textured surface that includes a plurality of second pyramids, and a first pyramid of the plurality of first pyramids has a height greater than a height of a second pyramid of the plurality of second pyramids.

In some embodiments, the side wall includes one slope, forming the second textured surface including the plurality of second pyramids.

In some embodiments, a portion of the plurality of second pyramids have pits at their apexes.

In some embodiments, a volume ratio of a single pit to the second pyramid having the single pit is in a range of 0.01 to 0.2.

In some embodiments, in a same groove, along the first direction, the bottom surface has a first length, the slope has a second length, and a ratio of the second length to the first length is in a range of 0.001 to 0.01.

In some embodiments, an inclination angle of the slope inclined towards the first region is in a range of 40° to 55°.

In some embodiments, the single groove has a depth in a range of 4 µm to 6 µm.

In some embodiments, a single first region of the first regions is provided as a third textured surface including a plurality of third pyramids. The first pyramids, the second pyramids and the third pyramids satisfy any one or any combination of the following relationships:
a base size of a single third pyramid is smaller than a base size of the single second pyramid and a base size of the single first pyramid;
a height of the single second pyramid is less than a height of the single third pyramid;
a reflectivity of the second textured surface is less than a reflectivity of the first textured surface and a reflectivity of the third textured surface; and
vertex angles of the first pyramids, the second pyramids and the third pyramids are in a range of 65° to 80°.

In some embodiments, the photovoltaic cell further includes: a first protective layer at least covering surface of the plurality of first pyramids.

In some embodiments, the first protective layer covers the bottom surface and the side wall.

In some embodiments, the first protective layer is made from at least one of a semiconductor material doped with a doping element, silicon oxide, phosphosilicate glass and borosilicate glass.

In some embodiments, the photovoltaic cell further includes: electrodes at least located on the first surface, and the electrodes are used to extract the photo-generated carriers generated in the substrate.

The first regions include at least regions where orthographic projection of the electrodes on the substrate are located.

In some embodiments, the photovoltaic cell further includes: a tunneling layer located on the second surface, a first doped semiconductor layer doped with a first doping element and located on a side of the tunneling layer away from the second surface, a second doped semiconductor layer doped with a second doping element and located on the first regions, a first passivation layer located on a side of the first doped semiconductor layer away from the tunneling layer, a second passivation layer located on a side of the second doped semiconductor layer away from the substrate and located on the second regions, first electrodes in ohmic contact with the first doped semiconductor layer, and second electrodes embedded in the second passivation layer and in ohmic contact with the second doped semiconductor layer. A conductivity type of the first doping element is different from a conductivity type of the second doping element.

In some embodiments, the photovoltaic cell further includes: a tunneling layer located on the second surface, a first doped semiconductor layer doped with a first doping element and located on a side of the tunneling layer away from the second surface, a second doped semiconductor layer doped with a second doping element and located on the first regions, a first protective layer located on the second regions, a first passivation layer located on a side of the first doped semiconductor layer away from the tunneling layer, a second passivation layer located on a side of the second doped semiconductor layer away from the substrate and located on the second regions, first electrodes in ohmic contact with the first doped semiconductor layer, and second electrodes embedded in the second passivation layer and in ohmic contact with the second doped semiconductor layer. A conductivity type of the first doping element is different from a conductivity type of the second doping element.

According to some embodiments of the present disclosure, another aspect of the embodiments of the present disclosure further provides a photovoltaic module, which includes: at least one cell string, each formed by connecting a plurality of photovoltaic cells as described above, at least one encapsulation adhesive film configured to cover a surface of the at least one cell string, and at least one cover plate configured to cover a surface of the at least one encapsulation adhesive film facing away from the at least one cell string.

### BRIEF DESCRIPTION OF THE DRAWINGS

One or more embodiments are described by way of example with reference to the corresponding figures in the accompanying drawings, and the exemplary description is not to be construed as limiting the embodiments. Elements in the accompanying drawings that have same reference signs are represented as similar elements, and unless otherwise particularly stated, the figures in the accompanying drawings are not drawn to scale. In order to describe the technical solutions of the embodiments of the present disclosure or the related art more clearly, the accompanying drawings that need to be used in the embodiments are briefly described below. Apparently, the accompanying drawings in the following description are only some embodiments of the present disclosure. For those skilled in the art, other drawings can be obtained according to the accompanying drawings without creative efforts.
FIG. 1 is a schematic diagram illustrating a first partial cross-sectional view of a photovoltaic cell according to an embodiment of the present disclosure.
FIG. 2 is a schematic diagram illustrating a first enlarged view of a substrate at a dashed box A shown in FIG. 1.
FIG. 3 is a schematic diagram illustrating a second enlarged view of a substrate at a dashed box A shown in FIG. 1.
FIG. 4 is a three-dimensional scanning electron microscope (SEM) schematic diagram of a substrate in a photovoltaic cell according to an embodiment of the present disclosure.
FIG. 5 is a schematic diagram illustrating a third enlarged view of a substrate at a dashed box A shown in FIG. 1.
FIG. 6 is a schematic diagram illustrating a second partial cross-sectional view of a photovoltaic cell according to an embodiment of the present disclosure.
FIG. 7 is a schematic diagram illustrating a third partial cross-sectional view of a photovoltaic cell according to an embodiment of the present disclosure.
FIG. 8 is a schematic diagram illustrating a fourth partial cross-sectional view of a photovoltaic cell according to an embodiment of the present disclosure.
FIG. 9 is a schematic diagram illustrating a fifth partial cross-sectional view of a photovoltaic cell according to an embodiment of the present disclosure.
FIG. 10 is a schematic diagram illustrating a partial cross-sectional view of an initial substrate provided in a method for manufacturing a photovoltaic cell according to an embodiment of the present disclosure.
FIG. 11 is a schematic diagram illustrating a partial cross-sectional of a damage layer formed in a method for manufacturing a photovoltaic cell according to an embodiment of the present disclosure.
FIG. 12 is a curve diagram corresponding to an energy gradient of a laser spot in a method for manufacturing a photovoltaic cell according to an embodiment of the present disclosure.
FIG. 13 is a schematic diagram illustrating a partial cross-sectional view of forming a first doped semiconductor layer on a structure shown in FIG. 7.
FIG. 14 is a schematic diagram illustrating a partial cross-sectional view of performing an etching process on a structure shown in FIG. 13.
FIG. 15 is a schematic diagram illustrating a partial cross-sectional view of forming a second doped semiconductor layer and a second protective layer on an initial substrate in a method for manufacturing a photovoltaic cell according to another embodiment of the present disclosure.
FIG. 16 is a schematic diagram illustrating a partial perspective view of a photovoltaic module according to another embodiment of the present disclosure.
FIG. 17 is a schematic diagram illustrating a cross-sectional structural view of the photovoltaic module taken along line MM1 in FIG. 16.
FIG. 18 is a schematic diagram illustrating a sixth partial cross-sectional view of a photovoltaic cell according to an embodiment of the present disclosure.
FIG. 19 is a schematic diagram illustrating a first enlarged view of the substrate at a dashed box B shown in FIG. 18.
FIG. 20 is a schematic diagram illustrating a second enlarged view of the substrate at the dashed box B shown in FIG. 18.
FIG. 21 is another three-dimensional scanning electron microscope (SEM) schematic diagram of a substrate in a photovoltaic cell according to an embodiment of the present disclosure.
FIG. 22 is a schematic diagram illustrating a seventh partial cross-sectional view of a photovoltaic cell according to an embodiment of the present disclosure.
FIG. 23 is a schematic diagram illustrating an eighth partial cross-sectional view of a photovoltaic cell according to an embodiment of the present disclosure.
FIG. 24 is a schematic diagram illustrating a ninth partial cross-sectional view of a photovoltaic cell according to an embodiment of the present disclosure.
FIG. 25 is a schematic diagram illustrating a partial cross-sectional of a damage layer formed in a method for manufacturing a photovoltaic cell according to another embodiment of the present disclosure.
FIG. 26 is another curve diagram corresponding to an energy gradient of a laser spot in a method for manufacturing a photovoltaic cell according to another embodiment of the present disclosure.
FIG. 27 is a schematic diagram illustrating a partial cross-sectional view of forming a first doped semiconductor layer on a structure shown in FIG. 22.
FIG. 28 is a schematic diagram illustrating a partial cross-sectional view of performing an etching process on a structure shown in FIG. 27.
FIG. 29 is a schematic diagram illustrating a tenth partial cross-sectional view of a photovoltaic cell according to an embodiment of the present disclosure.
FIG. 30 is schematic diagram illustrating an enlarged view of the substrate at a dashed box C shown in FIG. 29.
FIG. 31 is a further three-dimensional scanning electron microscope (SEM) schematic diagram of a substrate in a photovoltaic cell according to an embodiment of the present disclosure.
FIG. 32 is a schematic diagram illustrating an eleventh partial cross-sectional view of a photovoltaic cell provided in an embodiment of the present disclosure.
FIG. 33 is a schematic diagram illustrating a twelfth partial cross-sectional view of a photovoltaic cell provided in an embodiment of the present disclosure.
FIG. 34 is a schematic diagram illustrating a thirteenth partial cross-sectional view of a photovoltaic cell provided in an embodiment of the present disclosure.
FIG. 35 is a schematic diagram illustrating a partial cross-sectional of a damage layer formed in a method for manufacturing a photovoltaic cell according to a further embodiment of the present disclosure.
FIG. 36 is a further curve diagram corresponding to an energy gradient of a laser spot in a method for manufacturing a photovoltaic cell according to another embodiment of the present disclosure.
FIG. 37 is schematic diagram illustrating a partial cross-sectional view of forming a first doped semiconductor layer on a structure shown in FIG. 32.
FIG. 38 is schematic diagram illustrating a partial cross-sectional view of performing an etching process on a structure shown in FIG. 37.

### DETAILED DESCRIPTION OF THE EMBODIMENTS

As can be known from the background that, the light absorption efficiency and the photoelectric conversion efficiency of photovoltaic cells need to be improved.

The photovoltaic cell, the method for manufacturing the photovoltaic cell, and the photovoltaic module are provided in the embodiments of the present disclosure. In the photovoltaic cell, the surface morphology of the bottom surface and the slope of the groove is differentially designed. Specifically, the bottom surface is designed as a first textured surface, while the slope is designed as a second textured surface. Compared with the first pyramids in the first textured surface, the second pyramids in the second textured surface have a relatively smaller height. On one hand, the second pyramids with a lower height facilitates a more uniform distribution of the light incident to the slope, avoiding localized light intensity on the slope from being too high or too low, so as to enhance the photovoltaic conversion efficiency of the photovoltaic cell under low-light conditions or oblique light conditions. On the other hand, the second pyramid with a lower height is favorable to reduce the scattering path of the light rays on the slope to enhance the absorption rate of the slope for light rays with short wavelength, such as blue light and ultraviolet light. On another hand, the second pyramid with a lower height facilitates reducing the transmission distance of photo-generated carriers in the slope, thereby facilitating a reduction in the probability of carrier recombination to enhance the photovoltaic conversion efficiency of the photovoltaic cell. On still another hand, the slope serves as a transition region between the bottom surface and the first region, and the second pyramid is set on the slope so as to be conducive to avoiding the slope from being too steep, then the groove as a whole can receive more light at an incident angle and reduce light escape, in order to further reduce the reflection loss of light on the groove. In other words, with the aid of differentiated design of the surface morphology of the bottom surface and the slope, it is advantageous to reduce the reflection loss of the light on the second region, strengthen the utilization rate of the absorption of the light in the second region, and thereby enhancing the short-circuit current of the photovoltaic cell and the photovoltaic conversion efficiency. Moreover, it is advantageous to reduce the steepness of the slope so that the morphology of the first surface gently transitions from the higher first region to the lower bottom surface, thereby facilitating the subsequent formation of a film layer of uniform thickness on the first surface.

In the description of the embodiments of the present disclosure, the technical terms "first" and "second" are only used to distinguish different objects, and cannot be understood as indicating or implying relative importance or implicitly indicating the number, specific order or primary-secondary relationship of the indicated technical features. In the description of the embodiments of the present disclosure, the meaning of "plurality" is two or more, unless otherwise specifically limited.

Reference to "embodiments" in this document implies that particular features, structures, or characteristics described in conjunction with embodiments may be included in at least one embodiment of the present disclosure. The presence of the phrase at various points in the specification does not necessarily refer to the same embodiment, nor is it a separate or alternative embodiment that is mutually exclusive of other embodiments. It is understood by those skilled in the art, both explicitly and implicitly, that the embodiments described in this document may be combined with other embodiments.

In the description of the embodiments of the present disclosure, the term "and/or" is only an association relationship describing the associated objects, which means that there may be three relationships. For example, A and/or B, which may mean that there are three situations: the presence of A, the presence of A and B, and the presence of B. In addition, the character "/" generally indicates an "or" relationship between the associated objects.

In the description of the embodiments of the present disclosure, the term "multiple" refers to two or more (including two). Similarly, "multiple groups" refers to two groups or more (including two groups), and "multiple sheets" refers to two sheets or more (including two sheets).

In the description of the embodiments of the present disclosure, the technical terms "center", "longitudinal", "transverse", "length", "width", "thickness", "up", "down", "front", "rear", "left", "right", "vertical", "horizontal", "top", "bottom", "inside", "outside", "clockwise", "counterclockwise", "axial", "radial", "circumferential" and the like indicate orientations or positional relationships based on the orientations or positional relationships shown in the accompanying drawings, and are intended only to facilitate the description of the embodiments of the present disclosure and to simplify the description, and are not intended to indicate or imply that the referred device or element must have a particular orientation, be constructed and operated with a particular orientation, and therefore cannot be understood as a limitation of the embodiments of the present disclosure.

In the description of the embodiments of the present disclosure, unless otherwise specified and limited, technical terms such as "installation", "connection", and "fixation" should be broadly understood. For example, it may be fixed connection, detachable connection or integrated connection. It may also be mechanical connection or electrical connection. It may be direct connection, indirect connection through an intermediate medium, or an internal communication of two elements or an interaction between two elements. For those skilled in the art, the specific meanings of the above terms in the embodiments of the present disclosure may be understood according to the specific situation.

In the drawings corresponding to the embodiments of the present disclosure, the thickness and area of the layers are enlarged for better understanding and convenient description. When it is described that one component (such as a layer, a film, a region or a substrate) is on another component or on the surface of another component, the component can be "directly" located on the surface of the other component, or there may be a third component between the two components. On the contrary, when it is described that one component is on the surface of another component or another component is formed or provided on the surface of one component, it means that there is no third component between the two components. In addition, when it is described that one component is "substantially" formed on another component, it means that the component is not formed on the entire surface (or the front surface) of another component, nor on a part of the edge of the entire surface.

In the description of the embodiments of the present disclosure, when a component "includes" another component, unless otherwise specified, other components are not excluded, and other components may be further included. In addition, when a component such as a layer, a film, a region or a plate is referred to as being "on/located on" another component, it may be "directly on" another component (that is, there is no other component between the two components on the surface of another component) or there may be another component between the two components. In addition, when a component such as a layer, a film, a region or a plate is "directly located" on another component, or when a component such as a layer, a film, a region or a plate is located on the surface of another component, it means that no other component is located between the two components.

The terms used in the description of various embodiments described in this document are only intended to describe specific embodiments and are not intended to be limitations. As used in the description of various embodiments and the appended claims, "the component" is also intended to include the plural form, unless otherwise specified. Among them, the component includes the layer, the film, the region or the plate.

The various embodiments of the present disclosure will be described in detail below in conjunction with the accompanying drawings. However, those skilled in the art may understand that, in the various embodiments of the present disclosure, many technical details have been put forward for readers to better understand the embodiments of the present disclosure. However, even without these technical details and various changes and modifications based on the following embodiments, the technical solutions claimed in the embodiments of the present disclosure can still be implemented.

An embodiment of the present disclosure provides a photovoltaic cell. The photovoltaic cell provided in an embodiment of the present disclosure will be described in detail below with reference to the accompanying drawings.

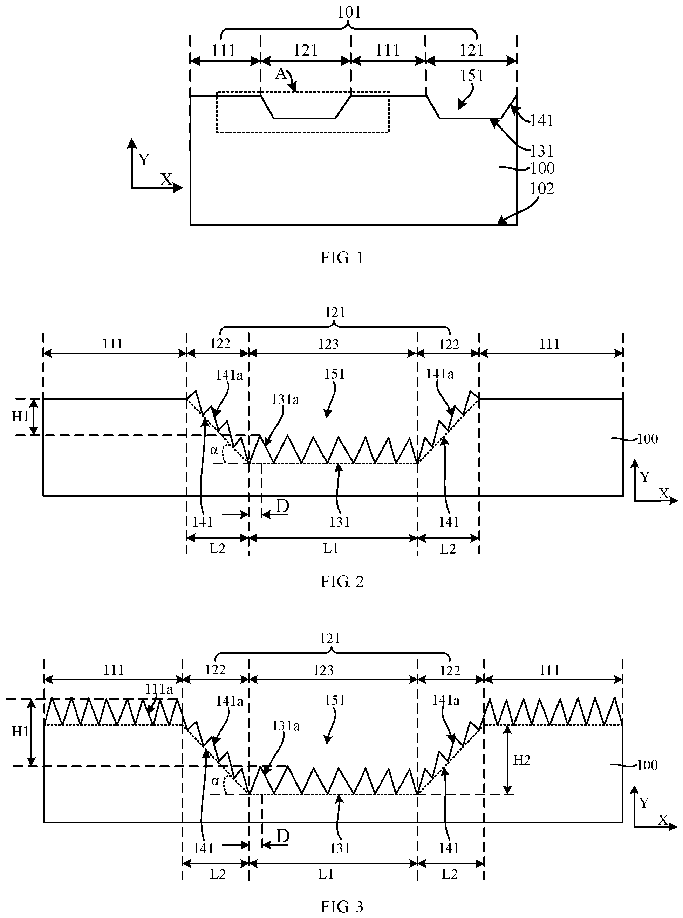

With reference to FIG. 1 to FIG. 4, the photovoltaic cell includes: a substrate 100 having a first surface 101 and a second surface 102 opposite to each other. The first surface 101 has first regions 111 and second regions 121 alternately arranged in a first direction X. The substrate 100 has grooves 151 recessed into the substrate 100 in the second regions 121. Each groove includes a bottom surface 131 and a slope 141 connecting the bottom surface 131 and an adjacent first region 111. The slope 141 is inclined toward the first region 111. The bottom surface 131 is provided as a first textured surface including a plurality of first pyramids 131a, the slope 141 is provided as a second textured surface including a plurality of second pyramids 141a, and the first pyramid 131a has a height greater than a height of the second pyramid 141a.

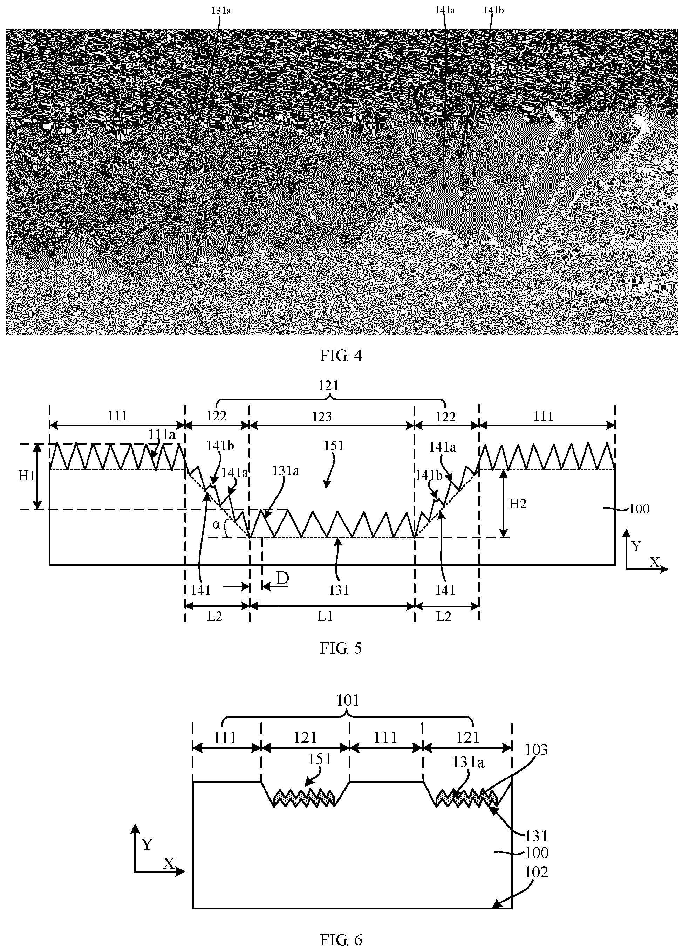

FIG. 1 is a schematic diagram illustrating a first partial cross-sectional view of a photovoltaic cell according to an embodiment of the present disclosure. FIG. 2 is a schematic diagram illustrating a first enlarged view of a substrate at a dashed box A shown in FIG. 1. FIG. 3 is a schematic diagram illustrating a second enlarged view of a substrate at a dashed box A shown in FIG. 1. FIG. 4 is a three-dimensional scanning electron microscope (SEM) schematic diagram of a substrate in a photovoltaic cell according to an embodiment of the present disclosure.

It should be noted that the surface morphology of the bottom surface 131 and the slope 141 of the groove 151 is differentially designed. Specifically, the bottom surface 131 is designed as a first textured surface, while the slope 141 is designed as a second textured surface. Compared with the first pyramids 131a included in the first textured surface, the second pyramids 141a included in the second textured surface have a relatively lower height. On one hand, the second pyramids 141a with a lower height are beneficial to more uniformly distributing the light incident on the slope 141, so as to avoid local light intensity on the slope 141 from being too high or too low, improve the overall absorption and utilization rate of the slope 141 for light, and reduce light escape, thereby further reducing the reflection loss of light on the slope 141, and improving the photoelectric conversion efficiency of the photovoltaic cell under weak light conditions or oblique light conditions. On the other hand, the second pyramids 141a with a lower height are beneficial to reducing the scattering path of light on the slope 141, so as to improve the absorption rate of the slope 141 for short-wavelength light, such as blue light and ultraviolet light. On another hand, the second pyramids 141a with a lower height are beneficial to reducing the transmission distance of photo-generated carriers in the slope 141, which can reduce the recombination probability of carriers, thereby improving the photoelectric conversion efficiency of the photovoltaic cell. On still another hand, as a transition region between the bottom surface 131 and the first region 111, designing the second pyramids 141a on the slope 141 are beneficial to avoiding the slope 141 from being too steep, so that the opening area of the groove 151 in a cross-section parallel to the second surface 102 gradually increases along a second direction Y, and the entire groove 151 can receive light at more incident angles, so as to reduce light escape, thereby reducing the reflection loss of light on the groove 151. A second direction Y is a direction pointing from the second surface 102 to the first surface 101.

In other words, the existing stepped structure is formed by a single-step film process, in which the sidewall is relatively steep and the morphology of the sidewall is not easy to control, so that the incident angle of the incident light that the sidewall can receive is very limited, and the difference in the absorption and utilization rate of the sidewall for light at different illumination angles is very large, resulting in that it is not conducive to the overall utilization of light absorption by the photovoltaic cell. In the photovoltaic cell provided in an embodiment of the present disclosure, by designing the surface morphologies of the bottom surface 131 and the slope 141 differently, it is beneficial to reducing the reflection loss of light in the second region 121, and improving the absorption and utilization rate of the second region 121 for light, thereby improving the short-circuit current and photoelectric conversion efficiency of the photovoltaic cell. Moreover, the morphology of the first surface 101 gradually transitions from the higher first region 111 to the lower bottom surface 131 by reducing the steepness of the slope 141, which is beneficial to forming a film layer with a uniform thickness on the first surface 101 subsequently.

In some cases, based on the design of the surface morphology of the bottom surface 131 and the slope 141 enclosing the groove 151, it is advantageous to reduce the overall reflectivity of the second region 121 to light to about 10.8.

In some cases, the inclination of the slope 141 toward the first region 111 means that the slope 141 may be inclined in a direction toward the second region 121 proximate the first region 111.

It should be noted that the photovoltaic cell further includes electrodes at least located on the first surface 101, and the electrodes are used to extract the photo-generated carriers generated in the substrate 100. Based on this, in order to facilitate the description of the specific orientation of the first pyramids 131a and the second pyramids 141a on the first surface 101, for those skilled in the art, the first surface 101 may be divided into first regions 111 and second regions 121. The first regions 111 include at least the regions where orthographic projection of the electrodes are located on the substrate 100, and the regions on the first surface 101 other than the first regions 111 are the second regions 121. In order to ensure that the film layer in contact with the electrodes has a large doping concentration or the regions in contact with the electrodes are high-concentration regions to reduce the contact resistance, an orthographic projection area of the first region 111 is generally set to be greater than or equal to an orthographic projection area of the corresponding electrode. In other words, the orthographic projection area of the electrode on the substrate 100 is smaller than the area of the first region 111, and the orthographic projection position is necessarily within the first region 111. It should be noted that the number of the first regions 111 and the number of the second regions 121 may both be plural, and the first regions 111 and the second regions 121 are alternately arranged in the first direction X. In other words, the first region 111 may be located in an interval between adjacent second regions 121, and the second region 121 may also be located in an interval between adjacent first regions 111.

Further, in order to further reflect the difference between the first pyramids 131a and the second pyramids 141a (or the transition surface), for those skilled in the art, the second region 121 may be divided into one transition region 122, one second sub-region 123, and another transition region 122 arranged in sequence in the first direction X. One transition region 122 is referred to as the region occupied by one slope 141 in the second region 121, and one second sub-region 123 is referred to as the region occupied by one bottom surface 131 in the second region 121. In other words, the first pyramids 131a are located in the second sub-region 123, and the second pyramids 141a (or the transition surface) is located in the transition region 122. In addition, each of the two first regions 111 on two opposite sides of the same second region 121 along the first direction X is connected to one corresponding transition region 122.

The embodiments of the present disclosure will be described in more detail below with reference to the accompanying drawings.

In some embodiments, with reference to FIG. 4 and FIG. 5, FIG. 5 is a schematic diagram illustrating a third enlarged view of a substrate at a dashed box A shown in FIG. 1, a portion of the second pyramids 141a have pits 141b at their apexes. In this way, the surface roughness of the second pyramids 141a are increased with the pits 141b, so that the light incident into the pits 141b has more reflection or refraction angles, inducing the light to be more easily absorbed and utilized by the second pyramids 141a after multiple reflections or refractions surrounded by the pits 141b, so as to further reduce the probability of the light being reflected outside the second pyramids 141a, thereby being beneficial to further enhancing the light trapping effect of the second pyramids 141a and the photovoltaic conversion efficiency of photovoltaic cells.

It should be noted that for the second pyramid 141a without the pit 141b, referring to FIG. 3 or FIG. 5, the second pyramid 141a may be regarded as a quadrangular pyramid formed by four lateral edges sharing a common vertex and four lateral faces each connecting neighboring lateral edges; for the second pyramid 141a with the pit 141b, referring to FIG. 5, the second pyramid 141a may be regarded as a quadrangular pyramid as described above with the pit 141b at the apex, or the quadrangular pyramid with the pit 141b at the apex is regarded as a quasi-quadrangular pyramid. In other words, in the quasi-quadrangular pyramid, due to the presence of the pit 141b, the endpoints of the lateral edges do not converge at a single vertex, but the extensions of the lateral edges can intersect at a common vertex. In addition, only a portion of the second pyramids 141a have pits 141b at their apexes, and not all of the second pyramids 141a have pits 141b.

In some examples, referring to FIG. 4 and FIG. 5, a volume ratio of a pit 141b to the second pyramid 141a with the pit 141b ranges from 0.01 to 0.2. For example, the volume ratio may be 0.02, 0.03, 0.04, 0.05, 0.06, 0.07, 0.08, 0.09, 0.1, 0.11, 0.12, 0.13, 0.14, 0.15, 0.16, 0.17, 0.18 or 0.19, etc.

If the volume ratio of the pit 141b to the second pyramid 141a with the pit 141b is less than 0.01, the pit 141b is too small relative to the second pyramid 141a, which restricts the range of incident angles of light that the pit 141b can receive, thereby hindering the improvement of light-trapping effects. If the volume ratio exceeds 0.2, the pit 141b is excessively large relative to the second pyramid 141a, significantly reducing the surface area of the lateral faces of the second pyramid 141a and adversely affecting the uniform deposition of subsequent film layers on the slopes 141. Therefore, designing the volume ratio of the pit 141b to the second pyramid 141a within the range of 0.01 to 0.2 ensures enhanced light-trapping performance through optimized pit geometry, and reduced overall roughness of slopes 141 having the second textured surfaces, facilitating uniform film deposition on the slopes 141.

It should be noted that due to the influence of the manufacturing process used to form the second pyramid 141a, the volume ratio of the pit 141b to the second pyramid 141a with the pit 141b exhibits significant variation. A detailed explanation of the manufacturing process for the second pyramid 141a will be provided in later sections. In addition, for the second pyramid 141a, the small volume of the pit 141b ensures that the overall appearance of the second pyramid 141a remains distinctly pyramidal and does not compromise the structural stability of the second pyramid 141a.

In some embodiments, referring to FIG. 2, FIG. 3 or FIG. 5, in the same groove 151, along the first direction X, the bottom surface 131 has a first length L1, the slope 141 has a second length L2, and a ratio of the second length L2 to the first length L1 ranges from 0.001 to 0.01. For example, it may be 0.002, 0.003, 0.004, 0.005, 0.006, 0.007, 0.008, or 0.009, etc.

It should be noted that both the first region 111 and the second region 121 extend along a third direction. Therefore, the groove 151 may be regarded as an elongated trench extending along the third direction, where the bottom surface 131 and the slope 141 share identical extension dimensions in the third direction. The area sizes of the bottom surface 131 and the slope 141 primarily depend on their respective lengths in the first direction X. In this way, by designing the ratio of the second length L2 to the first length L1 in a range of 0.001 to 0.01, a surface area of the groove 151 is mainly determined by an area of the bottom surface 131. Designing the first pyramids 131a included in the bottom surface 131 to have a higher height is beneficial to providing a larger surface area and more attachment points, so that the film layer subsequently deposited on the surface of the groove 151 can be better attached and more uniformly cover the surface of the groove 151, thereby being beneficial to reducing the defects and pores in the film layer and improving the quality and performance of the film layer.

In some cases, referring to FIG. 2, FIG. 3, or FIG. 5, along the first direction X, the first length L1 of the bottom surface 131 ranges from 200 µm to 800 µm. For example, the first length L1 may be 250 µm, 300 µm, 350 µm, 400 µm, 450 µm, 500 µm, 550 µm, 600 µm, 650 µm, 700 µm or 750 µm, etc.

In some embodiments, referring to FIG. 2, FIG. 3 or FIG. 5, an inclination angle α of the slope 141 inclined towards the first region 111 ranges from 40° to 55°. For example, the inclination angle α may be 40.5°, 41°, 41.5°, 42°, 42.5°, 43°, 43.5°, 44°, 44.5°, 45°, 45.5°, 46°, 46.5°, 47°, 47.5°, 48°, 48.5°, 49°, 49.5°, 50°, 50.5°, 51°, 51.5°, 52°, 52.5°, 53°, 53.5°, 54° or 54.5°, etc. It should be noted that the inclination angle α of different slopes 141 inclined toward the first region 111 may be either identical or exhibit slight variations. However, the numerical range of the inclination angle α for any slope 141 inclined toward the first region 111 may be set within 40° to 55°.

It should be noted that, on one hand, designing the inclination angle α of the slope 141 inclined toward the first region 111 within 40° to 55° can avoid excessive steepness of the slope 141. As a transition region between the bottom surface 131 and the first region 111, the slope 141 reduces abrupt height variations between adjacent areas along the first direction X. In other words, with the second surface 102 as the reference plane, this design minimizes height differences between adjacent areas along the first direction X across the slope 141, enabling a gradual morphological transition from the elevated first region 111 to the lower bottom surface 131 on the first surface 101. This smooth transition is beneficial to achieving uniform film thickness (e.g., passivation layers) on the first surface 101, thereby enhancing passivation effectiveness. On the other hand, this design ensures that the slope 141 remains relatively gradual relative to the first region 111, facilitating the design of second pyramids 141a on the slope 141.

Furthermore, referring to FIG. 2, FIG. 3, or FIG. 5, the second region 121 may be defined as including one transition region 122, one second sub-region 123, and another transition region 122 sequentially arranged along the first direction X. One transition region 122 refers to the region occupied by a slope 141 on the first surface 101. One second sub-region 123 refers to the region occupied by a bottom surface 131 on the first surface 101. Designing the inclination angle α of the slope 141 inclined toward the first region 111 within 40° to 55°, enhances the surface area of slope 141 deployable per unit distance along the first direction X within the transition regions 122, maximizes the number of second pyramids 141a that can be integrated per unit distance on the sloped surfaces 141 along the first direction X, and significantly improves the light-trapping efficiency of the sloped surfaces 141, thereby enhancing their light absorption utilization rate.

Furthermore, if the inclination angle α of the slope 141 inclined toward the first region 111 is set to be less than 40°, in order to ensure that the surface area of the slope 141 is larger, the size of the transition region 122 in the first direction X is increased, and thus the number of the first regions 111 that can be laid out on the entire first surface 101 is reduced. Therefore, designing an inclination angle α of the slope 141 inclined toward the first region 111 to be greater than or equal to 40° is beneficial to ensure that the slope 141 has a surface for laying out a sufficient number of second pyramids 141a, while at the same time decreasing the size of the slope 141 as a whole in the first direction X, i.e., decreasing the proportion of the transition region 122 that is occupied by the transition region 122 across the entire first surface 101.

It should be noted that with reference to FIG. 2, FIG. 3, or FIG. 5, the plane on which the bottom surfaces of a majority number of second pyramids 141a included in the slope 141 lie is used as the reference surface of the slope 141, i.e. a first reference surface; the plane on which a majority number of the bottom surfaces of first pyramids 131a included in the bottom surface 131 lie is used as the reference surface of the bottom surface 131, i.e. a second reference plane. Based on this, the inclination angle α of the slope 141 inclined towards the first region 111 refers to an acute angle formed between the first reference plane of the slope 141 and the second reference plane of the bottom surface 131. In addition, the first reference surface of the slope 141 and the second reference surface of the bottom surface 131 are illustrated in FIG. 2, FIG. 3, or FIG. 5 with dashed lines of higher density.

In addition, the bottom surface of the second pyramid 141a is the plane on which the base of the second pyramid 141a is located, the bottom surface of the first pyramid 131a is the plane on which the base of the first pyramid 131a is located, and the orthographic projection patterns of the bases of both the first pyramid 131a and the second pyramid 141a on the substrate 100 may be either a regular quadrilateral or an irregular polygonal shape.

It should be noted that, the bottom surfaces of all second pyramids 141a included in the slope 141 may be in different planes, but more than half of the number of second pyramids 141a have bottom surfaces that are nearly in the same plane, which may serve as the first reference plane. Similarly, the bottom surfaces of all first pyramids 131a included in the bottom surface 131 may be in different planes, but more than half of the number of first pyramids 131a have bottom surfaces that are nearly in the same plane, which may serve as the second reference plane.

In some embodiments, referring to FIG. 2, FIG. 3 or FIG. 5, along the second direction Y, the groove 151 has a depth H1 in a range of 4 µm to 6 µm. For example, the depth H1 may be 4.1 µm, 4.2 µm, 4.3 µm, 4.4 µm, 4.5 µm, 4.6 µm, 4.7 µm, 4.8 µm, 4.9 µm, 5 µm, 5.1 µm, 5.2 µm, 5.3 µm, 5.4 µm, 5.5 µm, 5.6 µm, 5.7 µm, 5.8 µm, or 5.9 µm, etc.

It should be noted that taking a plane where the apexes of most of the first pyramids 131a are located as a first plane, along the second direction Y, the depth H1 of the groove 151 refers to a distance between the first plane and a plane where the first region 111 is located. The plane where the first region 111 is located will be described in detail later. In addition, the apexes of all first pyramids 131a included in the first region 111 may be in different planes, but more than half of the number of apexes of the first pyramids 131a are in almost the same plane, which may be used as the first plane.

In some cases, referring to FIG. 3 or FIG. 5, the first region 111 is provided as a third textured surface including a plurality of third pyramids 111a. The plane where the first region 111 is located may be a plane where the apexes of most of the third pyramids 111a are located. Taking the plane where the apexes of most of the third pyramids 111a are located as a second plane, along the second direction Y, the depth H1 of the groove 151 refers to the distance between the first plane and the second plane. It should be noted that the apexes of all third pyramids 111a included in the first region 111 may be in different planes, but more than half of the number of the third pyramids 111a have apexes that are nearly in the same plane, which may serve as the second plane.

In some cases, referring to FIG. 3 or FIG. 5, the first region 111 is provided as a third textured surface including a plurality of third pyramids 111a. The bottom surfaces of all third pyramids 111a included in the first region 111 may be in different planes, but more than half of the number of the third pyramids 111a have bottom surfaces that are nearly in the same plane, which may serve as the third reference plane. Based on this, along the second direction Y, a distance H2 between the third reference plane of the first region 111 and the second reference plane of the bottom surface 131 ranges from 4.5 µm to 6.5 µm. For example, the distance H2 may be 4.6 µm, 4.7 µm, 4.8 µm, 4.9 µm, 5 µm, 5.1 µm, 5.2 µm, 5.3 µm, 5.4 µm, 5.5 µm, 5.6 µm, 5.7 µm, 5.8 µm, 5.9 µm, 6 µm, 6.1 µm, 6.2 µm, 6.3 µm or 6.4 µm, etc.

It should be noted that the third reference surface of the first region 111 is illustrated in FIG. 3 and FIG. 5 with dashed lines of higher density.

In some embodiments, referring to FIG. 3 or FIG. 5, the first region 111 is provided as a third textured surface including a plurality of third pyramids 111a. The size relationships among the first pyramids 131a, the second pyramids 141a, and the third pyramids 111a are described in detail below.

In some cases, referring to FIG. 3 or FIG. 5, a base size of the third pyramid 111a is smaller than a base size of the second pyramid 141a and a base size of the first pyramid 131a. That is, the third pyramid 111a has the smallest base size.

It should be noted that the base size of the pyramid structure includes any one of the length, width, or diagonal length of the orthographic projection pattern of the bottom of the pyramid structure on the second surface 102. For example, taking the orthographic projection pattern of the bottom of the pyramid structure on the second surface 102 being a regular quadrilateral as an example, the base size of the pyramid structure is any one of the length, width, or diagonal length of the regular quadrilateral. In addition, the pyramid structures mentioned herein include the first pyramids 131a, the second pyramids 141a, and the third pyramids 111a.

In practical applications, the orthographic projection pattern of the bottom of the pyramid structure on the second surface may also be an irregular polygon. In this case, the length, width, or diagonal length of the orthographic projection pattern of the bottom of the pyramid structure on the second surface is not absolute, but is artificially defined to characterize the base size of the pyramid structure. For example, if the orthographic projection pattern of the bottom of the pyramid structure on the second surface is an irregular quadrilateral, a length of the base of the pyramid structure may be defined as a side length of a longest side of the irregular quadrilateral, a width of the base of the pyramid structure may be defined as a side length of a shortest side of the irregular quadrilateral, and a diagonal length of the base of the pyramid structure may be defined as a length of a longest diagonal of the irregular quadrilateral. It should be understood that the above is only an exemplary description, and it may be flexibly defined according to actual needs in practice. In addition, the orthographic projection pattern of the bottom of the pyramid structure on the second surface may be not only an irregular quadrilateral, but also other irregular polygons, a circle, or an irregular shape similar to a circle. In this case, the base size of the pyramid structure is obtained by selecting multiple different regions with a specific area at the bottom of the pyramid structure. The regions with a specific area may be flexibly defined according to actual needs to calculate average values of the lengths, widths, diagonals, or diameters of the multiple different regions with a specific area.

In some examples, the base size of the third pyramid 111a may range from 1 µm to 2 µm, and for example, may be 1.1 µm, 1.2 µm, 1.3 µm, 1.4 µm, 1.5 µm, 1.6 µm, 1.7 µm, 1.8 µm, or 1.9 µm, etc. The base sizes of both the second pyramids 141a and the first pyramids 131a may range from 1.5 µm to 2.5 µm, and for example, may be 1.6 µm, 1.7 µm, 1.8 µm, 1.9 µm, 2 µm, 2.1 µm, 2.2 µm, 2.3 µm, or 2.4 µm, etc.

In one example, the base of the third pyramid 111a may be a quadrilateral with a size of 1.5 µm × 1.5 µm, and the bases of both the second pyramid 141a and the first pyramid 131a may be a quadrilateral with a size of 2 µm × 2 µm.

In some cases, referring to FIG. 3 or FIG. 5, a height of the second pyramid 141a is less than a height of the first pyramid 131a and a height of the third pyramid 111a. That is, the second pyramid 141a has the smallest height.

It should be noted that the height of the pyramid refers to the distance between the apex and the base of the pyramid in the second direction Y. In some examples, when measuring the texture size characteristics of the pyramid, such as the one-dimensional size of the bottom surface of the pyramid, and the height of the pyramid. It can be directly measured and calibrated by testing instruments (optical microscope, atomic force microscope, scanning electron microscope, transmission electron microscope, etc.). Exemplarily, the method for testing the height of the first pyramid is: randomly select 10 or more pyramids in a specific area of the first texture surface, measure the heights of the pyramids with a testing instrument, calculate the average value of the multiple heights, and take the average value as the height of the first pyramid. The above measurement methods are only examples, and this application does not limit it.

In some examples, the height of the second pyramid 141a may range from 0.5 µm to 1.5 µm, and for example, may be 0.6 µm, 0.7 µm, 0.8 µm, 0.9 µm, 1 µm, 1.1 µm, 1.2 µm, 1.3 µm, or 1.4 µm, etc. The heights of both the first pyramid 131a and the third pyramid 111a may range from 1.5 µm to 2.5 µm, and for example, may be 1.6 µm, 1.7 µm, 1.8 µm, 1.9 µm, 2 µm, 2.1 µm, 2.2 µm, 2.3 µm, or 2.4 µm, etc.

In some cases, referring to FIG. 3 or FIG.5, the reflectivity of the second textured surface is less than the reflectivity of the first textured surface and the reflectivity of the third textured surface. In other words, the reflectivity of the slope 141 is less than the reflectivity of the bottom surface 131 and the reflectivity of the first region 111, with the slope 141 having the least reflectivity.

In some examples, the reflectivity of the slope 141 may range from 10 to 11, and for example, may be 10.1, 10.2, 10.3, 10.4, 10.5, 10.6, 10.7, 10.8. or 10.9, etc. The reflectivity of the bottom surface 131 may range from 11.5 to 12.5, and for example, may be 11.6, 11.7, 11.8, 11.9, 12, 12.1, 12.2, 12.3, or 12.4, etc. The reflectivity of the first region 111 may range from 10.5 to 11.5, and for example, may be 10.6, 10.7, 10.8. 10.9, 11, 11.1, 11.2, 11.3, or 11.4, etc.

It should be noted that for the first surface 101, the above three examples may exist simultaneously, or one of them may be selected, or two of them may be selected.

In some embodiments, referring to FIG. 3 or FIG. 5, vertex angles of the first pyramid 131a, the second pyramid 141a and the third pyramid 111a may be in a range of 65° to 80°, and for example, may be 66°, 67°, 68°, 69°, 70°, 71°, 72°, 73°, 74°, 75°, 76°, 77°, 78°, or 79°, etc. In this way, it is advantageous to capture incident light more efficiently with the aid of a pyramid with a smaller vertex angle, for example, so that light from a greater number of incident angles can all be reflected into the first face 101 to increase the total amount of light entering the first face 101.

It should be noted that the angle formed by the two lateral edges set opposite each other in the pyramid may be regarded as the vertex angle of the pyramid.

The embodiments of the present disclosure further provide a photovoltaic cell. In the photovoltaic cell described above, the morphology of the grooves and the first pyramids are beneficial to enhancing the light trapping effect in the second regions. On this basis, in order to ensure the enhancing effect of the grooves and the first pyramids on the light trapping effect in the second regions, a first protective layer is designed to cover at least the first pyramids, so as to protect the morphology of the first pyramids with the help of the first protective layer. For example, when other film layers are subsequently formed on the second regions and a patterning process is performed, the first protective layer can be used as an etching barrier layer to prevent the patterning process from damaging the first pyramids, so as to avoid the reduction of the absorption and utilization rate for light caused by the deformation of the surface morphology of the first pyramids, which is beneficial to ensuring that the second regions have a high absorption and utilization rate for light. Furthermore, the first protective layer is beneficial to improving the optical performance of the second regions, so as to further reduce the reflection loss in the second regions. For example, it can reduce the reflectivity of the overall surface of the photovoltaic cell located in the second region, so as to ultimately improve the absorption and utilization rate of the second regions for light, thereby improving the photoelectric conversion efficiency of the photovoltaic cell.

FIG. 6 is a schematic diagram illustrating a second partial cross-sectional view of a photovoltaic cell according to an embodiment of the present disclosure. As shown in FIG. 6, the photovoltaic cell includes: a substrate 100 having a first surface 101 and a second surface 102 opposite to each other. The first surface 101 has first regions 111 and second regions 121 alternately arranged in a first direction X. The substrate 100 in the second regions 121 has grooves 151 recessed into the substrate 100. Each groove 151 includes a bottom surface 131, which is provided as a first textured surface including a plurality of first pyramids 131a. The photovoltaic cell includes a first protective layer 103 covering at least surfaces of the first pyramids 131a.

The groove 151 recessed into the substrate 100 is beneficial to increasing the number of reflection and/or scattering of light in the second region 121, and increasing a surface area of the second region 121 for absorbing light, thereby facilitating the use of the groove 151 to increase the light trapping effect of the second region 121 on light. Further, designing the bottom surface 131 of the groove 151 as the first textured surface including the plurality of first pyramids 131a is also beneficial to improving the light trapping effect of the bottom surface 131 on light by means of the first pyramids 131a.

On the above basis, in order to ensure the enhancing effect of the groove 151 and the first pyramids 131a on the light trapping effect of the second region, a first protective layer 103 is designed to cover at least the first pyramids 131a, so as to protect the morphology of the first pyramids with the help of the first protective layer 103. For example, when other film layers are subsequently formed on the second region 121 and a patterning process is performed, the first protective layer 103 can be used an etching barrier layer to prevent the patterning process from damaging the first pyramids 131a, so as to avoid the reduction of the absorption and utilization rate for light caused by the deformation of the surface morphology of the first pyramids 131a, which is beneficial to ensuring that the second region 121 has a high absorption and utilization rate for light. Further, the first protective layer 103 is beneficial to improving the optical performance of the second region 121, so as to further reduce the reflection loss in the second region 121. For example, the first protective layer 103 can reduce the reflectivity of the overall surface of the photovoltaic cell located in the second region 121, so as to ultimately improve the absorption and utilization rate of the second region 121 for light, thereby improving the photoelectric conversion efficiency of the photovoltaic cell.

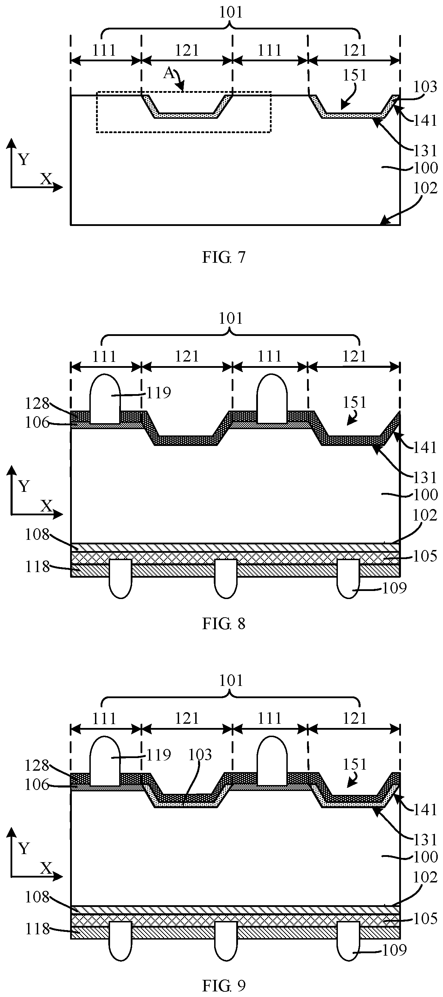

In some embodiments, referring to FIG. 7, FIG. 7 is a schematic diagram illustrating a third partial cross-sectional view of a photovoltaic cell according to an embodiment of the present disclosure, the first protective layer 103 covers the bottom surface 131 and the slope 141.

In some cases, the first protective layer 103 may conformally cover the bottom surface 131 and the slope 141, then the surface morphology of the portion of the first protective layer 103 aligned with the bottom surface 131 also exhibits a textured morphology like the bottom surface 131, and the surface morphology of the portion of the first protective layer 103 aligned with the slope 141 also exhibits a textured morphology like the slope 141.

It should be noted that with reference to FIG. 2 to FIG. 7, on one hand, the first protective layer 103 is conducive to protecting the morphology of the first pyramids 131a and the second pyramids 141a, for example, when other film layers are subsequently formed on the second regions 121 and patterning is carried out, the first protective layer 103 can be used as an etching barrier layer, so as to avoid damage to the first pyramids 131a and the second pyramids 141a by the patterning process, thereby favorably ensuring that the second regions 121 have relatively lower reflectivity.

On the other hand, the first protective layer 103 facilitates the enhancement of the optical properties of the second regions 121 to further reduce the reflection loss of the second regions 121, for example, to reduce the reflectivity of the photovoltaic cell as a whole disposed on the surface of the second regions 121 to ultimately enhance the utilization rate of the absorption of light by the second regions 121, thereby enhancing the photoelectric conversion efficiency of the photovoltaic cell.

In some cases, after the first protective layer 103 is formed by an oxygen-free high-temperature process, the reflectivity of the overall surface of the photovoltaic cell located in the second region 121 can be reduced by about 0.1 to 0.3 on the original basis. In other cases, after the first protective layer 103 is formed by an oxygen-containing high-temperature process, the reflectivity of the overall surface of the photovoltaic cell located in the second region 121 can be reduced by about 0.5 to 1 on the original basis. In still other cases, after the first protective layer 103 is formed by an in-situ doped oxidation process, the reflectivity of the overall surface of the photovoltaic cell located in the second region 121 can be reduced by about 0.5 to 1 on the original basis. The oxygen-free high-temperature process, the oxygen-containing high-temperature process, and the in-situ doped oxidation process will be described in detail later.

In some cases, referring to FIG. 6, the first protective layer 103 at least covers surfaces of the first pyramids 131a, that is, at least the surface morphology of a portion of the first protective layer 103 aligned with the bottom surface 131 presents a textured surface morphology similar to the textured surface morphology of the bottom surface 131.

In some cases, referring to FIG. 5, the first protective layer 103 may cover the entire surface of the groove 151, that is, in addition to covering the surfaces of the first pyramids 131a, the first protective layer 103 also covers a transition surface in the groove 151 connecting a first region 111 and the bottom surface 131. The transition surface of the groove 151 will be described in detail later. The case that the first protective layer 103 covers the entire surface of the groove 151 will be described in detail as an example later.

In some embodiments, referring to FIG. 5 and FIG. 6, the first protective layer 103 may be made from a semiconductor material doped with a doping element, silicon oxide, phosphosilicate glass, or borosilicate glass.

In some cases, the semiconductor material included in the first protective layer 103 is an elemental semiconductor material. Specifically, the elemental semiconductor material is composed of a single element. For example, it may be silicon or germanium. The elemental semiconductor material may be in a single crystal state, a polycrystalline state, an amorphous state, or a microcrystalline state (a state having both a single crystal state and an amorphous state is referred to as a microcrystalline state). For example, silicon may be at least one of single crystal silicon, polycrystalline silicon, amorphous silicon, or microcrystalline silicon. In other cases, the semiconductor material included in the first protective layer 103 is a compound semiconductor material. Common compound semiconductor materials include, but are not limited to, silicon germanide, silicon carbide, gallium arsenide, indium gallide, perovskite, cadmium telluride, or copper indium selenide and other materials.

In some cases, the doping element included in the first protective layer 103 may be an N-type doping element or a P-type doping element. The N-type doping element may be at least one of group V elements such as phosphorus (P), bismuth (Bi), antimony (Sb), or arsenic (As). The P-type doping element may be at least one of group III elements such as boron (B), aluminum (Al), gallium (Ga), or indium (In).

It should be noted that referring to FIG. 7, based on the difference in the surface morphology of the grooves 151, the morphology of the first protective layer 103 covering the surface of the grooves 151 may also be different. The specific morphology of the grooves 151 located in the second regions 121 includes various embodiments. For example, an enlarged schematic view of the substrate at the dashed box A shown in FIG. 7 is similar to the enlarged schematic view of the substrate at the dashed box A shown in FIG. 1, as shown in FIG. 2, FIG. 3, and FIG. 5. The groove 151 is enclosed by a bottom surface 131 and a slope 141 connecting the bottom surface 131 and the first region 111, the slope 141 being inclined in a direction toward the second region 121 proximate to the first region 111; the slope 141 being a second textured surface including a plurality of second pyramids 141a, where a height of the first pyramid 131a is greater than a height of the second pyramid 141a.

In some cases, with reference to FIG. 5 and FIG. 7, a portion of the second pyramids 141a have pits 141b at their apexes. In this way, the surface roughness of the second pyramids 141a are increased with the pits 141b, so that the light incident into the pits 141b has more reflection or refraction angles, inducing the light to be more easily absorbed and utilized by the second pyramids 141a after multiple reflections or refractions surrounded by the pits 141b, so as to further reduce the probability of the light being reflected outside the second pyramids 141a, thereby being beneficial to further enhancing the light trapping effect of the second pyramids 141a.

In some embodiments, the substrate 100 may be made from an elemental semiconductor material or a compound semiconductor material.

In some cases, the substrate 100 may be an N-type semiconductor substrate doped with an N-type doping element. In some other cases, the substrate 100 may be a P-type semiconductor substrate doped with a P-type doping element.

In some embodiments, referring to FIG. 8 and FIG. 9, FIG. 8 is a schematic diagram illustrating a fourth partial cross-sectional view of a photovoltaic cell according to an embodiment of the present disclosure, and FIG. 9 is a schematic diagram illustrating a fifth partial cross-sectional view of a photovoltaic cell according to an embodiment of the present disclosure. The photovoltaic cell further includes: a tunneling layer 108 located on the second surface 102, a first doped semiconductor layer 105 doped with a first doping element and located on a side of the tunneling layer 108 away from the second surface 102, and a second doped semiconductor layer 106 doped with a second doping element and located on the first regions 111. A conductivity type of the first doping element is different from a conductivity type of the second doping element. The photovoltaic cell further includes a first passivation layer 118 located on a side of the first doped semiconductor layer 105 away from the tunneling layer 108, a second passivation layer 128 located on a side of the second doped semiconductor layer 106 away from the substrate 100 and located on the second regions 121, first electrodes 109 in ohmic contact with the first doped semiconductor layer 105, and second electrodes 119 embedded in the second passivation layer 128 and in ohmic contact with the second doped semiconductor layer 106.

It should be noted that the second doped semiconductor layer 106, as a selective emitter structure on the first surface 101, is beneficial to ensuring that the second electrodes 119 have a good current collection efficiency based on the second doped semiconductor layer 106, avoiding the second regions 121 from being covering by the second doped semiconductor layer 106, avoiding the parasitic absorption by the second doped semiconductor layer 106 of the light incident to the second regions 121, thereby enhancing the utilization of the incident light by the first surface 101 to improve the photovoltaic conversion efficiency of the photovoltaic cell.

In addition, the tunneling layer 108 and the first doped semiconductor layer 105 jointly form a passivated contact structure. The tunneling layer 108 chemically passivates the second surface 102, saturates the dangling bonds of the second face 102, reduces the defect state density of the second face 102, reduces the recombination probability of carriers on the second face 102, and the first doped semiconductor layer 105 field-passivates the second surface 102, reduces the concentration of minority carriers to reduce the recombination probability of carriers on the second face 102, thereby improving the photoelectric conversion efficiency of the photovoltaic cell. In addition, the first passivation layer 118 can further passivate the second surface 102 and serve as an optical optimization layer for the second surface 102 to improve the absorption and utilization rate of the second surface 102 for light. The second passivation layer 128 can passivate the first surface 101 to reduce the defect state density of the first surface 101, and serve as an optical optimization layer for the first surface 101 to improve the absorption and utilization rate of the first surface 101 for light.

In some cases, the second doped semiconductor layer 106 doped with the second doping element is formed in an initial state of the substrate 100. In other words, there is no obvious boundary line between the second doped semiconductor layer 106 and the substrate 100 located in the first regions 111. In FIG. 8 and FIG. 9, for the convenience of description, different filling methods are used to draw the substrate 100 and the second doped semiconductor layer 106. On this basis, the slope 141 of the groove 151 formed by the substrate 100 located in the second region 121 recessed towards the second surface 102 may be regarded as being jointly formed by the second doped semiconductor layer 106 and the substrate 100 located in the first region 111.

In some cases, the tunneling layer 108 may be made from at least one of silicon oxide, silicon nitride, silicon oxynitride, silicon carbide, or magnesium fluoride, and the first doped semiconductor layer 105 may be made from at least one of amorphous silicon, polycrystalline silicon, or silicon carbide. Both the first doped semiconductor layer 105 and the substrate 100 may be doped with the first doping element.

In some cases, both the second passivation layer 128 and the first passivation layer 118 may be either a single-layer structure or a stacked-layer structure. In addition, the materials of both the second passivation layer 128 and the first passivation layer 118 may include at least one of aluminum oxide, silicon oxide, silicon nitride, or silicon oxynitride.

In some cases, the substrate 100 may be an N-type semiconductor substrate doped with an N-type doping element, the first doping element doped in the first doped semiconductor layer 105 is an N-type doping element, and the second doping element doped in the second doped semiconductor layer 106 is a P-type doping element. In some other cases, the substrate 100 may be a P-type semiconductor substrate doped with a P-type doping element, the first doping element doped in the first doped semiconductor layer 105 is a P-type doping element, and the second doping element doped in the second doped semiconductor layer 106 is an N-type doping element.

In some cases, the material of the substrate 100 may be an elemental semiconductor material or a compound semiconductor material, and the substrate 100 may be an N-type semiconductor substrate doped with an N-type doping element, the first doping element doped in the first doped semiconductor layer 105 is an N-type doping element, and the second doping element doped in the second doped semiconductor layer 106 is a P-type doping element. In some other cases, the substrate 100 may be a P-type semiconductor substrate doped with a P-type doping element, the first doping element doped in the first doped semiconductor layer 105 is a P-type doping element, and the second doping element doped in the second doped semiconductor layer 106 is an N-type doping element.

In summary, the bottom surface 131 is designed as a first textured surface, while the slope 141 is designed as a second textured surface. Compared with the first pyramids 131a in the first textured surface, the second pyramids 141a in the second textured surface have a relatively smaller height. On one hand, the second pyramids 141a with a lower height facilitates a more uniform distribution of the light incident to the slope 141, avoiding localized light intensity on the slope 141 from being too high or too low, enhancing the overall light absorption utilization of the slope 141 and reducing light escape to further reduce the reflection loss of light on the slope 141, so as to enhance the photovoltaic conversion efficiency of the photovoltaic cell under low-light conditions or oblique light conditions. On the other hand, the second pyramid 141a with a lower height is favorable to reduce the scattering path of the light rays on the slope 141 to enhance the absorption rate of the slope 141 for light rays with short wavelength, such as blue light and ultraviolet light. On another hand, the second pyramid 141a with a lower height facilitates reducing the transmission distance of photo-generated carriers in the slope 141, thereby facilitating a reduction in the recombination probability of carrier to enhance the photovoltaic conversion efficiency of the photovoltaic cell. On still another hand, the slope 141 serves as a transition region between the bottom surface 131 and the first region 111, and the second pyramid 141a is set on the slope 141 so as to be conducive to avoiding the slope 141 from being too steep, then the groove 151 as a whole can receive more light at an incident angle and reduce light escape, in order to further reduce the reflection loss of light on the groove 151.

Moreover, it is advantageous to reduce the steepness of the slope 141 so that the morphology of the first surface 101 gently transitions from the higher first region 111 to the lower bottom surface 131, thereby facilitating the subsequent formation of a film layer of uniform thickness on the first surface 101.

Further, the morphology of the groove 151 and the first pyramids 131a are beneficial to enhancing the light trapping effect in the second regions. On this basis, in order to ensure the enhancing effect of the grooves 151 and the first pyramids 131a on the light trapping effect in the second regions, the first protective layer 103 is designed to cover at least the first pyramids 131a, so as to protect the morphology of the first pyramids with the help of the first protective layer 103. For example, when other film layers are subsequently formed on the second regions 121 and a patterning process is performed, the first protective layer 103 can be used as an etching barrier layer to prevent the patterning process from damaging the first pyramids 131a, so as to avoid the reduction of the absorption and utilization rate for light caused by the deformation of the surface morphology of the first pyramids 131a, which is beneficial to ensuring that the second regions 121 have a high absorption and utilization rate for light. Furthermore, the first protective layer 103 is beneficial to improving the optical performance of the second regions 121, so as to further reduce the reflection loss in the second regions 121. For example, it can reduce the reflectivity of the overall surface of the photovoltaic cell located in the second regions 121, so as to ultimately improve the absorption and utilization rate of the second regions 121 for light, thereby improving the photoelectric conversion efficiency of the photovoltaic cell.

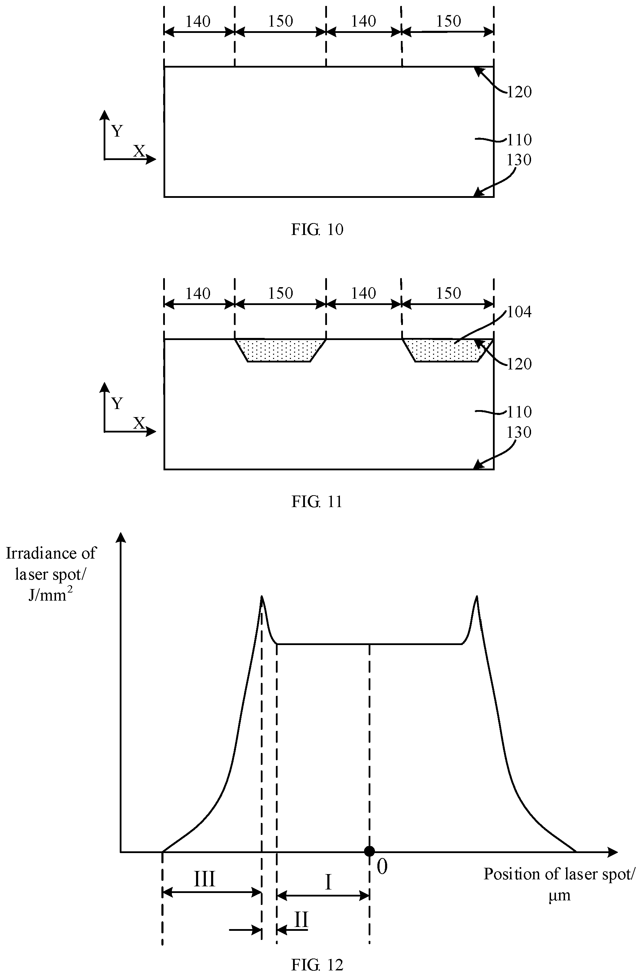

The embodiments of the present disclosure further provide a method for manufacturing a photovoltaic cell, which is configured to form the photovoltaic cell provided in the foregoing embodiments. The method for manufacturing the photovoltaic cell will be described in detail below with reference to the accompanying drawings. FIG. 10 to FIG. 15 are schematic diagrams of the partial cross-sectional structures corresponding to each operation in the method for manufacturing the photovoltaic cell. It should be noted that the same or corresponding parts as those in the foregoing embodiments will not be described in detail herein.

With reference to FIG. 10 to FIG. 15, and with reference to FIG. 1 to FIG. 5, the method for manufacturing the photovoltaic cell may at least include the following operations.

S1: Referring to FIG. 10, FIG. 10 is a schematic diagram illustrating a partial cross-sectional view of an initial substrate provided in a method for manufacturing a photovoltaic cell according to an embodiment of the present disclosure, an initial substrate 110 is provided, where the initial substrate 110 has an initial first surface 120 and an initial second surface 130 opposite to each other. The initial first surface 120 has initial first regions 140 and initial second regions 150 that are alternately arranged along the first direction X.

It should be noted that the initial first surface 120 corresponds to the subsequently formed first surface, the initial first regions 140 correspond to the first regions of the subsequently formed first surface, the initial second regions 150 correspond to the second regions of the subsequently formed first surface, and the initial second surface 130 corresponds to the subsequently formed second surface.

S2: Referring to FIG. 10 to FIG. 12, the initial second regions 150 is irradiated using a laser spot with a gradual change in energy to transform a portion of the thickness of the initial substrate 110, which is disposed in the initial second regions 150, into a damage layer 104, and the change in the energy of the laser spot in a direction of the center of the laser spot pointing toward the edge includes at least a first stage I, a second stage II, and a third stage III in a sequential manner, with the energy of the laser spot in the first stage I being at a first preset value, the energy of the laser spot gradually increases from the first preset value to a second preset value in the second stage II, and the energy of the laser spot gradually decreases from the second preset value to zero in the third stage III. In other words, in the direction of the center of the laser spot pointing towards the edge, the energy of the laser spot first remains unchanged, then gradually increases, and finally gradually decreases to zero.

It should be noted that FIG. 11 is a schematic diagram illustrating a partial cross-sectional of a damage layer formed in a method for manufacturing a photovoltaic cell according to an embodiment of the present disclosure, and FIG. 12 is a curve diagram corresponding to an energy gradient of a laser spot in a method for manufacturing a photovoltaic cell according to an embodiment of the present disclosure. In addition, the center of the laser spot is taken as point 0 in FIG. 12.

S3: Referring to FIG. 11 and FIG. 1 to FIG. 5, each initial second region 150 is subjected to a first textured process to at least remove the damage layer 104 and to form a groove 151 in the initial second region 150, with the remaining initial substrate 110 being the substrate 100, the initial first region 140 transformed into the first region 111 of the substrate 100, and the initial second region 150 transformed into the second region 121 of the substrate 100, and the substrate 100 including a bottom surface 131 recessed toward inside of the substrate 100 in the second region 121, and a slope 141 connecting the bottom surface 131 and the first region 111, the slope 141 inclined toward the first region 111, and the bottom surface 131 and the slope 141 enclosing the groove 151.

The bottom surface 131 is provided as a first textured surface including a plurality of first pyramids 131a, the slope 141 is provided as a second textured surface including a plurality of second pyramids 141a, and a height of the first pyramid 131a is greater than a height of the second pyramid 141a.

It should be noted that during the process of irradiating the initial second regions 150 using the laser spot with gradual change in energy in operation S2, only the damage layer 104 is formed in the initial second region 150, and a stepped structure with a height difference is not be formed between the initial first region 140 and the initial second region 150. On this basis, in operation S3, by means of the difference in etching rates of the damage layer 104 in the initial second region 150 and the initial first region 140 during the first texturing treatment, the initial second region 150 is transformed into the second region 121 with the groove 151.

Further, based on the design in operation S2 that along the direction from the center to the edge of the laser spot, the energy of the laser spot remains unchanged first, then gradually increases, and finally gradually decreases to zero, which is beneficial to forming the damage layer with different thickness in different regions in operation S2. Generally speaking, the portion of the initial substrate 110 irradiated by the portion with greater energy in the laser spot has a greater degree of damage caused by the laser, and the formed damage layer 104 has a greater thickness or the interior is more completely destroyed. For example, in a direction along the center of the initial second region 150 pointing toward the initial first region 140, the thickness of the damage layer 104 first remains unchanged, then gradually increases, and finally gradually decreases to zero. On this basis, in operation S3, the etching rates of different regions of the damage layer 104 during the first texturing treatment are different, and the durations spent by the first texturing treatment to remove the damage layer 104 with different thicknesses are also different. Therefore, the first texturing treatment exposes the initial substrate 110 covered by different portions of the damage layer 104 at different moments, and a texturing treatment is further performed on the remaining initial substrate 110 at different moments. Consequently, it is beneficial to forming the groove 151 jointly surrounded by the bottom surface 131 and the slope 141, and forming different textured surface structures on the bottom surface 131 and the slope 141. Specifically, a bottom surface 131 is formed as a first textured surface including a plurality of first pyramids 131a, and a slope 141 is formed as a second textured surface including a plurality of second pyramids 141a.

In other words, under the joint cooperation of irradiating the initial second region 150 using the laser spot with gradual change in energy in operation S2 and the first texturing treatment in operation S3, the turning points of the etching rates of different regions of the film layer jointly formed by the damage layer 104 and the remaining initial substrate 110 during the first texturing treatment are different along the direction from the center of the initial second region 150 to the initial first region 140. Further, the average etching rate of the first texturing treatment on different regions of the film layer including the damage layer 104 and the remaining initial substrate 110 together is further made to be gradual change, for example, to remain unchanged and then gradually decreased, thereby favoring the eventual formation of a less steep slope 141.

In some embodiments, referring to FIG. 12, FIG. 2, FIG. 3, and FIG. 5, the position with the maximum energy of the laser spot, that is, the second preset value, irradiates the bottom surface 131 of the groove 151, and irradiates the region of the bottom surface 131 close to the slope 141. It should be noted that the energy of a single laser spot reaches the second preset value in two different regions, and the two second preset values irradiate the regions of the bottom surface 131 close to two different slopes 141 respectively.

In some cases, along the first direction X, an irradiation position of the bottom surface 131 corresponding to the second preset value and a junction of the slope 141 and the bottom surface 131 are spaced apart by a preset distance D, and a ratio of the preset distance D to the first length L1 of the bottom surface 131 ranges from 0.0025 to 0.05. For example, the ratio may be 0.003, 0.004, 0.005, 0.006, 0.007, 0.008, 0.009, 0.01, 0.015, 0.02, 0.025, 0.03, 0.035, 0.04, or 0.045, etc.

It should be noted that the first length L1 of the bottom surface 131 is formed by multiple laser lines opening the film, and the surface area of the groove 151 is mainly determined by the first length L1 of the bottom surface 131. The value range of the first length L1 is relatively large. Based on this, the value range of the ratio of the preset distance D to the first length L1 of the bottom surface 131 is also relatively large. However, compared with the first length L1 of the bottom surface 131, the preset distance D between the irradiation position of the bottom surface 131 corresponding to the second preset value and the junction of the slope 141 and the bottom surface 131 is relatively small. In other words, the position irradiated by the turning point of the energy decrease of the laser spot is very close to the finally formed slope 141.

In some examples, the preset distance D between the irradiation position of the bottom surface 131 corresponding to the second preset value and the junction of the slope 141 and the bottom surface 131 ranges from 5 µm to 10 µm. For example, the preset distance D may be 5.2 µm, 5.5 µm, 5.8 µm, 6 µm, 6.3 µm, 6.5 µm, 6.6 µm, 6.8 µm, 7 µm, 7.3 µm, 7.5 µm, 7.7 µm, 8 µm, 8.2 µm, 8.5 µm, 8.8 µm, 9 µm, 9.3 µm, or 9.5 µm, etc.

In some examples, an overall size of the laser spot ranges from 50 µm to 200 µm. In other words, a diameter of the laser spot ranges from 50 µm to 200 µm. For example, the diameter of the laser spot may be 60 µm, 70 µm, 80 µm, 90 µm, 100 µm, 110 µm, 120 µm, 130 µm, 140 µm, 150 µm, 160 µm, 170 µm, 180 µm, or 190 µm, etc.

In some examples, referring to FIG. 11 and FIG. 12, a single laser spot is divided into two symmetrical portions along the center. Along the first direction X, a width of the irradiation region of either of the two portions of the laser spot corresponding to the first stage I on the initial second region 150 ranges from 20 µm to 50 µm, for example, may be 21 µm, 22 µm, 23 µm, 24 µm, 25 µm, 26 µm, 27 µm, 28 µm, 29 µm, 30 µm, 31 µm, 32 µm, 33 µm, 34 µm, 35 µm, 36 µm, 37 µm, 38 µm, 39 µm, 40 µm, 41 µm, 42 µm, 43 µm, 44 µm, 45 µm, 46 µm, 47 µm, 4 8µm, or 49 µm, etc. A width of the irradiation region of either of the two portions of the laser spot corresponding to the second stage II on the initial second region 150 ranges from 1 µm to 5 µm, for example, may be 1.2 µm, 1.5 µm, 1.6 µm, 1.8 µm, 2 µm, 2.2 µm, 2.5 µm, 2.6 µm, 3 µm, 3.2 µm, 3.5 µm, 3.8 µm, 4 µm, 4.2 µm, 4.5 µm, or 4.8 µm, etc. A width of the irradiation region of either of the two portions of the laser spot corresponding to the third stage III on the initial second region 150 ranges from 5 µm to 20 µm, for example, may be 6 µm, 7 µm, 8 µm, 9 µm, 10 µm, 11 µm, 12 µm, 13 µm, 14 µm, 15 µm, 16 µm, 17 µm, 18 µm, or 19 µm, etc.

It should be noted that designing the width of the irradiation region of the laser spot corresponding to the second stage II on the initial second region 150 to range from 1 µm to 5 µm, and designing the width of the irradiation region of the laser spot corresponding to the third stage III on the initial second region 150 to range from 5 µm to 10 µm can shorten the irradiation range of the laser spots corresponding to the second stage II and the third stage III on the initial second region 150, which is beneficial to controlling the relatively low damage degree inside the damage layer 104 corresponding to the finally formed slope 141, reducing the etching degree of the damage layer 104 and the initial substrate 110 corresponding to the finally formed slope 141 during the first texturing treatment, and promoting the formation of the slope 141 including the second pyramids 141a after the first texturing treatment.

In some embodiments, referring to FIG. 12, the energy of the laser spot is irradiance of the laser spot. Along the direction from the center to the edge of the laser spot, the irradiance of the laser spot is increased by 0.016 J/mm² to 0.19 J/mm² per 1 µm distance in the second stage II, and the irradiance of the laser spot is decreased by 0.01 J/mm² to 0.04 J/mm² per 1 µm distance in the third stage III.

It should be noted that setting the growth rate of the irradiance of the laser spot in the second stage II being greater than the decrease rate of the irradiance of the laser spot in the third stage III is advantageous to eventually form a bottom surface 131 with a longer length in the first direction X, as well as to form a less steep slope 141. In addition, setting the growth rate of the irradiance of the laser spot in the second stage II and the decrease rate of the irradiance of the laser spot in the third stage III both relatively large is beneficial for the first texturing treatment to form the first pyramids 131a in the bottom surface 131 and form the second pyramids 141a in the slope 141.

In some examples, along the direction from the center to the edge of the laser spot, the amount of the irradiance of the laser spot increased per 1 µm distance in the second stage II may be 0.017 J/mm², 0.02 J/mm², 0.03 J/mm², 0.04 J/mm², 0.05 J/mm², 0.06 J/mm², 0.07 J/mm², 0.08 J/mm², 0.09 J/mm², 0.1 J/mm², 0.11 J/mm², 0.12 J/mm², 0.13 J/mm², 0.14 J/mm², 0.15 J/mm², 0.16 J/mm², 0.17 J/mm², or 0.18 J/mm², etc.

In some examples, along the direction from the center to the edge of the laser spot, the amount of the irradiance of the laser spot decreased per 1 µm distance in the second stage III may be 0.011 J/mm², 0.012 J/mm², 0.013 J/mm², 0.014 J/mm², 0.015 J/mm², 0.016 J/mm², 0.017 J/mm², 0.018 J/mm², 0.019 J/mm², 0.02 J/mm², 0.021 J/mm², 0.022 J/mm², 0.023 J/mm², 0.024 J/mm², 0.025 J/mm², 0.026 J/mm², 0.027 J/mm², 0.028 J/mm², 0.029 J/mm², 0.03 J/mm², 0.031 J/mm², 0.032 J/mm², 0.033 J/mm², 0.034 J/mm², 0.035 J/mm², 0.036 J/mm², 0.037 J/mm², 0.038 J/mm², or 0.039 J/mm², etc.

It should be noted that the irradiance represents the amount of radiant energy received per unit area and per unit time on the surface irradiated by the radiant energy, that is, the radiant flux density on the irradiated surface.

In some embodiments, referring to FIG. 12, the first preset value may range from 0.01J/mm² to 0.02J/mm², and for example, may be 0.011 J/mm², 0.012 J/mm², 0.013 J/mm², 0.014 J/mm², 0.015 J/mm², 0.016 J/mm², 0.017 J/mm², 0.018 J/mm², or 0.019 J/mm², etc. The second preset value may range from 0.1J/mm² to 0.2J/mm², and for example, may be 0.11 J/mm², 0.12 J/mm², 0.13 J/mm², 0.14 J/mm², 0.15 J/mm², 0.16 J/mm², 0.17 J/mm², 0.18 J/mm², or 0.19 J/mm², etc.

In some embodiments, referring to FIG. 11 and FIG.1 to FIG. 5, the first texturing treatment uses a first etching solution that include potassium hydroxide and water, and a ratio of potassium hydroxide to water ranges from 0.002:1 to 0.01:1, and for example, may be 0.003, 0.004, 0.005, 0.006, 0.007, 0.008, or 0.009, etc.

In some embodiments, a treatment duration of the first texturing treatment ranges from 200 s to 300 s, and for example, may be 205s, 210s, 215s, 220s, 225s, 230s, 235s, 240s, 245s, 250s, 255s, 260s, 265s, 270s, 275s, 280s, 285s, 290s, or 295s, etc.

In some embodiments, a process temperature of the first texturing treatment ranges from 65°C to 75°C, and for example, may be 66°C, 67°C, 68°C, 69°C, 70°C, 71°C, 72°C, 73°C, or 74°C, etc.

In some examples, irradiating the initial substrate 110 with the laser spot shown in FIG. 12 is beneficial to forming the first damage layer with thickness remaining unchanged first, then gradually increasing, and finally gradually decreasing to zero along the direction from the center of the initial second region 150 to the initial first region 140.

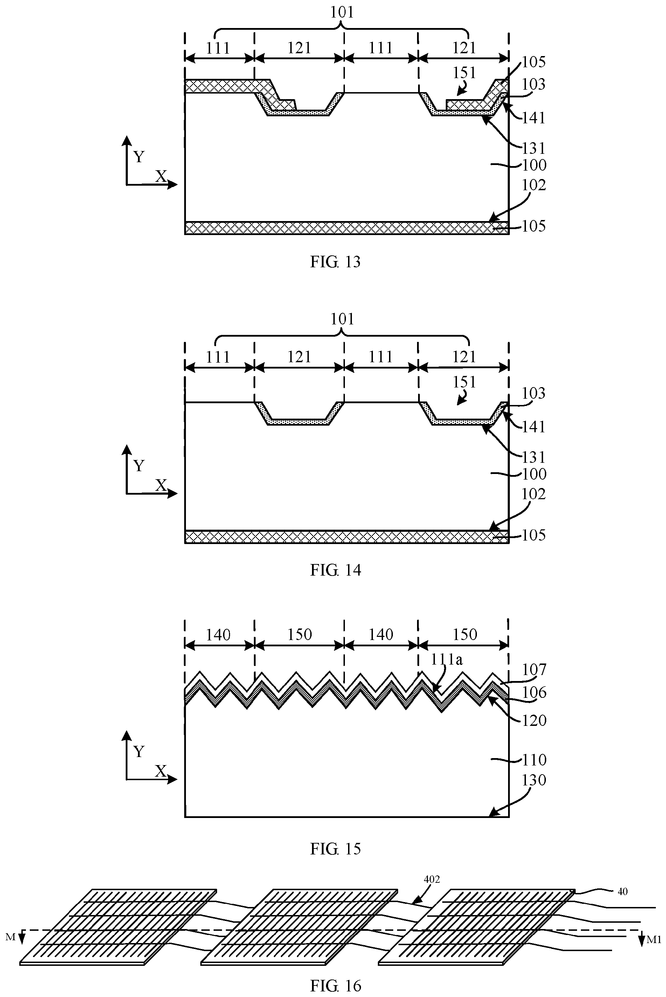

In some embodiments, with reference to FIG. 1, FIG. 7, FIG. 13 and FIG. 14, the method for manufacturing the photovoltaic cell further includes:
referring to FIG. 1 and FIG. 7, performing a high-temperature treatment or a high-temperature doping treatment on the grooves 151 to form a first protective layer 103 to cover the bottom surface 131 and the slope 141,
referring to FIG. 7 and FIG. 13, forming a first doped semiconductor layer 105 on the second surface 102, where the first doped semiconductor layer 105 is also located on a portion of the first surface 101, and
referring to FIG. 13 and FIG. 14, performing an etching process on the first doped semiconductor layer 105 located on the first surface 101 with the first protective layer 103 as an etching barrier layer.

FIG. 13 is a schematic diagram illustrating a partial cross-sectional view of forming a first doped semiconductor layer on a structure shown in FIG. 7, and FIG. 14 is a schematic diagram illustrating a partial cross-sectional view of performing an etching process on a structure shown in FIG. 13.

It should be noted that during the process of forming the first doped semiconductor layer 105 on the second surface 102, there may be a wrapping plating phenomenon, so the first doped semiconductor layer 105 may also be formed on some regions of the first surface 101. Subsequently, an etching process needs to be performed on the first doped semiconductor layer 105 located on the first surface 101. During the etching process, the first protective layer 103 may be used as an etching barrier layer to avoid the damage to the surfaces of the first pyramids 131a and the second pyramids 141a caused by the etching process, thereby being beneficial to ensuring that the second region 121 has a relatively low reflectivity. In addition, the first protective layer 103 is beneficial to improving the optical performance of the second region 121 to further reduce the reflection loss of the second region 121. For example, the first protective layer 103 can reduce the reflectivity of the overall surface of the photovoltaic cell located in the second region 121 to improve the absorption and utilization rate of the second region 121 of the first surface 101 for light, thereby improving the photoelectric conversion efficiency of the photovoltaic cell.

In some cases, the process temperature of the high-temperature treatment or the high-temperature doping treatment ranges from 900°C to 1050°C, and the treatment duration ranges from 2000 s to 5000 s.

In some examples, the process temperature of the high-temperature treatment or the high-temperature doping treatment may be 910°C, 920°C, 930°C, 940°C, 950°C, 960°C, 970°C, 980°C, 990°C, 1000°C, 1010°C, 1020°C, 1030°C, or 1040°C, etc.

In some examples, the treatment duration of the high-temperature treatment or the high-temperature doping treatment may be 2100 s, 2200 s, 2300 s, 2400 s, 2500 s, 2600 s, 2700 s, 2800 s, 2900 s, 3000 s, 3100 s, 3200 s, 3300 s, 3400 s, 3500 s, 3600 s, 3700 s, 3800 s, 3900 s, 4000 s, 4100 s, 4200 s, 4300 s, 4400 s, 4500 s, 4600 s, 4700 s, 4800 s, or 4900 s, etc.

In some cases, the high-temperature treatment may be an oxygen-free high-temperature process. Directly performing a high-temperature treatment on the groove 151 can transform a portion of the thickness of the substrate 100 corresponding to the groove 151 into the first protective layer 103. In some examples, the substrate 100 is a semiconductor material doped with a doping element. Based on the oxygen-free high-temperature process, it is beneficial to increasing the concentration of the doping element in a portion of the substrate 100 close to the groove 151, thereby forming the first protective layer 103 with a different doping element concentration from the doping element concentration in the remaining substrate 100. The material of the first protective layer 103 is also a semiconductor material including a doping element. It should be noted that after the first protective layer 103 is formed by the oxygen-free high-temperature process, the reflectivity of the overall surface of the photovoltaic cell located in the second region 121 can be reduced by about 0.1 to 0.3 on the original basis.

In some other cases, the high-temperature treatment may be an oxygen-containing high-temperature process. When a high-temperature treatment is performed on the groove 151, an oxidation treatment is also performed on the groove 151, which can oxidize a portion of the thickness of the substrate 100 corresponding to the groove 151 to form the first protective layer 103. In some examples, the substrate 100 may include a silicon material, and the first protective layer 103 including silicon oxide is formed based on the oxygen-containing high-temperature process. It should be noted that after the first protective layer 103 is formed by the oxygen-containing high-temperature process, the reflectivity of the overall surface of the photovoltaic cell located in the second region 121 can be reduced by about 0.5 to 1 on the original basis.

In still some other cases, the high-temperature doping treatment may be an in-situ doped oxidation process. When a high-temperature treatment is performed on the groove 151, a doping treatment and an oxidation treatment are also performed on the groove 151, so that a portion of the thickness of the substrate 100 corresponding to the groove 151 is transformed into the first protective layer 103, and the first protective layer 103 includes an oxidized material doped with a doping element. In some examples, the substrate 100 may include a silicon material, and the first protective layer 103 including phosphosilicate glass or borosilicate glass is formed based on the in-situ doped oxidation process.

It should be noted that after the first protective layer 103 is formed by the in-situ doped oxidation process, the reflectivity of the overall surface of the photovoltaic cell located in the second region 121 can be reduced by about 0.5 to 1 on the original basis. In addition, phosphosilicate glass or borosilicate glass are only two examples of the first protective layer 103 formed based on the in-situ doped oxidation process. In practical applications, the doping source provided in the in-situ doped oxidation process may include other group V elements or other group III elements.

In other embodiments, in the operation of performing high temperature treatment on the groove 151, no additional film layer may be formed, and the high temperature provided by the high temperature treatment only repairs the laser damage to reduce the defect state density on the surface of the groove 151, thereby reducing the recombination center of the carriers at the groove 151, and enhancing the photovoltaic cell photovoltaic conversion efficiency.

In some cases, during the process of forming the first doped semiconductor layer 105, a first dielectric layer (not shown in the drawings) is formed on a side of the first doped semiconductor layer 105 away from the second surface 102. In one example, the substrate 100 is an N-type semiconductor substrate, the first doped semiconductor layer 105 is polysilicon doped with N-type doping elements, and the material of the first dielectric layer may be phosphor-silicon glass.

Based on this, the operation of performing the etching process on the first doped semiconductor layer 105 disposed on the first surface 101 may include: removing the first dielectric layer disposed on the first surface 101 using a chain hydrofluoric acid process, and removing the first doped semiconductor layer 105 uncovered by the first dielectric layer using an alkali polishing process, such that the first doped semiconductor layer 105 disposed on the second surface 102 is retained.

In some cases, referring to FIG. 8, prior to forming the first doped semiconductor layer 105, the manufacturing method may further include: forming a tunneling layer 108 on the second surface 102. Subsequently, forming the first doped semiconductor layer 105 on a side of the tunneling layer 108 away from the substrate 100. It should be noted that there is no limitation on the process of forming the tunneling layer 108 in the manufacturing method.

In some embodiments, referring to FIG. 10 and FIG. 15, after providing the initial substrate 110 and before irradiating the initial second region 150 using a laser spot with a gradual change in energy, the method for manufacturing the photovoltaic cell may also include: referring to FIG. 10 and FIG. 15, performing a second texturing treatment on the initial first surface 120, so that the initial first surface 120 includes a plurality of third pyramids 111a, continuing to refer to FIG. 15, performing a doping treatment on the initial first surface 120 to transform a portion of a thickness of the initial substrate 110 into the second doped semiconductor layer 106, and forming a second protective layer 107 on a side of the second doped semiconductor layer 106 away from the initial substrate 110. Referring to FIG. 15 and FIG. 3 or FIG. 5, in the operation of performing the first texturing treatment on the initial second regions 150, i.e. in the operation S3, retaining the second doped semiconductor layer 106 located in the initial first regions 140 with the second protective layer 107 as an etching barrier layer, and forming a third textured surface including a plurality of third pyramids 111a by the initial first regions 140. The base size of the third pyramid 111a is smaller than the base size of the second pyramid 141a.

FIG. 15 is a schematic diagram illustrating a partial cross-sectional view of forming a second doped semiconductor layer and a second protective layer on an initial substrate in a method for manufacturing a photovoltaic cell according to another embodiment of the present disclosure.

It should be noted that the initial first surface 120 includes a plurality of third pyramids 111a, which is beneficial to subsequently forming the first region 111 as a third textured surface including a plurality of third pyramids 111a. In addition, different texturing treatments are respectively used to form the initial first surface 120 including a plurality of third pyramids 111a and the grooves 151.

Moreover, referring to FIG. 15 and FIG. 11, during the process of irradiating the initial second region 150 using the laser spot with a gradual change in energy in operation S2, both the second protective layer 107 and the second doped semiconductor layer 106 located on the initial second region 150 is transformed into the damage layer 104. Referring to FIG. 15 and FIG. 3 or FIG. 5, the second protective layer 107 located on the initial first region 140 that is not irradiated by the laser spot may be used as an etching barrier layer in operation S3 to achieve that only the first region 111 is retained as a third textured surface including a plurality of third pyramids 111a. That is, referring to FIG. 8, the remaining second doped semiconductor layer 106 is only located on the first region 111 to be used as a selective emitter structure on the first surface 101, which is beneficial to reducing the contact resistance between the subsequently formed second electrode and the second doped semiconductor layer 106 and reducing the recombination probability of carrier in other regions of the first surface 101, so as to improve the photoelectric conversion efficiency of the finally formed photovoltaic cell.

In one example, the substrate 100 is an N-type semiconductor substrate, the second doped semiconductor layer 106 is a semiconductor material doped with a P-type doping element, such as a boron diffusion layer, and the material of the second protective layer 107 may be borosilicate glass.

It should be noted that the dimensional relationship between the first pyramid 131a, the second pyramid 141a and the third pyramid 111a is the same as in the previous embodiments and will not be repeated herein.

In some cases, referring to FIG. 13 and FIG. 14, after the alkaline polishing process is used to remove the first doped semiconductor layer 105 not covered by the first dielectric layer, to retain the first doped semiconductor layer 105 located on the second surface 102, the manufacturing method may further include: referring to FIG. 15 and FIG. 3 or FIG. 5, removing the remaining second protective layer 107 located on the initial first regions 140 by using the acid cleaning process. It should be noted that by controlling the process parameters of the acid cleaning process, such as the process duration, the second protective layer 107 is removed and the first protective layer 103 is retained only by means of the acid cleaning process, or both the second protective layer 107 and the first protective layer 103 are removed by means of the acid cleaning process.

In some cases, referring to FIG. 8, after forming the first doped semiconductor layer 105 and the second doped semiconductor layer 106, the manufacturing method may further include: forming a first passivation layer 118 located on a side of the first doped semiconductor layer 105 away from the tunneling layer 108, forming a second passivation layer 128 located on a side of the second doped semiconductor layer 106 away from the substrate 100 and on the second regions 121, forming first electrodes 109 in ohmic contact with the first doped semiconductor layer 105, and forming second electrodes 119 embedded in the second passivation layer 128 and in ohmic contact with the second doped semiconductor layer 106.

In some examples, the first passivation layer 118 and the second passivation layer 128 are formed by using an atomic layer deposition process and/or a plasma-enhanced chemical vapor deposition process. It should be noted that the second passivation layer 128 located on the first surface 101 and the first passivation layer 118 on the second surface 102 may be formed synchronously.

In some examples, the operation of forming the first electrodes 109 may include: using a screen printing process to print a metal paste on the surface of a portion of the first passivation layer 118 away from the second surface 102, and performing a sintering process on the metal paste. In some examples, the metal paste includes materials with high corrosiveness such as glass. Thus, during the sintering process, the corrosive components may at least corrode the first passivation layer 118, so that the metal paste penetrates from the first passivation layer 118 to the first doped semiconductor layer 105, thereby forming the first electrodes 109. It should be noted that the operations of forming the second electrodes 119 are similar to those of forming the first electrodes 109, and reference may be made to the above description of the operations of forming the first electrodes 109.

In some examples, the metal paste may include at least one of silver, aluminum, copper, tin, gold, lead or nickel.

It should be noted that there is no restriction on the formation process of the first passivation layer 118, the second passivation layer 128, the first electrodes 109, and the second electrodes 119 in the manufacturing method provided in the embodiment of the present disclosure, and different formation processes may be selected according to the needs in practical application. In summary, based on the design in operation S2 that in the direction along the center of the laser spot pointing to the edge, the energy of the laser spot first remains unchanged, then gradually increases, and finally gradually decreases to zero, which is conducive to making the thickness of the damage layer 104 formed in operation S2 vary at different regions or the degree of the interior being damaged vary. On this basis, in operation S3, the time taken by the first texturing treatment to remove different thicknesses of the damage layer 104 also varies, so that the first texturing treatment may expose the initial substrate 110 covered by different portions of the damage layer 104 at different moments, and the remaining initial substrate 110 is subjected to the texturing treatment at different moments, thus facilitating the formation of the groove 151 jointly enclosed by the bottom surface 131 and the slope 141, with different textured structures on the bottom surface 131 and the less steep slopes 141.

Another embodiment of the present disclosure further provides a photovoltaic module, which is configured to convert received light energy into electrical energy. The photovoltaic module provided in the embodiment of the present disclosure will be described in detail with reference to the accompanying drawings. It should be noted that the same or corresponding parts as those in the foregoing embodiments will not be described again herein.

Referring to FIG. 1 to FIG. 15, and FIG. 16 and FIG. 17, the photovoltaic module includes: at least one cell string, each formed by connecting a plurality of photovoltaic cells 40 provided in the foregoing embodiments, or formed by connecting a plurality of photovoltaic cells 40 formed by the method for manufacturing the photovoltaic cell provided in the foregoing embodiments, at least one encapsulation adhesive film 41, configured to cover a surface of the at least one cell string, and at least one cover plate 42, configured to cover a surface of the at least one encapsulation adhesive film 41 away from the at least one cell string. The photovoltaic cells 40 are electrically connected in the form of a whole sheet or multiple sheets to form the at least one cell strings, and the at least one cell strings are electrically connected in series and/or in parallel.

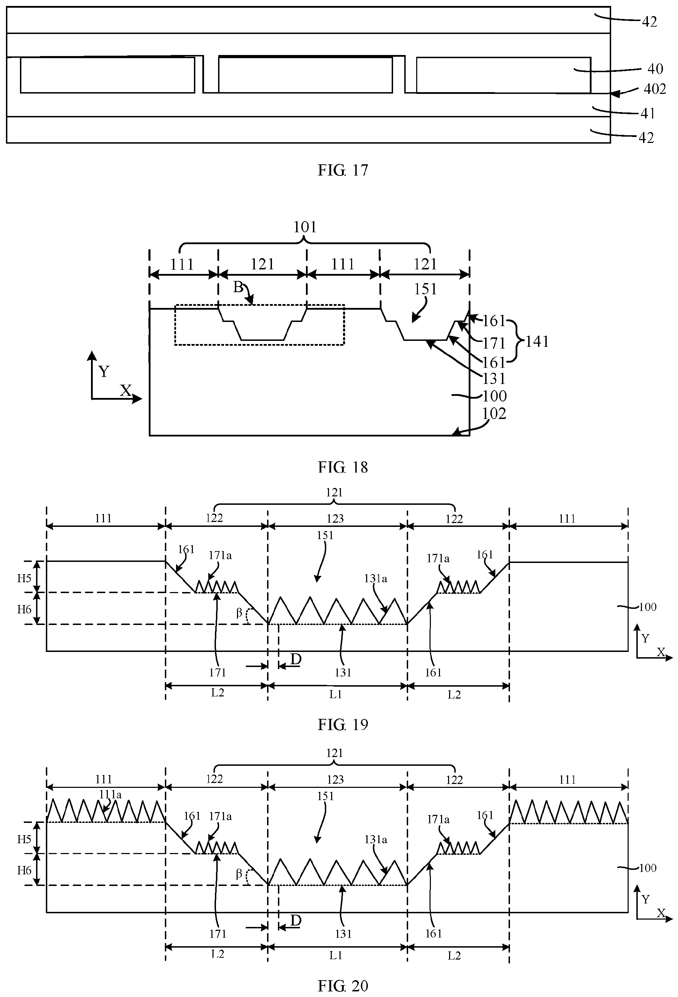

FIG. 16 is a schematic diagram illustrating a partial perspective view of a photovoltaic module according to another embodiment of the present disclosure, and FIG. 17 is a schematic diagram illustrating a cross-sectional structural view of the photovoltaic module taken along line MM1 in FIG. 16.

In some embodiments, the photovoltaic cell 40 includes, but is not limited to, one or any combination of a PERC cell (Passivated Emitter Rear Cell), an Interdigitated Back Contact (IBC) cell, a Tunnel Oxide Passivated Contact (TOPCon) cell, a Heterojunction Technology (HIT/HJT) cell, a solar thin-film cell, and a tandem cell. The solar thin-film cell includes, but is not limited to, a perovskite solar thin-film cell, a copper indium gallium selenide solar thin-film cell, a gallium arsenide solar thin-film cell, and a cadmium sulfide solar thin-film cell. The tandem cell includes, but is not limited to, a perovskite cell stacked with a crystalline silicon cell, a perovskite cell stacked with a perovskite cell, and a perovskite cell stacked with a thin-film cell.

In some embodiments, the photovoltaic cell 40 may be a monocrystalline silicon solar cell, a polycrystalline silicon solar cell, an amorphous silicon solar cell or a multi-component compound solar cell. Specifically, the multi-component compound solar cell may be a cadmium sulfide solar cell, a gallium arsenide solar cell, a copper indium gallium selenide solar cell or a perovskite solar cell. In addition, the photovoltaic cell 40 may be a whole cell or a sliced cell. A sliced cell refers to a cell formed by cutting a complete whole cell by a cutting process.

In some embodiments, referring to FIG. 17, a plurality of cell strings may be electrically connected through a conductive strip 402. FIG. 17 only illustrates one positional relationship between photovoltaic cells, that is, the electrodes with the same polarity of the photovoltaic cells are arranged in the same direction, or in other words, the electrodes with positive polarity of each photovoltaic cell are all arranged on the same side, so that the conductive strip connects the different sides of two adjacent photovoltaic cells respectively. In some embodiments, the photovoltaic cells may also be arranged such that the electrodes with different polarities face the same side, that is, the electrodes of a plurality of adjacent photovoltaic cells are sequentially arranged in the sequence of the first polarity, the second polarity, and the first polarity, then the conductive strip connects two adjacent photovoltaic cells on the same side.

In some embodiments, there is no interval between the photovoltaic cells, that is, the adjacent photovoltaic cells overlap each other.

In some embodiments, the at least one encapsulation adhesive film 41 include a first encapsulation layer and a second encapsulation layer. The first encapsulation layer covers one of the front or the back of the photovoltaic cell 40, and the second encapsulation layer covers the other of the front or the back of the photovoltaic cell 40. Specifically, at least one of the first encapsulation layer and the second encapsulation layer may be an organic encapsulation adhesive film such as a polyvinyl butyral (PVB) adhesive film, an ethylene-vinyl acetate (EVA) adhesive film, a polyolefin elastomer (POE) adhesive film or a polyethylene terephthalate (PET) adhesive film, or at least one of the first encapsulation layer and the second encapsulation layer may also be an adhesive film such as an EP adhesive film, an EPE adhesive film or a PVP adhesive film. The EP adhesive film refers to a co-extruded adhesive film composed of an EVA adhesive film and a POE adhesive film stacked layer by layer, the EPE adhesive film refers to a co-extruded adhesive film formed by using an EVA adhesive film, a POE adhesive film and an EVA adhesive film stacked in sequence, and the PVP adhesive film refers to a co-extruded adhesive film formed by stacking a POE adhesive film, an EVA adhesive film and a POE adhesive film. The preparation method of the co-extruded adhesive film may be to sequentially extrude one or more raw materials onto another already-made adhesive film during the processing of the adhesive film, or to bond the already-made adhesive films of different types together.

In some cases, there is a dividing boundary between the first encapsulation layer and the second encapsulation layer before lamination. After the lamination treatment, when the photovoltaic module is formed, the concepts of the first encapsulation layer and the second encapsulation layer no longer exist, that is, the first encapsulation layer and the second encapsulation layer have formed the overall encapsulation adhesive film 41.

In some embodiments, the at least one cover plate 42 may be a glass cover plate, a plastic cover plate and other cover plates with a light-transmitting function. Specifically, the surface of the cover plate 42 facing the encapsulation adhesive film 41 may be a concave-convex surface or a textured surface including a plurality of protruding structures, so as to increase the utilization rate of incident light. The at least one cover plate 42 includes a first cover plate and a second cover plate. The first cover plate is opposite to the first encapsulation layer, and the second cover plate is opposite to the second encapsulation layer.

In some embodiments, the photovoltaic cell 40 may be a cell with busbars or a cell without busbars.

The embodiments of the present disclosure further provide a photovoltaic cell, a method for manufacturing the photovoltaic cell, and a photovoltaic module. In the photovoltaic cell, the surface jointly formed by a plurality of inclined surfaces and the stepped surface connecting two adjacent inclined surfaces in the same groove is taken as the slope. The groove with this slope may be regarded as a multi-layer stepped structure. On one hand, it beneficial to forming a stepped light propagation path in the groove, so that the light incident on the groove can be reflected multiple times between the inclined surfaces and the stepped surface, and finally be absorbed and utilized by the second region. On the other hand, the stepped light propagation path is beneficial to extending the optical path, so as to improve the absorption and utilization rate of the slope for long-wavelength light, such as infrared light. On another hand, compared with the first pyramids included in the bottom surface, both the base size and the height of the fourth pyramids are smaller. Firstly, it is beneficial to more uniformly distributing the light incident on the slope with the help of the smaller fourth pyramids, so as to improve the overall light absorption and utilization rate of the slope, and reduce light escape, thereby further reducing the reflection loss of light on the slope. Secondly, it is beneficial to enhancing the scattering of light on the slope, so as to improve the absorption rate of the slope for short-wavelength light, such as blue light and ultraviolet light. In this way, through the comprehensive effect of multiple aspects, a multi-level light trapping effect can be achieved macroscopically, and the reflection loss of light on the groove can be reduced microscopically, and more light at different incident angles can be received and utilized from the macro to the micro level, so as to improve the light trapping effect of the second region, thereby improving the photoelectric conversion efficiency of the photovoltaic cell. Additionally, as a transition region between the bottom surface and the first region, the slope, based on the design of the stepped surface, divides the transition region into at least two regions with height differences. On one hand, it improves the overall flatness of the second region, which is beneficial to forming a film layer with a uniform thickness on the first surface subsequently. In addition, both the stepped surface and the transition with multiple levels of small height differences can relieve the degree of stress concentration during film deposition, thereby reducing the risk of film cracking or peeling. On the other hand, it is beneficial for the photo-generated carriers in the second region to quickly migrate to the nearest first region, and reducing the lateral transmission distance of the photo-generated carriers, so as to reduce the recombination probability of the photo-generated carriers. On the other hand, the stepped surface can avoid too high or too low local light intensity in the slope, and the slope as a whole can disperse the density of the photo-generated carriers, so as to avoid an excessive density of the photo-generated carriers near the electrode located in the first region, thereby reducing the risk of the local hot spot effect occurring in the photovoltaic cell.

Referring to FIG. 18 to FIG. 21, the photovoltaic cell includes a substrate 100 having a first surface 101 and a second surface 102 opposite to each other. The first surface 101 has first regions 111 and second regions 121 alternately arranged in a first direction X. The substrate 100 has grooves 151 recessed into the substrate 100 in the second regions 121. Each groove 151 includes a bottom surface 131, at least two inclined surfaces 161 connecting the bottom surface 131 and the first region 111, and a stepped surface 171 connecting two adjacent inclined surfaces 161. The at least two inclined surface 161 are inclined towards a direction that the second region 121 is close to the first region 111. The bottom surface 131 is provided as a first textured surface including a plurality of first pyramids 131a, the stepped surface 171 is provided as a second textured surface including a plurality of fourth pyramids 171a. A base size of the first pyramid 131a is greater than a base size of the fourth pyramid 171a, and a height of the first pyramid 131a is greater than a height of the fourth pyramid 171a.

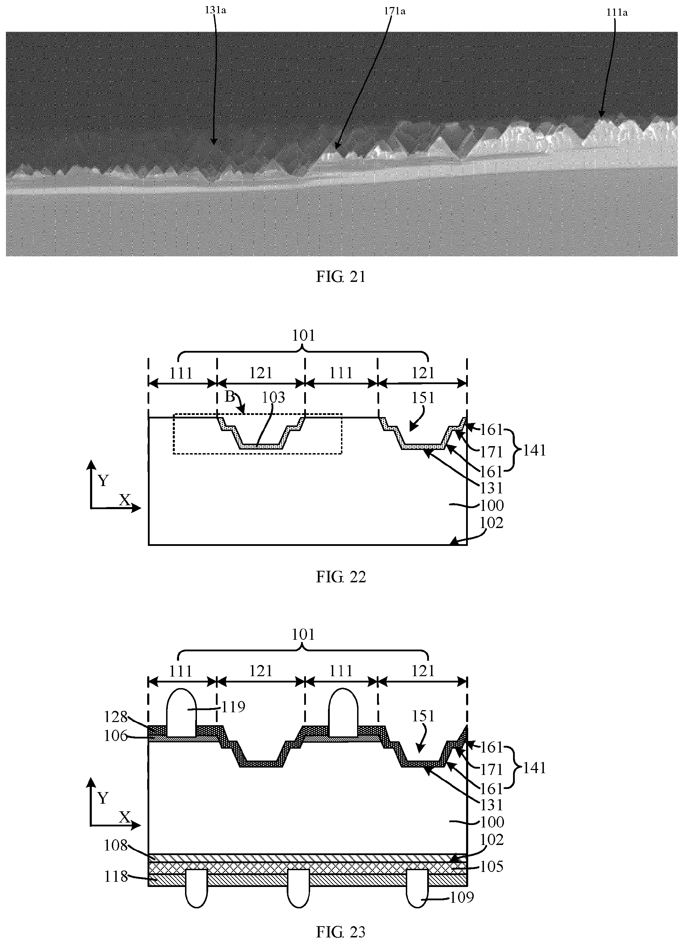

FIG. 18 is a schematic diagram illustrating a sixth partial cross-sectional view of a photovoltaic cell according to an embodiment of the present disclosure. FIG. 19 is a schematic diagram illustrating a first enlarged view of the substrate at a dashed box B shown in FIG. 18. FIG. 20 is a schematic diagram illustrating a second enlarged view of the substrate at the dashed box B shown in FIG. 18. FIG. 21 is another three-dimensional scanning electron microscope (SEM) schematic diagram of a substrate in a photovoltaic cell according to an embodiment of the present disclosure.

It should be noted that, an individual groove 151 includes at least two inclined surfaces 161 and at least one stepped surface 171, and may be regarded as a multi-layer stepped structure. A surface jointly formed by a plurality of inclined surfaces 161 and the stepped surface 171 connecting two adjacent inclined surfaces 161 in the same groove 151 is taken as the slope 141. On one hand, it is beneficial to forming a stepped light propagation path in the groove 151 with the help of the slope 141, so that the light incident on the groove 151 can be reflected multiple times between the inclined surfaces 161 and the stepped surface 171, and finally be absorbed and utilized by the second region 121. On the other hand, the stepped light propagation path is beneficial to extending the optical path, so as to improve the absorption and utilization rate of the slope 141 for long-wavelength light, such as infrared light. On the other hand, the stepped surface 171 is designed as the second textured surface including a plurality of fourth pyramids 171a, and compared with the first pyramids 131a included in the bottom surface 131, both the base size and the height of the fourth pyramids 171a are smaller. Firstly, it is beneficial to more uniformly distributing the light incident on the slope 141 with the help of the smaller fourth pyramids 171a, so as to avoid too high or too low local light intensity in the slope 141, improve the overall light absorption and utilization rate of the slope 141, and reduce light escape, thereby further reducing the reflection loss of light on the slope 141, and improving the photoelectric conversion efficiency of the photovoltaic cell under weak light conditions or oblique light conditions. Secondly, it is beneficial to enhancing the scattering of light on the slope 141, so as to improve the absorption rate of the slope 141 for short-wavelength light, such as blue light and ultraviolet light. In this way, through the comprehensive effect of multiple aspects, a multi-level light trapping effect can be achieved macroscopically by means of the multi-layer stepped structure, and the reflection loss of light on the groove 151 can be reduced microscopically by means of the stepped surface 171 including the plurality of fourth pyramids 171a, and more light at different incident angles can be received and utilized from the macro to the micro level, so as to improve the light trapping effect of the second region 121, thereby increasing the short-circuit current of the photovoltaic cell and improving the photoelectric conversion efficiency of the photovoltaic cell.

Moreover, as a transition region between the bottom surface 131 and the first region 111, the slope 141, based on the design of the stepped surface 171, divides the transition region into at least two regions with height differences. On one hand, it is beneficial to reducing the steepness of slope 141, that is, it improves the overall flatness of the second region 121, which is beneficial to forming a film layer with a uniform thickness on the first surface 101 subsequently. In addition, both the stepped surface 171 and the transition with multiple levels of small height differences can relieve the degree of stress concentration during film deposition, thereby reducing the risk of film cracking or peeling. On the other hand, it is beneficial for the photo-generated carriers in the second region 121 to quickly migrate to the nearest first region 111, and reducing the lateral transmission distance of the photo-generated carriers, so as to reduce the recombination probability of the photo-generated carriers, thereby improving the photoelectric conversion efficiency of the photovoltaic cell. On the other hand, the stepped surface 171 can avoid too high or too low local light intensity in the slope 141, and the slope 141 as a whole can disperse the density of the photo-generated carriers, so as to avoid an excessive density of the photo-generated carriers near the electrode located in the first region 111, thereby reducing the risk of the local hot spot effect occurring in the photovoltaic cell.

It should be noted that in some cases, the inclined surfaces 161 do not all have pyramids. Only the stepped surface 171 includes a plurality of fourth pyramids 171a, and the inclined surfaces 161 are smooth surfaces to further improve the overall flatness of the second region 121, so as to improve the thickness uniformity of the film layer formed on the second region 121 subsequently. It should be noted that the inclined surfaces 161 being smooth surfaces is in comparison with the stepped surface 171 including the fourth pyramids 171a. Due to the influence of the forming process, the surface of the inclined surface 161 may not necessarily be as smooth as a polished surface, and there may also be tiny protrusions or depressions, without having a typical pyramid structure, and the overall flatness is much higher than that of the stepped surface 171.

It should be noted that the photovoltaic cell further includes electrodes at least located on the first surface 101, and the electrodes are used to extract the photo-generated carriers generated in the substrate 100. Based on this, in order to facilitate the description of the specific orientation of the first pyramids 131a and the fourth pyramids 171a on the first surface 101, for those skilled in the art, the first surface 101 may be divided into first regions 111 and second regions 121. The first regions 111 include at least the regions where orthographic projection of the electrodes are located on the substrate 100, and the regions on the first surface 101 other than the first regions 111 are the second regions 121. In order to ensure that the film layer in contact with the electrodes has a large doping concentration or the regions in contact with the electrodes are high-concentration regions to reduce the contact resistance, an orthographic projection area of the first region 111 is generally set to be greater than or equal to an orthographic projection area of the corresponding electrode. In other words, the orthographic projection area of the electrode on the substrate 100 is smaller than the area of the first region 111, and the orthographic projection position is necessarily within the first region 111. It should be noted that the number of the first regions 111 and the number of the second regions 121 may both be plural, and the first regions 111 and the second regions 121 are alternately arranged in the first direction X. In other words, the first region 111 may be located in an interval between adjacent second regions 121, and the second region 121 may also be located in an interval between adjacent first regions 111.

Further, in order to further reflect the difference between the first pyramids 131a and the fourth pyramids 171a, for those skilled in the art, the second region 121 may be divided into one transition region 122, one second sub-region 123, and another transition region 122 arranged in sequence in the first direction X. One transition region 122 is referred to as the region occupied by one slope 141 in the second region 121, and one second sub-region 123 is referred to as the region occupied by one bottom surface 131 in the second region 121. In other words, the first pyramids 131a are located in the second sub-region 123, and the fourth pyramids 171a is located in the transition region 122. In addition, each of the two first regions 111 on two opposite sides of the same second region 121 along the first direction X is connected to one corresponding transition region 122.

The embodiments of the present disclosure will be described in more detail below with reference to the accompanying drawings.

Referring to FIG. 19 or FIG. 20, by designing the base size of the first pyramids 131a to be larger than that of the fourth pyramids 171a, the number of first pyramids 131a is lower than that of the fourth pyramids 171a within the same arrangement area. In other words, compared with the distribution density of the first pyramids 131a in the bottom surface 131, the fourth pyramids 171a in the stepped surface 171 exhibit a higher distribution density. On one hand, it is advantageous to increase the surface area and the specific surface area of the stepped surface 171 so that the stepped surface 171 has more surfaces for receiving incident light, which is beneficial to enable more light to be reflected, refracted, or absorbed and utilized by the stepped surface 171. On the other hand, it is conducive to lowering the gap between adjacent fourth pyramids 171a, so that the step surface 171 can capture the incident light more efficiently to reduce the probability of the light escaping from the space between adjacent fourth pyramids 171a, and a larger number of fourth pyramids 171a can disperse the incident light more uniformly, so that the incident light is more likely to enter into the substrate 100 and then be absorbed and utilized. On another hand, it is also beneficial to reduce the sensitivity of the step surface 171 to the angle of the incident light, so that the step surface 171 can maintain a higher absorption rate of the light at different light angles.

It should be noted that the base size of the pyramid structure includes any one of the length, width, or diagonal length of the orthographic projection pattern of the bottom of the pyramid structure on the second surface 102. For example, taking the orthographic projection pattern of the bottom of the pyramid structure on the second surface 102 being a regular quadrilateral as an example, the base size of the pyramid structure is any one of the length, width, or diagonal length of the regular quadrilateral. In addition, the pyramid structures mentioned herein include the first pyramids 131a, the fourth pyramids 171a and the third pyramids mentioned later.

In practical applications, the orthographic projection pattern of the bottom of the pyramid structure on the second surface may also be an irregular polygon. In this case, the length, width, or diagonal length of the orthographic projection pattern of the bottom of the pyramid structure on the second surface is not absolute, but is artificially defined to characterize the base size of the pyramid structure. For example, if the orthographic projection pattern of the bottom of the pyramid structure on the second surface is an irregular quadrilateral, a length of the base of the pyramid structure may be defined as a side length of a longest side of the irregular quadrilateral, a width of the base of the pyramid structure may be defined as a side length of a shortest side of the irregular quadrilateral, and a diagonal length of the base of the pyramid structure may be defined as a length of a longest diagonal of the irregular quadrilateral. It should be understood that the above is only an exemplary description, and it may be flexibly defined according to actual needs in practice. In addition, the orthographic projection pattern of the bottom of the pyramid structure on the second surface may be not only an irregular quadrilateral, but also other irregular polygons, a circle, or an irregular shape similar to a circle. In this case, the base size of the pyramid structure is obtained by selecting multiple different regions with a specific area at the bottom of the pyramid structure. The regions with a specific area may be flexibly defined according to actual needs to calculate average values of the lengths, widths, diagonals, or diameters of the multiple different regions with a specific area.

In some examples, the base size of the fourth pyramid 171a may range from 0.5 µm to 1.5 µm, and for example, may be 0.6 µm, 0.7 µm, 0.8 µm, 0.9 µm, 1 µm, 1.1 µm, 1.2 µm, 1.3 µm, or 1.4 µm, etc. The base size of the first pyramid 131a may range from 2 µm to 3 µm, and for example, may be 2.1 µm, 2.2 µm, 2.3 µm, 2.4 µm, 2.5 µm, 2.6 µm, 2.7 µm, 2.8 µm, or 2.9 µm, etc.

In one example, the base of the fourth pyramid 171a may be a quadrilateral with a size of 1 µm × 1 µm, and the base of the first pyramid 131a may be a quadrilateral with a size of 2.5 µm × 2.5 µm.

Referring to FIG. 19 or FIG. 20, the height of the first pyramid 131a is designed to be larger than the height of the fourth pyramid 171a. In this way, compared to the first pyramid 131a, the fourth pyramid 171a with a lower height also facilitates the reduction of the transmission distance of the photo-generated carriers at the step surface 171, thereby facilitating the reduction of the recombination probability of carrier, to enhance the photovoltaic conversion efficiency of the photovoltaic cell.

It should be noted that the height of the pyramid refers to the distance between the apex of the pyramid and the base of the pyramid in the second direction Y. The second direction Y is the direction in which the second surface 102 points towards the first surface 101, in other words, the second direction Y is the direction of the thickness of the substrate 100.

In some examples, the height of the fourth pyramid 171a may range from 0.5 µm to 1.5 µm, and for example, may be 0.6 µm, 0.7 µm, 0.8 µm, 0.9 µm, 1 µm, 1.1 µm, 1.2 µm, 1.3 µm, or 1.4 µm, etc. The height of the first pyramid 131a may range from 2 µm to 3 µm, and for example, may be 2.1 µm, 2.2 µm, 2.3 µm, 2.4 µm, 2.5 µm, 2.6 µm, 2.7 µm, 2.8 µm, or 2.9 µm, etc.

In some embodiments, referring to FIG. 18 to FIG. 20, the reflectivity of the second textured surface of the stepped surface 171 is less than the reflectivity of the first textured surface of the bottom surface 131.

In some examples, the reflectivity of the stepped surface 171 may range from 10 to 11, and for example, may be 10.1, 10.2, 10.3, 10.4, 10.5, 10.6, 10.7, 10.8. or 10.9, etc. The reflectivity of the bottom surface 131 may range from 12 to 13, and for example, may be 12.1, 12.2, 12.3, 12.4, 12.5, 12.6, 12.7, 12.8, or 12.9, etc.

In some embodiments, referring to FIG. 18 to FIG. 20, in the same groove 151, multiple inclined surfaces 161 and stepped surfaces 171 connecting adjacent inclined surfaces 161 jointly form slope 141, an orthographic projection area of the slope 141 on the bottom surface 131 is a first area, and an area of the bottom surface 131 is a second area. A ratio of the first area to the second area may range from 0.005 to 0.02. For example, it can be 0.006, 0.007, 0.008, 0.009, 0.01, 0.011, 0.012, 0.013, 0.014, 0.015, 0.016, 0.017, 0.018, or 0.019, etc. In this way, the surface area of the groove 151 is mainly determined by the area of the bottom surface 131. Designing the first pyramids 131a included in the bottom surface 131 to have a higher height is beneficial to providing a larger surface area and more attachment points, so that the film layer subsequently deposited on the surface of the groove 151 can be better attached and more uniformly cover the surface of the groove 151, thereby being beneficial to reducing the defects and pores in the film layer and improving the quality and performance of the film layer.

It should be noted that both the first region 111 and the second region 121 extend along a third direction. Therefore, the groove 151 may be regarded as an elongated trench extending along the third direction, where the bottom surface 131, the inclined surfaces 161 and the stepped surfaces 171 share identical extension dimensions in the third direction. The area sizes of the orthographic projection of the bottom surface 131 and the slope 141 on the bottom surface 131 primarily depend on their respective lengths of the orthographic projection of the bottom surface 131 and the slope 141 on the bottom surface 131 in the first direction X. In this way, by taking the length of the bottom surface 131 in the first direction X as the first length L1 and the length of the orthographic projection of the slope 141 on the bottom surface 131 in the first direction X as the second length L2, and designing the ratio of the first area to the second area to be 0.005 to 0.02, i.e. by designing the ratio of the second length L2 to the first length L1 in a range of 0.005 to 0.02, a surface area of the groove 151 is mainly determined by an area of the bottom surface 131. Designing the first pyramids 131a included in the bottom surface 131 to have a higher height is beneficial to providing a larger surface area and more attachment points, so that the film layer subsequently deposited on the surface of the groove 151 can be better attached and more uniformly cover the surface of the groove 151, that is, it is advantageous to make the deposited film layer, such as a passivation layer, an inverse reduction layer, or a transparent conductive layer, cover the surface of the groove 151 more uniformly, thereby being beneficial to reducing the defects and pores in the film layer and improving the quality and performance of the film layer.

In some cases, referring to FIG. 19 or FIG. 20, along the first direction X, the first length L1 of the bottom surface 131 ranges from 200 µm to 800 µm. For example, the first length L1 may be 250 µm, 300 µm, 350 µm, 400 µm, 450 µm, 500 µm, 550 µm, 600 µm, 650 µm, 700 µm or 750 µm, etc.

In some embodiments, referring to FIG. 19 or FIG. 20, the substrate 100 located in the second region 121 may include two inclined surfaces 161 and one stepped surface 171 connecting two adjacent inclined surfaces 161. Along the second direction Y, a distance between the stepped surface 171 and the first region 111 is a first distance H5, and a distance between the stepped surface 171 and the bottom surface 131 is a second distance H6. A ratio of the first distance H5 to the second distance H6 may range from 0.6 to 1.3. The second direction Y is the direction of the thickness of the substrate 100. In addition, the depth of the groove 151 may be the sum of the first distance H5 and the second distance H6.

It should be noted that a plane where the bottoms of most of the fourth pyramids 171a included in the stepped surface 171 are located is taken as a fourth reference plane, and a plane where the bottoms of most of the first pyramids 131a included in the bottom surface 131 is taken as the second reference plane. Along the second direction Y, the first distance H5 between the stepped surface 171 and the first region 111 refers to the distance between the fourth reference plane and the reference plane where the first region 111 is located, and the second distance H6 between the stepped surface 171 and the bottom surface 131 refers to the distance between the fourth reference plane and the second reference plane.

In addition, the bottom surface of the fourth pyramid 171a is a plane where the base of the fourth pyramid 171a is located. The orthographic projection pattern of the base of the fourth pyramid 171a on the substrate 100 may be a regular quadrilateral, or may be an irregular polygon. It should be noted that, the bottom surfaces of all fourth pyramids 171a included in the stepped surface 171 may be in different planes, but more than half of the number of fourth pyramids 171a have bottom surfaces that are nearly in the same plane, which may serve as the reference plane of the stepped surface 171. The bottom surface of the first pyramid 131a is a plane where the base of the first pyramid 131a is located. The orthographic projection pattern of the base of the first pyramid 131a on the substrate 100 may be a regular quadrilateral, or may be an irregular polygon. It should be noted that, the bottom surfaces of all first pyramids 131a included in the bottom surface 131 may be in different planes, but more than half of the number of first pyramids 131a have bottom surfaces that are nearly in the same plane, which may serve as the reference plane of the bottom surface 131.

Moreover, in practical applications, the substrate located in the second region may be designed to include (N+1) inclined surfaces and N stepped surfaces each connecting adjacent inclined surfaces. N may be other positive integers besides 1. For example, N may be 2, 3, or 4, etc.

In some cases, referring to FIG. 20, the first region 111 is provided as a third textured surface including a plurality of third pyramids 111a, the bottom surfaces of all third pyramids 111a included in the first region 111 may be in different planes, but more than half of the number of third pyramids 111a have bottom surfaces that are nearly in the same plane, which may serve as a reference plane of the first region 111, i.e. the third reference plane. Based on this, the first distance H5 is the distance between the fourth reference plane where the stepped surface 171 is located and the third reference plane where the first region 111 is located.

It should be noted that the fourth reference plane of the stepped surface 171 and the second reference plane of the bottom surface 131 are illustrated in FIG. 19 or FIG. 20 with dashed lines of higher density, and the third reference surface of the first region 111 is illustrated in FIG. 20 with dashed lines of higher density.

In some examples, referring to FIG. 19 or FIG. 20, along the second direction Y, the ratio of the first distance H5 to the second distance H6 may be 0.7, 0.8, 0.9, 1, 1.1, or 1.2, etc.

In some examples, along the second direction Y, the first distance H5 between the stepped surface 171 and the first region 111 ranges from 5 µm to 7 µm. For example, it may be 5.1 µm, 5.2 µm, 5.3 µm, 5.4 µm, 5.5 µm, 5.6 µm, 5.7 µm, 5.8 µm, 5.9 µm, 6 µm, 6.1 µm, 6.2 µm, 6.3 µm, 6.4 µm, 6.5 µm, 6.6 µm, 6.7 µm, 6.8 µm, or 6.9 µm, etc.

In some examples, along the second direction Y, the second distance H6 between the stepped surface 171 and the bottom surface 131 ranges from 5.5 µm to 7.5 µm. For example, it may be 5.6 µm, 5.7 µm, 5.8 µm, 5.9 µm, 6 µm, 6.1 µm, 6.2 µm, 6.3 µm, 6.4 µm, 6.5 µm, 6.6 µm, 6.7 µm, 6.8 µm, 6.9 µm, 7 µm, 7.1 µm, 7.2 µm, 7.3 µm, or 7.4 µm, etc.

In some embodiments, referring to FIG. 19, or FIG. 20, an inclination angle β of the inclined surface 161 inclined towards the second region 121 close to the first region 111 ranges from 40° to 55°. For example, the inclination angle β may be 40.5°, 41°, 41.5°, 42°, 42.5°, 43°, 43.5°, 44°, 44.5°, 45°, 45.5°, 46°, 46.5°, 47°, 47.5°, 48°, 48.5°, 49°, 49.5°, 50°, 50.5°, 51°, 51.5°, 52°, 52.5°, 53°, 53.5°, 54° or 54.5°, etc. It should be noted that the inclination angles β of different inclined surfaces 161 inclined toward the first region 111 may be either identical or exhibit slight variations. However, the numerical range of the inclination angle β for any inclined surface 161 inclined toward the first region 111 may be set within 40° to 55°.

It should be noted that, designing the inclination angle β of the inclined surface 161 inclined toward the first region 111 within 40° to 55° can avoid excessive steepness of the inclined surface 161. As a transition region between the bottom surface 131 and the first region 111, the inclined surface 161 reduces abrupt height variations between adjacent regions of the slope along the first direction X. In other words, with the second surface 102 as the reference plane, this design minimizes height differences between adjacent regions along the first direction X across the inclined surface 161, enabling a gradual morphological transition from the elevated first region 111 to the lower bottom surface 131 on the first surface 101. This smooth transition is beneficial to achieving uniform film thickness (e.g., passivation layers) on the first surface 101, thereby enhancing passivation effectiveness.

Furthermore, if the inclination angle β of the inclined surface 161 inclined toward the first region 111 is set to be less than 40°, compared with the inclination angle β greater than or equal to 40°, in the case of the surface area of the inclined surface 161 remaining unchanged, the size of the transition region 122 in the first direction X is increased, and thus the number of the first regions 111 that can be laid out on the entire first surface 101 is reduced. Therefore, designing an inclination angle β of the inclined surface 161 inclined toward the first region 111 to be greater than or equal to 40° is beneficial to ensure that the inclined surface 161 has a certain surface area, while at the same time decreasing the size of the inclined surface 161 as a whole in the first direction X, i.e., decreasing the proportion of the transition region 122 that is occupied by the transition region 122 across the entire first surface 101.

It should be noted that with reference to FIG. 19, or FIG. 20, the plane on which a majority number of the bottom surfaces of first pyramids 131a included in the bottom surface 131 lie is used as the reference surface of the bottom surface 131. Based on this, the inclination angle β of the inclined surface 161 inclined towards the first region 111 refers to an acute angle formed between the reference plane of the inclined surface 161 and the reference plane of the bottom surface 131.

In some embodiments, referring to FIG. 20, the first region 111 is provided as the third textured surface including the plurality of third pyramids 111a. The dimensional relationships among the first pyramids 131a, the fourth pyramids 171a, and the third pyramids 111a will be described in detail below.

In some cases, referring to FIG. 20, a base size of the third pyramid 111a is greater than a base size of the fourth pyramid 171a and smaller than a base size of the first pyramid 131a. That is, the fourth pyramid 171a has the smallest base size, and the first pyramids 131a has the largest base size.

In some examples, the base size of the third pyramid 111a may range from 1 µm to 2 µm, and for example, may be 1.1 µm, 1.2 µm, 1.3 µm, 1.4 µm, 1.5 µm, 1.6 µm, 1.7 µm, 1.8 µm, or1.9µm, etc. The base size of the fourth pyramid 171a may range from 0.5 µm to 1.5 µm, and the base size of the first pyramid 131a may range from 2 µm to 3 µm.

In some cases, referring to FIG. 20, the height of the third pyramid 111a is greater than the height of the fourth pyramid171a and less than the height of the first pyramid 131a. That is, the fourth pyramid 171a has the smallest height, and the first pyramids 131a has the maximum height.

In some examples, the height of the third pyramid 111a ranges from 1.5 µm to 2.5 µm, and for example, may be 1.6 µm, 1.7 µm, 1.8 µm, 1.9 µm, 2 µm, 2.1 µm, 2.2 µm, 2.3 µm, or 2.4 µm, etc. The height of the fourth pyramid 171a ranges from 0.5 µm to 1.5 µm, and the height of the first pyramid 131a ranges from 2 µm to 3 µm.

In some cases, referring to FIG. 20, the reflectivity of the third textured surface is greater than the reflectivity of the second textured surface and less than the reflectivity of the first textured surface. That is, the stepped surface 171 has the smallest reflectivity, and the bottom surface 131 has the maximum reflectivity.

In some examples, the reflectivity of the third textured surface of the first region 111 ranges from 10.5 to 11.5, and for example, may be 10.6, 10.7, 10.8, 10.9, 11, 11.1, 11.2, 11.3, or 11.4, etc. The reflectivity of the stepped surface 171 ranges from 10 to 11, and the reflectivity of the bottom surface 131 ranges from 12 to 13.

It should be noted that for the first surface 101, the above three examples may exist simultaneously, or one of them may be selected, or two of them may be selected.

In some embodiments, referring to FIG. 20, vertex angles of the first pyramid 131a, the fourth pyramid 171a and the third pyramid 111a may be in a range of 65° to 80°, and for example, may be 66°, 67°, 68°, 69°, 70°, 71°, 72°, 73°, 74°, 75°, 76°, 77°, 78°, or 79°, etc. In this way, it is advantageous to capture incident light more efficiently with the aid of a pyramid with a smaller vertex angle, for example, so that light from a greater number of incident angles can all be reflected into the first face 101 to increase the total amount of light entering the first face 101.

It should be noted that the angle formed by the two lateral edges set opposite each other in the pyramid may be regarded as the vertex angle of the pyramid.

In some embodiments, referring to FIG. 22, FIG. 22 is a schematic diagram illustrating a seventh partial cross-sectional view of a photovoltaic cell according to an embodiment of the present disclosure, the photovoltaic cell further includes a first protective layer 103 covering the bottom surface 131, the inclined surfaces 161 and the stepped surfaces 171.

In some cases, the first protective layer 103 may conformally cover the bottom surface 131, the inclined surfaces 161 and the stepped surfaces 171, then the surface morphology of the portion of the first protective layer 103 aligned with the bottom surface 131 also exhibits a textured morphology like the bottom surface 131, and the surface morphology of the portion of the first protective layer 103 aligned with the stepped surfaces 171 also exhibits a textured morphology like the stepped surfaces 171. It should be noted that with reference to FIG. 19 to FIG. 22, on one hand, the first protective layer 103 is conducive to protecting the morphology of the first pyramids 131a and the fourth pyramids 171a, for example, when other film layers are subsequently formed on the second regions 121 and patterning is carried out, the first protective layer 103 can be used as an etching barrier layer, so as to avoid damage to the first pyramids 131a and the fourth pyramids 171a by the patterning process, thereby favorably ensuring that the second regions 121 have relatively lower reflectivity.

On the other hand, the first protective layer 103 facilitates the enhancement of the optical properties of the second regions 121 to further reduce the reflection loss of the second regions 121, for example, to reduce the reflectivity of the photovoltaic cell as a whole disposed on the surface of the second regions 121 to ultimately enhance the absorption and utilization rate of the second regions 121 for light, thereby enhancing the photoelectric conversion efficiency of the photovoltaic cell.

In some cases, after the first protective layer 103 is formed by an oxygen-free high-temperature process, the reflectivity of the overall surface of the photovoltaic cell located in the second regions 121 can be reduced by about 0.1 to 0.3 on the original basis. In other cases, after the first protective layer 103 is formed by an oxygen-containing high-temperature process, the reflectivity of the overall surface of the photovoltaic cell located in the second regions 121 can be reduced by about 0.5 to 1 on the original basis. In still other cases, after the first protective layer 103 is formed by an in-situ doped oxidation process, the reflectivity of the overall surface of the photovoltaic cell located in the second regions 121 can be reduced by about 0.5 to 1 on the original basis. The oxygen-free high-temperature process, the oxygen-containing high-temperature process, and the in-situ doped oxidation process will be described in detail later.

In some embodiments, referring to FIG. 22, the first protective layer 103 may be made from a semiconductor material doped with a doping element, silicon oxide, phosphosilicate glass, or borosilicate glass.

In some cases, the semiconductor material included in the first protective layer 103 is an elemental semiconductor material. Specifically, the elemental semiconductor material is composed of a single element. For example, it may be silicon or germanium. The elemental semiconductor material may be in a single crystal state, a polycrystalline state, an amorphous state, or a microcrystalline state (a state having both a single crystal state and an amorphous state is referred to as a microcrystalline state). For example, silicon may be at least one of single crystal silicon, polycrystalline silicon, amorphous silicon, or microcrystalline silicon. In other cases, the semiconductor material included in the first protective layer 103 is a compound semiconductor material. Common compound semiconductor materials include, but are not limited to, silicon germanide, silicon carbide, gallium arsenide, indium gallide, perovskite, cadmium telluride, or copper indium selenide and other materials.

In some cases, the doping element included in the first protective layer 103 may be an N-type doping element or a P-type doping element. The N-type doping element may be at least one of group V elements such as phosphorus (P), bismuth (Bi), antimony (Sb), or arsenic (As). The P-type doping element may be at least one of group III elements such as boron (B), aluminum (Al), gallium (Ga), or indium (In).

In some embodiments, the substrate 100 may be made from an elemental semiconductor material or a compound semiconductor material.

In some cases, the substrate 100 may be an N-type semiconductor substrate doped with an N-type doping element. In some other cases, the substrate 100 may be a P-type semiconductor substrate doped with a P-type doping element.

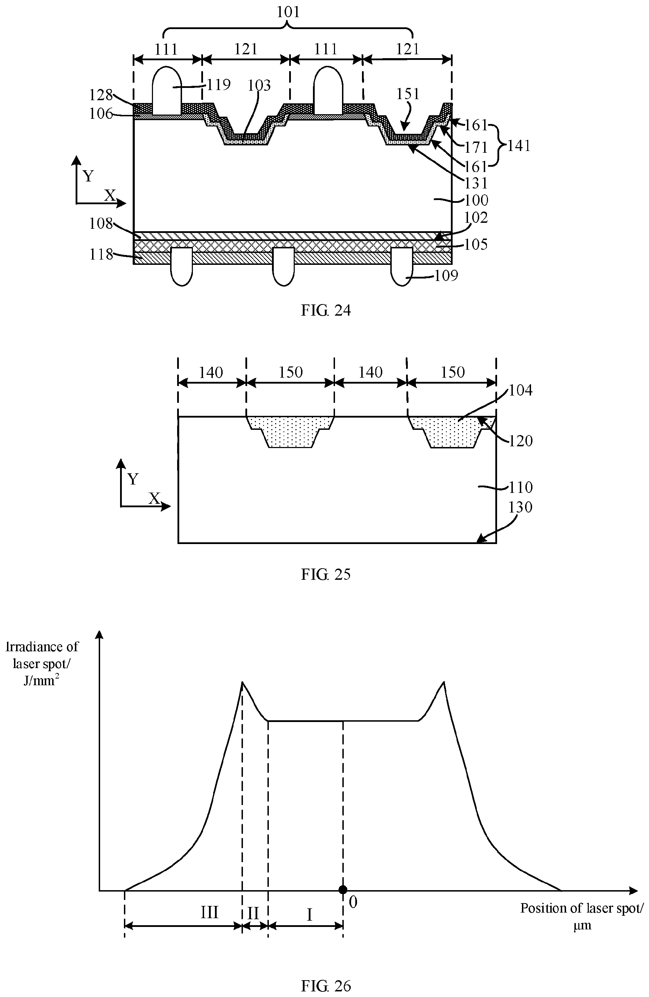

In some embodiments, referring to FIG. 23 and FIG. 24, FIG. 23 is a schematic diagram illustrating an eighth partial cross-sectional view of a photovoltaic cell according to an embodiment of the present disclosure, and FIG. 24 is a schematic diagram illustrating a ninth partial cross-sectional view of a photovoltaic cell according to an embodiment of the present disclosure. The photovoltaic cell further includes: a tunneling layer 108 located on the second surface 102, a first doped semiconductor layer 105 doped with a first doping element and located on a side of the tunneling layer 108 away from the second surface 102, and a second doped semiconductor layer 106 doped with a second doping element and located on the first regions 111. A conductivity type of the first doping element is different from a conductivity type of the second doping element. The photovoltaic cell further includes a first passivation layer 118 located on a side of the first doped semiconductor layer 105 away from the tunneling layer 108, a second passivation layer 128 located on a side of the second doped semiconductor layer 106 away from the substrate 100 and located on the second regions 121, first electrodes 109 in ohmic contact with the first doped semiconductor layer 105, and second electrodes 119 embedded in the second passivation layer 128 and in ohmic contact with the second doped semiconductor layer 106.

It should be noted that the second doped semiconductor layer 106, as a selective emitter structure on the first surface 101, is beneficial to ensuring that the second electrodes 119 have a good current collection efficiency based on the second doped semiconductor layer 106, avoiding the second regions 121 from being covering by the second doped semiconductor layer 106, avoiding the parasitic absorption by the second doped semiconductor layer 106 of the light incident to the second regions 121, thereby enhancing the utilization of the incident light by the first surface 101 to improve the photovoltaic conversion efficiency of the photovoltaic cell.

In addition, the tunneling layer 108 and the first doped semiconductor layer 105 jointly form a passivated contact structure. The tunneling layer 108 chemically passivates the second surface 102, saturates the dangling bonds of the second face 102, reduces the defect state density of the second face 102, reduces the recombination probability of carriers on the second face 102, thereby improving the photoelectric conversion efficiency of the photovoltaic cell. In addition, the first passivation layer 118 can further passivate the second surface 102 and serve as an optical optimization layer for the second surface 102 to improve the absorption and utilization rate of the second surface 102 for light. The second passivation layer 128 can passivate the first surface 101 to reduce the defect state density of the first surface 101, and serve as an optical optimization layer for the first surface 101 to improve the absorption and utilization rate of the first surface 101 for light.

In some cases, the second doped semiconductor layer 106 doped with the second doping element is formed in an initial state of the substrate 100. In other words, there is no obvious boundary line between the second doped semiconductor layer 106 and the substrate 100 located in the first regions 111. In FIG. 23, for the convenience of description, different filling methods are used to draw the substrate 100 and the second doped semiconductor layer 106. On this basis, the slope 141 of the groove 151 formed by the substrate 100 located in the second region 121 recessed towards the second surface 102 may be regarded as being jointly formed by the second doped semiconductor layer 106 and the substrate 100 located in the first region 111.

In some cases, the tunneling layer 108 may be made from at least one of silicon oxide, silicon nitride, silicon oxynitride, silicon carbide, or magnesium fluoride, and the first doped semiconductor layer 105 may be made from at least one of amorphous silicon, polycrystalline silicon, or silicon carbide. Both the first doped semiconductor layer 105 and the substrate 100 may be doped with the first doping element.

In some cases, both the second passivation layer 128 and the first passivation layer 118 may be either a single-layer structure or a stacked-layer structure. In addition, the materials of both the second passivation layer 128 and the first passivation layer 118 may include at least one of aluminum oxide, silicon oxide, silicon nitride, or silicon oxynitride.

In some cases, the substrate 100 may be an N-type semiconductor substrate doped with an N-type doping element, the first doping element doped in the first doped semiconductor layer 105 is an N-type doping element, and the second doping element doped in the second doped semiconductor layer 106 is a P-type doping element. In some other cases, the substrate 100 may be a P-type semiconductor substrate doped with a P-type doping element, the first doping element doped in the first doped semiconductor layer 105 is a P-type doping element, and the second doping element doped in the second doped semiconductor layer 106 is an N-type doping element.

In summary, an individual groove 151 includes at least two inclined surfaces 161 and at least one stepped surface 171, and may be regarded as a multi-layer stepped structure. A surface jointly formed by a plurality of inclined surfaces 161 and the stepped surface 171 connecting two adjacent inclined surfaces 161 in the same groove 151 is taken as the slope 141. On one hand, it is beneficial to forming a stepped light propagation path in the groove 151 with the help of the slope 141, so that the light incident on the groove 151 can be reflected multiple times between the inclined surfaces 161 and the stepped surface 171, and finally be absorbed and utilized by the second region 121. On the other hand, the stepped light propagation path is beneficial to extending the optical path, so as to improve the absorption and utilization rate of the slope 141 for long-wavelength light, such as infrared light. On the other hand, compared with the first pyramids 131a included in the bottom surface 131, both the base size and the height of the fourth pyramids 171a are smaller. Firstly, it is beneficial to more uniformly distributing the light incident on the slope 141 with the help of the smaller fourth pyramids 171a, so as to avoid too high or too low local light intensity in the slope 141, improve the overall light absorption and utilization rate of the slope 141, and reduce light escape, thereby further reducing the reflection loss of light on the slope 141. Secondly, it is beneficial to enhancing the scattering of light on the slope 141, so as to improve the absorption rate of the slope 141 for short-wavelength light, such as blue light and ultraviolet light. In this way, through the comprehensive effect of multiple aspects, a multi-level light trapping effect can be achieved macroscopically, and the reflection loss of light on the groove 151 can be reduced microscopically, and more light at different incident angles can be received and utilized from the macro to the micro level, so as to improve the light trapping effect of the second region 121, thereby improving the photoelectric conversion efficiency of the photovoltaic cell.

Moreover, as a transition region between the bottom surface 131 and the first region 111, the slope 141, based on the design of the stepped surface 171, divides the transition region into at least two regions with height differences. On one hand, it is beneficial to improving the overall flatness of the second regions 121, which is beneficial to forming a film layer with a uniform thickness on the first surface 101 subsequently. In addition, both the stepped surface 171 and the transition with multiple levels of small height differences can relieve the degree of stress concentration during film deposition, thereby reducing the risk of film cracking or peeling. On the other hand, it is beneficial for the photo-generated carriers in the second region 121 to quickly migrate to the nearest first region 111, and reducing the lateral transmission distance of the photo-generated carriers, so as to reduce the recombination probability of the photo-generated carriers. On the other hand, the stepped surface 171 can avoid too high or too low local light intensity in the slope 141, and the slope 141 as a whole can disperse the density of the photo-generated carriers, so as to avoid an excessive density of the photo-generated carriers near the electrode located in the first region 111, thereby reducing the risk of the local hot spot effect occurring in the photovoltaic cell.

The embodiments of the present disclosure further provide a method for manufacturing a photovoltaic cell, which is configured to form the photovoltaic cell provided in the foregoing embodiments. The method for manufacturing the photovoltaic cell will be described in detail below with reference to the accompanying drawings. FIG. 10, FIG. 25 to FIG. 28, FIG. 15 are schematic diagrams of the partial cross-sectional structures corresponding to each operation in the method for manufacturing the photovoltaic cell. It should be noted that the same or corresponding parts as those in the foregoing embodiments will not be described in detail herein.

With reference to FIG. 10, FIG. 25 to FIG. 28, FIG. 15, and with reference to FIG. 18 to FIG. 21, the method for manufacturing the photovoltaic cell may at least include the following operations.

S1: Referring to FIG. 10, an initial substrate 110 is provided, where the initial substrate 110 has an initial first surface 120 and an initial second surface 130 opposite to each other. The initial first surface 120 has initial first regions 140 and initial second regions 150 that are alternately arranged along the first direction X.

It should be noted that the initial first surface 120 corresponds to the subsequently formed first surface, the initial first regions 140 correspond to the first regions of the subsequently formed first surface, the initial second regions 150 correspond to the second regions of the subsequently formed first surface, and the initial second surface 130 corresponds to the subsequently formed second surface.

S2: Referring to FIG. 10, FIG. 25 to FIG. 26, the initial second regions 150 is irradiated using a laser spot with a gradual change in energy to transform a portion of the thickness of the initial substrate 110, which is disposed in the initial second regions 150, into a damage layer 104, and the change in the energy of the laser spot in a direction of the center of the laser spot pointing toward the edge includes at least a first stage I, a second stage II, and a third stage III in a sequential manner, with the energy of the laser spot in the first stage I being at a first preset value, the energy of the laser spot gradually increases from the first preset value to a second preset value in the second stage II, and the energy of the laser spot gradually decreases from the second preset value to zero in the third stage III. In other words, in the direction of the center of the laser spot pointing towards the edge, the energy of the laser spot first remains unchanged, then gradually increases, and finally gradually decreases to zero.

It should be noted that FIG. 25 is a schematic diagram illustrating a partial cross-sectional of a damage layer formed in a method for manufacturing a photovoltaic cell according to another embodiment of the present disclosure, and FIG. 26 is another curve diagram corresponding to an energy gradient of a laser spot in a method for manufacturing a photovoltaic cell according to another embodiment of the present disclosure. In addition, the center of the laser spot is taken as point 0 in FIG. 26.

S3: Referring to FIG. 25 and FIG. 18 to FIG. 21, each initial second region 150 is subjected to a first textured process to at least remove the damage layer 104 and to form a groove 151 in the initial second region 150, with the remaining initial substrate 110 being the substrate 100, the initial first region 140 transformed into the first region 111 of the substrate 100, and the initial second region 150 transformed into the second region 121 of the substrate 100, and the substrate 100 including a bottom surface 131 recessed toward inside of the substrate 100 in the second region 121, and at least two inclined surfaces 161 connecting the bottom surface 131 and the first region 111, the stepped surface 171 connecting adjacent inclined surfaces 161, and the bottom surface 131, the at least two inclined surfaces 161 and the stepped surface 171 jointly forming the groove 151, the inclined surfaces 161 inclined towards the first region 111.

The bottom surface 131 is provided as a first textured surface including a plurality of first pyramids 131a, and the stepped surface 171 is provided as a second textured surface including a plurality of fourth pyramids 171a. A base size of the first pyramid 131a is greater than a base size of the fourth pyramid 171a, and a height of the first pyramid 131a is greater than a height of the fourth pyramid 171a.

It should be noted that during the process of irradiating the initial second regions 150 using the laser spot with gradual change in energy in operation S2, only the damage layer 104 is formed in the initial second region 150, and a stepped structure with a height difference is not be formed between the initial first region 140 and the initial second region 150. On this basis, in operation S3, by means of the difference in etching rates of the damage layer 104 in the initial second region 150 and the initial first region 140 during the first texturing treatment, the initial second region 150 is transformed into the second region 121 with the groove 151.

Further, based on the design in operation S2 that along the direction from the center to the edge of the laser spot, the energy of the laser spot remains unchanged first, then gradually increases, and finally gradually decreases to zero, which is beneficial to forming the damage layer with different thickness in different regions in operation S2. Generally speaking, the portion of the initial substrate 110 irradiated by the portion with greater energy in the laser spot has a greater degree of damage caused by the laser, and the formed damage layer 104 has a greater thickness or the interior is more completely destroyed. For example, in a direction along the center of the initial second region 150 pointing toward the initial first region 140, the thickness of the damage layer 104 first remains unchanged, then gradually increases, remains an average value again, gradually increases again, and finally gradually decreases to zero. On this basis, in operation S3, the etching rates of different regions of the damage layer 104 during the first texturing treatment are different, and the durations spent by the first texturing treatment to remove the damage layer 104 with different thicknesses are also different. Therefore, the first texturing treatment exposes the initial substrate 110 covered by different portions of the damage layer 104 at different moments, and further performs a texturing treatment on the remaining initial substrate 110 at different moments. Consequently, it is beneficial to forming the groove 151 jointly surrounded by the bottom surface 131, the inclined surfaces 161 and the stepped surface 171, and form different textured surface structures on the bottom surface 131 and the stepped surface 171. Specifically, a bottom surface 131 is provided as a first textured surface including a plurality of first pyramids 131a, and a stepped surface 171 is provided as a second textured surface including a plurality of fourth pyramids 171a.

In other words, under the joint cooperation of irradiating the initial second region 150 using the laser spot with gradual change in energy in operation S2 and the first texturing treatment in operation S3, the turning points of the etching rates of different regions of the film layer jointly formed by the damage layer 104 and the remaining initial substrate 110 during the first texturing treatment are different along the direction from the center of the initial second region 150 to the initial first region 140. Further, the average etching rate of the first texturing treatment on different regions of the film layer including the damage layer 104 and the remaining initial substrate 110 together is further made to be gradual change, for example, to remain unchanged, then gradually decreased, remain unchanged again, finally thereby gradually decreased to zero, favoring the eventual formation of a groove 151 with multiple-layer stepped structure.

In some embodiments, referring to FIG. 26, and FIG. 19 or FIG. 20, the position with the maximum energy of the laser spot, that is, the second preset value, irradiates the bottom surface 131 of the groove 151, and irradiates the region of the bottom surface 131 close to the inclined surfaces 161. It should be noted that the energy of a single laser spot reaches the second preset value in two different regions, and the two second preset values irradiate the regions of the bottom surface 131 close to two different inclined surfaces 161 respectively.

In some cases, along the first direction X, an irradiation position of the bottom surface 131 corresponding to the second preset value and a junction of the inclined surface 161 and the bottom surface 131 are spaced apart by a preset distance D, and a ratio of the preset distance D to the first length L1 of the bottom surface 131 ranges from 0.0025 to 0.05. For example, the ratio may be 0.003, 0.004, 0.005, 0.006, 0.007, 0.008, 0.009, 0.01, 0.015, 0.02, 0.025, 0.03, 0.035, 0.04, or 0.045, etc.

It should be noted that the first length L1 of the bottom surface 131 is formed by multiple laser lines opening the film, and the surface area of the groove 151 is mainly determined by the first length L1 of the bottom surface 131. The value range of the first length L1 is relatively large. Based on this, the value range of the ratio of the preset distance D to the first length L1 of the bottom surface 131 is also relatively large. However, compared with the first length L1 of the bottom surface 131, the preset distance D between the irradiation position of the bottom surface 131 corresponding to the second preset value and the junction of the slope 141 and the bottom surface 131 is relatively small. In other words, the position irradiated by the turning point of the energy decrease of the laser spot is very close to the finally formed inclined surface 161.

In some examples, the preset distance D between the irradiation position of the bottom surface 131 corresponding to the second preset value and the junction of the inclined surface 161 and the bottom surface 131 ranges from 5 µm to 10 µm. For example, the preset distance D may be 5.2 µm, 5.5 µm, 5.8 µm, 6 µm, 6.3 µm, 6.5 µm, 6.6 µm, 6.8 µm, 7 µm, 7.3 µm, 7.5 µm, 7.7 µm, 8 µm, 8.2 µm, 8.5 µm, 8.8 µm, 9 µm, 9.3 µm, or 9.5 µm, etc.

In some examples, an overall size of the laser spot ranges from 50 µm to 200 µm. In other words, a diameter of the laser spot ranges from 50 µm to 200 µm. For example, the diameter of the laser spot may be 60 µm, 70 µm, 80 µm, 90 µm, 100 µm, 110 µm, 120 µm, 130 µm, 140 µm, 150 µm, 160 µm, 170 µm, 180 µm, or 190 µm, etc.

In some examples, the first texturing treatment exposes the initial substrate 110 covered by different portions of different regions in the second damage layer at different moments, so as to achieve the texturing treatment of some regions of the remaining initial substrate 110 at different moments. Therefore, it is beneficial to forming the groove 151 jointly surrounded by the bottom surface 131, the inclined surfaces 161 and the stepped surface 171, and forming different textured structures only on the bottom surface 131 and the stepped surface 171.

In some examples, referring to FIG. 25 and FIG. 26, a single laser spot is divided into two symmetrical portions along the center. Along the first direction X, a width of the irradiation region of either of the two portions of the laser spot corresponding to the first stage I on the initial second region 150 ranges from 20 µm to 50 µm, for example, may be 21 µm, 22 µm, 23 µm, 24 µm, 25 µm, 26 µm, 27 µm, 28 µm, 29 µm, 30 µm, 31 µm, 32 µm, 33 µm, 34 µm, 35 µm, 36 µm, 37 µm, 38 µm, 39 µm, 40 µm, 41 µm, 42 µm, 43 µm, 44 µm, 45 µm, 46 µm, 47 µm, 4 8µm, or 49 µm, etc. A width of the irradiation region of either of the two portions of the laser spot corresponding to the second stage II on the initial second region 150 ranges from 5 µm to 10 µm, for example, may be 5.2 µm, 5.5 µm, 5.6 µm, 5.8 µm, 6 µm, 6.2 µm, 6.5 µm, 6.6 µm, 7 µm, 7.2 µm, 7.5 µm, 7.8 µm, 8 µm, 8.2 µm, 8.5 µm, 8.8 µm, 9.2 µm, 9.5 µm, or 9.8 µm, etc. A width of the irradiation region of either of the two portions of the laser spot corresponding to the third stage III on the initial second region 150 ranges from 10 µm to 25 µm, for example, may be 11 µm, 12 µm, 13 µm, 14 µm, 15 µm, 16 µm, 17 µm, 18 µm, 19 µm, 20 µm, 21 µm, 22 µm, 23 µm, or 24 µm, etc.

It should be noted that designing the width of the irradiation region of the laser spot corresponding to the second stage II on the initial second region 150 to range from 5 µm to 10 µm, and designing the width of the irradiation region of the laser spot corresponding to the third stage III on the initial second region 150 to range from 10 µm to 25 µm, are beneficial to increasing the overall length of the transition region 122 along the first direction X, facilitating the formation of the stepped surface 171 on the transition region 122, and ensuring that the stepped surface 171 has enough surface area to arrange the fourth pyramids 171a.

In some embodiments, referring to FIG. 26, the energy of the laser spot in the laser treatment is the irradiance of the laser spot, along the direction from the center to the edge of the laser spot, the irradiance of the laser spot is increased by 0.008 J/mm² to 0.038 J/mm² per 1 µm distance in the second stage II, and the irradiance of the laser spot is decreased by 0.004 J/mm² to 0.02 J/mm² per 1 µm distance in the third stage III.

It should be noted that designing the growth rate of the irradiance of the laser spot in the second stage II to be greater than the decrease rate of the irradiance of the laser spot in the third stage III, is beneficial to finally forming the bottom surface 131 with relatively longer length in the first direction X, and forming the slope 141 with relatively less steepness. Further, designing both the growth rate of the irradiance of the laser spot in the second stage II and the decrease rate of the irradiance of the laser spot in the third stage III to be relatively small is beneficial to finally forming the stepped surface 171 between the adjacent inclined surfaces 161 while forming the inclined surfaces 161, and facilitating the first texturing treatment to form the textured surface only on the bottom surface 131 and the stepped surface 171.

In some examples, along the direction from the center to the edge of the laser spot, the amount of the irradiance of the laser spot increased per 1 µm distance in the second stage II may be 0.009 J/mm², 0.01 J/mm², 0.011 J/mm², 0.012 J/mm², 0.013 J/mm², 0.014 J/mm², 0.015 J/mm², 0.016 J/mm², 0.017 J/mm², 0.018 J/mm², 0.019 J/mm², 0.02 J/mm², 0.021 J/mm², 0.022 J/mm², 0.023 J/mm², 0.024 J/mm², 0.025 J/mm², 0.026 J/mm², 0.027 J/mm², 0.028 J/mm², 0.029 J/mm², 0.03 J/mm², 0.031 J/mm², 0.032 J/mm², 0.033 J/mm², 0.034 J/mm², 0.035 J/mm², 0.036 J/mm², or 0.037 J/mm², etc.

In some examples, along the direction from the center to the edge of the laser spot, the amount of the irradiance of the laser spot decreased per 1 µm distance in the third stage III may be 0.005 J/mm², 0.006 J/mm², 0.007 J/mm², 0.008 J/mm², 0.009 J/mm², 0.01 J/mm², 0.011 J/mm², 0.012 J/mm², 0.013 J/mm², 0.014 J/mm², 0.015 J/mm², 0.016 J/mm², 0.017 J/mm², 0.018 J/mm², or 0.019 J/mm², etc.

In some embodiments, referring to FIG. 26, the first preset value may be in a range of 0.01 J/mm² to 0.02 J/mm², and for example, may be 0.011 J/mm², 0.012 J/mm², 0.013 J/mm², 0.014 J/mm², 0.015 J/mm², 0.016 J/mm², 0.017 J/mm², 0.018 J/mm², or 0.019 J/mm², etc. The second preset value may be in a range of 0.1 J/mm² to 0.2 J/mm², and for example, may be 0.11 J/mm², 0.12 J/mm², 0.13 J/mm², 0.14 J/mm², 0.15 J/mm², 0.16 J/mm², 0.17 J/mm², 0.18 J/mm², or 0.19 J/mm², etc.

In some examples, irradiating the initial substrate 110 with the laser spot shown in FIG. 26 is beneficial to forming the second damage layer with thickness remaining unchanged first, then gradually increasing, remaining at an average value again, gradually increasing again, and finally gradually decreasing to zero along the direction from the center of the initial second region 150 to the initial first region 140.

In some embodiments, referring to FIG. 25, FIG. 18 to FIG.21, the first etching solution used in the first texturing treatment may include potassium hydroxide and water, and a ratio of potassium hydroxide to water ranges from 0.002:1 to 0.01:1. For example, the ratio may be 0.003, 0.004, 0.005, 0.006, 0.007, 0.008, or 0.009, etc.

In some embodiments, a treatment duration of the first texturing treatment ranges from 200 s to 300 s, and for example, may be 205s, 210s, 215s, 220s, 225s, 230s, 235s, 240s, 245s, 250s, 255s, 260s, 265s, 270s, 275s, 280s, 285s, 290s, or 295s, etc.

In some embodiments, the process temperature of the first texturing treatment can be 65°C to 75°C, and for example, may be 66°C, 67°C, 68°C, 69°C, 70°C, 71°C, 72°C, 73°C, or 74°C, etc.

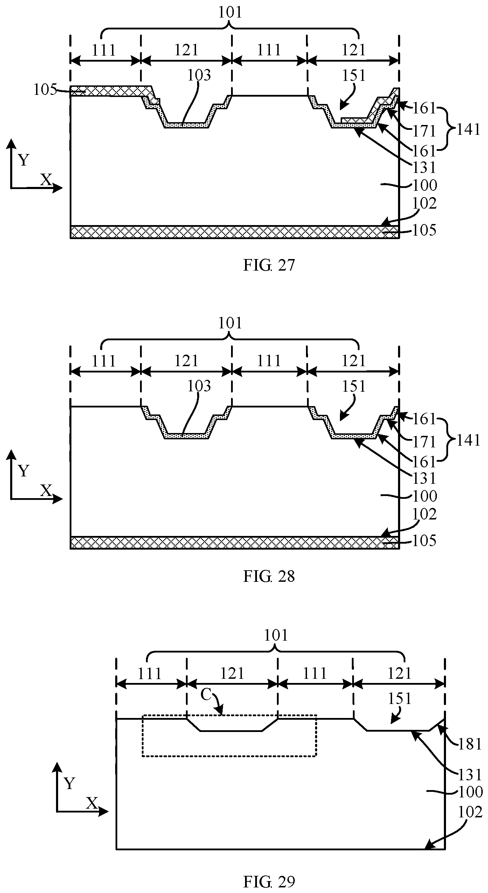

In some embodiments, with reference to FIG. 18, FIG. 22, FIG. 27 and FIG. 28, the method for manufacturing the photovoltaic cell further includes:
referring to FIG. 18 and FIG. 22, performing a high-temperature treatment or a high-temperature doping treatment on the grooves 151 to form a first protective layer 103 to cover the bottom surface 131, the inclined surfaces 161 and the stepped surface 171,
referring to FIG. 22 and FIG. 27, forming a first doped semiconductor layer 105 on the second surface 102, where the first doped semiconductor layer 105 is also located on a portion of the first surface 101, and
referring to FIG. 27 and FIG. 28, performing an etching process on the first doped semiconductor layer 105 located on the first surface 101 with the first protective layer 103 as an etching barrier layer.

FIG. 27 is a schematic diagram illustrating a partial cross-sectional view of forming a first doped semiconductor layer on a structure shown in FIG. 22. FIG. 28 is a schematic diagram illustrating a partial cross-sectional view of performing an etching process on a structure shown in FIG. 27.

It should be noted that during the process of forming the first doped semiconductor layer 105 on the second surface 102, there may be a wrapping plating phenomenon, so the first doped semiconductor layer 105 may also be formed on some regions of the first surface 101. Subsequently, an etching process needs to be performed on the first doped semiconductor layer 105 located on the first surface 101. During the etching process, the first protective layer 103 may be used as an etching barrier layer to avoid the damage to the surface of the first pyramids 131a and the fourth pyramids 171a caused by the etching process, thereby being beneficial to ensuring that the second region 121 has a relatively low reflectivity. In addition, the first protective layer 103 is beneficial to improving the optical performance of the second region 121 to further reduce the reflection loss of the second region 121. For example, the first protective layer 103 can reduce the reflectivity of the overall surface of the photovoltaic cell located in the second regions 121 to improve the absorption and utilization rate of the second region 121 of the first surface 101 for light, thereby improving the photoelectric conversion efficiency of the photovoltaic cell.

In some cases, the process temperature of the high-temperature treatment or the high-temperature doping treatment ranges from 900°C to 1050°C, and the treatment duration ranges from 2000 s to 5000 s.

In some examples, the process temperature of the high-temperature treatment or the high-temperature doping treatment may be 910°C, 920°C, 930°C, 940°C, 950°C, 960°C, 970°C, 980°C, 990°C, 1000°C, 1010°C, 1020°C, 1030°C, or 1040°C, etc.

In some examples, the treatment duration of the high-temperature treatment or the high-temperature doping treatment may be 2100 s, 2200 s, 2300 s, 2400 s, 2500 s, 2600 s, 2700 s, 2800 s, 2900 s, 3000 s, 3100 s, 3200 s, 3300 s, 3400 s, 3500 s, 3600 s, 3700 s, 3800 s, 3900 s, 4000 s, 4100 s, 4200 s, 4300 s, 4400 s, 4500 s, 4600 s, 4700 s, 4800 s, or 4900 s, etc.

In some cases, the high-temperature treatment may be an oxygen-free high-temperature process. Directly performing a high-temperature treatment on the groove 151 can transform a portion of the thickness of the substrate 100 corresponding to the groove 151 into the first protective layer 103. In some examples, the substrate 100 is a semiconductor material doped with a doping element. Based on the oxygen-free high-temperature process, it is beneficial to increasing the concentration of the doping element in a portion of the substrate 100 close to the groove 151, thereby forming the first protective layer 103 with a different doping element concentration from the doping element concentration in the remaining substrate 100. The material of the first protective layer 103 is also a semiconductor material including a doped doping element. It should be noted that after the first protective layer 103 is formed by the oxygen-free high-temperature process, the reflectivity of the overall surface of the photovoltaic cell located in the second region 121 can be reduced by about 0.1 to 0.3 on the original basis.

In some other cases, the high-temperature treatment may be an oxygen-containing high-temperature process. When a high-temperature treatment is performed on the groove 151, an oxidation treatment is also performed on the groove 151, which can oxidize a portion of the thickness of the substrate 100 corresponding to the groove 151 to form the first protective layer 103. In some examples, the substrate 100 may include a silicon material, and the first protective layer 103 including silicon oxide is formed based on the oxygen-containing high-temperature process. It should be noted that after the first protective layer 103 is formed by the oxygen-containing high-temperature process, the reflectivity of the overall surface of the photovoltaic cell located in the second region 121 can be reduced by about 0.5 to 1 on the original basis.

In still some other cases, the high-temperature doping treatment may be an in-situ doped oxidation process. When a high-temperature treatment is performed on the groove 151, a doping treatment and an oxidation treatment are also performed on the groove 151, so that a portion of the thickness of the substrate 100 corresponding to the groove 151 is transformed into the first protective layer 103, and the first protective layer 103 includes an oxidized material doped with a doping element. In some examples, the substrate 100 may include a silicon material, and the first protective layer 103 including phosphosilicate glass or borosilicate glass is formed based on the in-situ doped oxidation process.

It should be noted that after the first protective layer 103 is formed by the in-situ doped oxidation process, the reflectivity of the overall surface of the photovoltaic cell located in the second region 121 can be reduced by about 0.5 to 1 on the original basis. In addition, phosphosilicate glass or borosilicate glass are only two examples of the first protective layer 103 formed based on the in-situ doped oxidation process. In practical applications, the doping source provided in the in-situ doped oxidation process may include other group V elements or other group III elements.

In other embodiments, in the operation of performing high temperature treatment on the groove 151, no additional film layer may be formed, and the high temperature provided by the high temperature treatment only repairs the laser damage to reduce the defect state density on the surface of the groove 151, thereby reducing the recombination center of the carriers at the groove 151, and enhancing the photovoltaic cell photovoltaic conversion efficiency.

In some cases, during the process of forming the first doped semiconductor layer 105, a first dielectric layer (not shown in the drawings) is formed on a side of the first doped semiconductor layer 105 away from the second surface 102. In one example, the substrate 100 is an N-type semiconductor substrate, the first doped semiconductor layer 105 is polysilicon doped with N-type doping elements, and the material of the first dielectric layer may be phosphor-silicon glass.

Based on this, the operation of performing the etching process on the first doped semiconductor layer 105 disposed on the first surface 101 may include: removing the first dielectric layer disposed on the first surface 101 using a chain hydrofluoric acid process, and removing the first doped semiconductor layer 105 uncovered by the first dielectric layer using an alkali polishing process, such that the first doped semiconductor layer 105 disposed on the second surface 102 is retained.

In some cases, referring to FIG. 23, prior to forming the first doped semiconductor layer 105, the manufacturing method may further include: forming a tunneling layer 108 on the second surface 102. Subsequently, the first doped semiconductor layer 105 is formed on a side of the tunneling layer 108 away from the substrate 100. It should be noted that there is no limitation on the process of forming the tunneling layer 108 in the manufacturing method.

In some embodiments, referring to FIG. 10 and FIG. 15, after providing the initial substrate 110 and before irradiating the initial second surface 150 using the laser spot with gradual change in energy, the method for manufacturing the photovoltaic cell may also include: referring to FIG. 10 and FIG. 15, performing a second texturing treatment on the initial first surface 120, so that the initial first surface 120 includes a plurality of third pyramids 111a, continuing to refer to FIG. 15, performing a doping treatment on the initial first surface 120 to transform a portion of a thickness of the initial substrate 110 into the second doped semiconductor layer 106, and forming a second protective layer 107 on a side of the second doped semiconductor layer 106 away from the initial substrate 110. Referring to FIG. 15 and FIG. 20, in the operation of performing the first texturing treatment on the initial second regions 150, the second doped semiconductor layer 106 located in the initial first regions 140 is retained with the second protective layer 107 as an etching barrier layer, and the initial first regions 140 is provided as a third textured surface including a plurality of third pyramids 111a. The base size of the third pyramid 111a is smaller than the base size of the fourth pyramid 171a.

It should be noted that the initial first surface 120 includes a plurality of third pyramids 111a, which is beneficial to subsequently forming the first region 111 as a third textured surface including a plurality of third pyramids 111a. In addition, different texturing treatments are respectively used to form the initial first surface 120 including a plurality of third pyramids 111a and the groove 151.

Moreover, referring to FIG. 15 and FIG. 25, during the process of irradiating the initial second region 150 using the laser spot with gradual change in energy in operation S2, both the second protective layer 107 and the second doped semiconductor layer 106 located on the initial second region 150 are transformed into the damage layer 104. Referring to FIG. 15 and FIG. 20, the second protective layer 107 located on the initial first region 140 that is not irradiated by the laser spot may be used as an etching barrier layer in operation S3 to achieve that only the first region 111 is retained as a third textured surface including a plurality of third pyramids 111a. That is, referring to FIG. 23, the remaining second doped semiconductor layer 106 is only located on the first region 111 to be used as a selective emitter structure on the first surface 101, which is beneficial to reducing the contact resistance between the subsequently formed second electrode and the second doped semiconductor layer 106 and reducing the recombination probability of carrier in other regions of the first surface 101, so as to improve the photoelectric conversion efficiency of the finally formed photovoltaic cell.

In one example, the substrate 100 is an N-type semiconductor substrate, the second doped semiconductor layer 106 is a semiconductor material doped with a P-type doping element, such as a boron diffusion layer, and the material of the second protective layer 107 may be borosilicate glass.

It should be noted that the dimensional relationship between the first pyramid 131a, the fourth pyramid 171a and the third pyramid 111a is the same as in the previous embodiments and will not be repeated herein.

In some cases, referring to FIG. 27 and FIG. 28, after the alkaline polishing process is used to remove the first doped semiconductor layer 105 not covered by the first dielectric layer, to retain the first doped semiconductor layer 105 located on the second surface 102, the manufacturing method may further include: referring to FIG. 15 and FIG. 20, removing the remaining second protective layer 107 located on the initial first regions 140 by using the acid cleaning process. It should be noted that by controlling the process parameters of the acid cleaning process, such as the process duration, the second protective layer 107 is removed and the first protective layer 103 is retained by means of the acid cleaning process, or both the second protective layer 107 and the first protective layer 103 are removed by means of the acid cleaning process.

In some cases, referring to FIG. 23, after forming the first doped semiconductor layer 105 and the second doped semiconductor layer 106, the manufacturing method may further include: forming a first passivation layer 118 located on a side of the first doped semiconductor layer 105 away from the tunneling layer 108, forming a second passivation layer 128 located on a side of the second doped semiconductor layer 106 away from the substrate 100 and on the second regions 121, forming first electrodes 109 in ohmic contact with the first doped semiconductor layer 105, and forming second electrodes 119 embedded in the second passivation layer 128 and in ohmic contact with the second doped semiconductor layer 106.

In some examples, the first passivation layer 118 and the second passivation layer 128 are formed by using an atomic layer deposition process and/or a plasma-enhanced chemical vapor deposition process. It should be noted that the second passivation layer 128 located on the first surface 101 and the first passivation layer 118 on the second surface 102 may be formed synchronously.

In some examples, the operation of forming the first electrodes 109 may include: using a screen printing process to print a metal paste on the surface of a portion of the first passivation layer 118 away from the second surface 102, and performing a sintering process on the metal paste. In some examples, the metal paste includes materials with high corrosiveness such as glass. Thus, during the sintering process, the corrosive components may at least corrode the first passivation layer 118, so that the metal paste penetrates from the first passivation layer 118 to the first doped semiconductor layer 105, thereby forming the first electrodes 109. It should be noted that the operations of forming the second electrodes 119 are similar to those of forming the first electrode 109, and reference may be made to the above description of the operations of forming the first electrodes 109.

In some examples, the metal paste may include at least one of silver, aluminum, copper, tin, gold, lead or nickel.

It should be noted that there is no restriction on the formation process of the first passivation layer 118, the second passivation layer 128, the first electrodes 109, and the second electrodes 119 in the manufacturing method provided in the embodiment of the present disclosure, and different formation processes may be selected according to the needs in practical application.

In summary, based on the design in operation S2 that in the direction along the center of the laser spot pointing to the edge, the energy of the laser spot first remains unchanged, then gradually increases, and finally gradually decreases to zero, which is conducive to making the thickness of the damage layer 104 formed in operation S2 vary at different regions or the degree of the interior being damaged vary. On this basis, in operation S3, the time taken by the first texturing treatment to remove different thicknesses of the damage layer 104 also varies, so that the first texturing treatment may expose the initial substrate 110 covered by different portions of the damage layer 104 at different moments, and the remaining initial substrate 110 is subjected to the texturing treatment at different moments, thus facilitating the formation of the groove 151 jointly enclosed by the bottom surface 131, the inclined surfaces 161 and the stepped surface 171, with different textured structures on the bottom surface 131 and the stepped surface 171.

Another embodiment of the present disclosure further provides a photovoltaic module, which is configured to convert received light energy into electrical energy. The photovoltaic module provided in the embodiment of the present disclosure will be described in detail with reference to the accompanying drawings. It should be noted that the same or corresponding parts as those in the foregoing embodiments will not be described again herein.

Referring to FIG. 18 to FIG. 24, and FIG. 16 and FIG. 17, the photovoltaic module includes: at least one cell string, each formed by connecting a plurality of photovoltaic cells 40 provided in the embodiments shown in FIG. 18 to FIG. 24, or formed by connecting a plurality of photovoltaic cells 40 formed by the method for manufacturing the photovoltaic cell provided in the embodiments shown in FIG 25 to FIG. 28, at least one encapsulation adhesive film 41, configured to cover a surface of the at least one cell string, and at least one cover plate 42, configured to cover a surface of the at least one encapsulation adhesive film 41 away from the at least one cell string. The photovoltaic cells 40 are electrically connected in the form of a whole sheet or multiple sheets to form the at least one cell strings, and the at least one cell strings are electrically connected in series and/or in parallel.

It should be noted that the base size of the second pyramids 141a in the slope 141 shown in FIG. 2, FIG. 3 and FIG. 5 may be greater than the base size of the fourth pyramids 171a in the stepped surface 171 shown in FIG. 19 and FIG. 20. The base size of the first pyramids 131a in the bottom surface 131 shown in FIG. 2, FIG. 3 and FIG. 5 may be smaller than the base size of the first pyramids 131a in the bottom surface 131 shown in FIG. 19 and FIG. 20. The height of the first pyramids 131a in the bottom surface 131 shown in FIG. 2, FIG. 3 and FIG. 5 may be smaller than the height of the first pyramids 131a in the bottom surface 131 shown in FIG. 19 and FIG. 20.

The embodiments of the present disclosure further provide a photovoltaic cell, a method for manufacturing the photovoltaic cell, and a photovoltaic module. In the photovoltaic cell, in order to avoid the entire second region being a pyramid textured surface, the transition region between the bottom surface and the first region is designed to be a smooth inclined surface. On one hand, a height difference between the bottom surface and the first region is beneficial to using the smooth inclined surface to efficiently reflect the light that has not been absorbed by the bottom surface, so that the light is finally reflected to the first region or the bottom surface to be absorbed and utilized, which is beneficial to reducing the overall reflection loss of light on the first surface. On the other hand, the light obliquely incident on the second region relative to the first direction X can change its angle through the reflection of the smooth inclined surface, and is more likely to be captured by the bottom surface or the first region. Then, the first surface as a whole can receive light at more incident angles, so as to reduce light escape, thereby further reducing the reflection loss of light on the first surface. On the other hand, it is beneficial to improving the overall flatness of the second region with the help of the smooth inclined surface. When a film layer is formed on the first surface subsequently, the film layer can smoothly transition from the first region to the bottom surface with the help of the smooth inclined surface, which is beneficial to forming a film layer with a uniform thickness on the first surface. The smooth inclined surface can relieve the degree of stress concentration during film deposition, thereby reducing the risk of film cracking or peeling. On the other hand, it is beneficial for the photo-generated carriers in the second region to quickly migrate to the nearest first region with the help of the smooth inclined surface, so as to reduce the lateral transmission distance of the photo-generated carriers, thereby reducing the recombination probability of the photo-generated carriers. Moreover, it is beneficial to using the smooth inclined surface as a channel for guiding the photo-generated carriers, so as to avoid the problem of local concentration of photo-generated carriers caused by the conventional textured surface, thereby improving the fill factor of the photovoltaic cell and improving the photoelectric conversion efficiency of the photovoltaic cell. In addition, the groove located in the second region is beneficial to increasing the number of reflection and/or scattering of light in the second region, and increasing a surface area of the second region for absorbing light, so as to further enhance the light trapping effect of the second region for light.

Referring to FIG. 29 to FIG. 31, the photovoltaic cell includes a substrate 100 having a first surface 101 and a second surface 102 opposite to each other. The first surface 101 has first regions 111 and second regions 121 alternately arranged in a first direction X. The substrate 100 has grooves 151 recessed into the substrate 100 in the second regions 121. Each groove 151 includes a bottom surface 131 and a smooth inclined surface 181 connecting the bottom surface 131 and the first region 111. The smooth inclined surface 181 is inclined towards a direction that the second region 121 is close to the first region 111. The bottom surface 131 is provided as a first textured surface including a plurality of first pyramids 131a.The first region 111 is provided as a third textured surface including a plurality of third pyramids 111a.

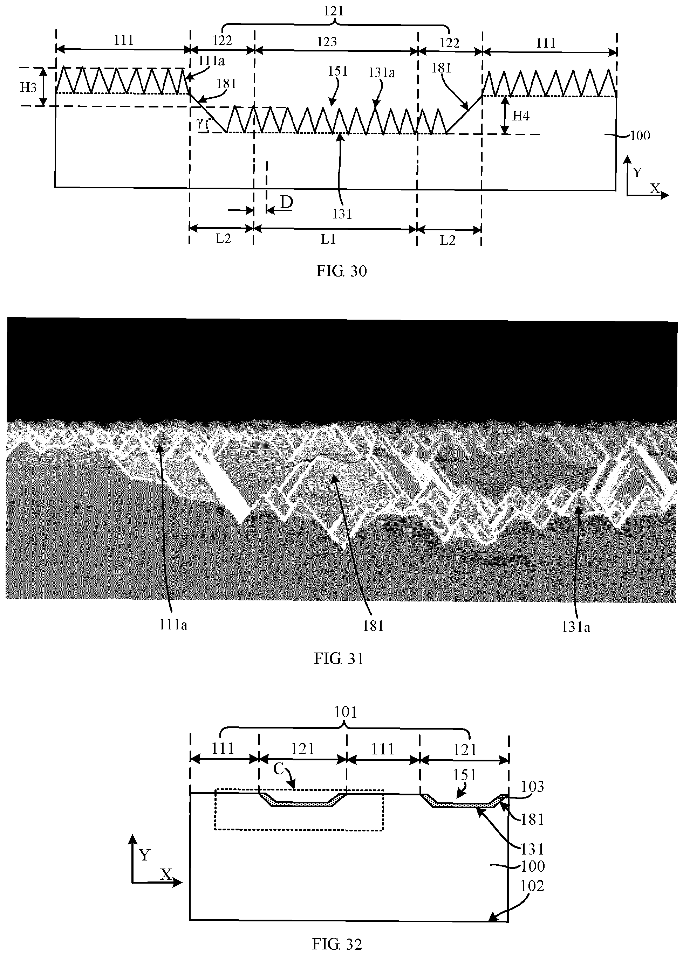

FIG. 29 is a schematic diagram illustrating a tenth partial cross-sectional view of a photovoltaic cell according to an embodiment of the present disclosure. FIG. 30 is schematic diagram illustrating an enlarged view of the substrate at a dashed box C shown in FIG. 29. FIG. 31 is a further three-dimensional scanning electron microscope (SEM) schematic diagram of a substrate in a photovoltaic cell according to an embodiment of the present disclosure.

It should be noted that not only the grooves 151 are designed on the first surface 101, but also, in order to avoid the entire second region 121 being a pyramid textured surface, the transition region between the bottom surface 131 and the first region 111 is designed to be a smooth inclined surface 181. On one hand, a height difference between the bottom surface 131 and the first region 111 is beneficial to using the smooth inclined surface 181 to efficiently reflect the light that has not been absorbed by the bottom surface 131, so that the light is finally reflected to the first region 111 or the bottom surface 131 and absorbed and utilized, which is beneficial to achieving the closed-loop utilization of light and reducing the overall reflection loss of light on the first surface 101. On the other hand, the light obliquely incident on the second region 121 relative to the first direction X can change its angle through the reflection of the smooth inclined surface 181, and is more likely to be captured by the bottom surface 131 provided as the first textured surface including the plurality of first pyramids 131a, or more likely to be captured by the first region 111 provided as the third textured surface including the plurality of third pyramids 111a. Then, the first surface 101 as a whole can receive light at more incident angles, so as to reduce light escape, thereby further reducing the reflection loss of light on the first surface 101, and improving the photoelectric conversion efficiency of the photovoltaic cell under weak light conditions or oblique light conditions. On the other hand, it is beneficial to improving the overall flatness of the second region 121 with the help of the smooth inclined surface 181. When a film layer is formed on the first surface 101 subsequently, the film layer can smoothly transition from the first region 111 to the bottom surface 131 with the help of the smooth inclined surface 181, which is beneficial to forming a film layer with a uniform thickness on the first surface 101. The smooth inclined surface 181 can relieve the degree of stress concentration during film deposition, thereby reducing the risk of film cracking or peeling. On the other hand, it is beneficial for the photo-generated carriers in the second region 121 to quickly migrate to the nearest first region 111 with the help of the smooth inclined surface 181, so as to reduce the lateral transmission distance of the photo-generated carriers, thereby reducing the recombination probability of the photo-generated carriers. Moreover, it is beneficial to using the smooth inclined surface 181 as a channel for guiding the photo-generated carriers, so as to avoid the problem of local concentration of photo-generated carriers caused by the conventional textured surface, thereby improving the fill factor of the photovoltaic cell and improving the photoelectric conversion efficiency of the photovoltaic cell.

In addition, the groove 151 located in the second region 121 is beneficial to increasing the number of reflection and/or scattering of light in the second region 121, and increasing a surface area of the second region 121 for absorbing light, so as to further enhance the light trapping effect of the second region 121 for light.

It should be noted that the smoothness represented by the smooth inclined surface 181 is in comparison with the bottom surface 131 including the first pyramids 131a. Due to the influence of the forming process, the surface of the smooth inclined surface 181 may not necessarily be as smooth as a polished surface, and there may also be tiny protrusions or depressions, without having a typical pyramid structure. The overall smoothness, that is, the flatness, is much higher than the flatness of the bottom surface 131.

It should be noted that the photovoltaic cell further includes electrodes at least located on the first surface 101, and the electrodes are used to extract the photo-generated carriers generated in the substrate 100. Based on this, in order to facilitate the description of the specific orientation of the first pyramids 131a and the third pyramids 111a on the first surface 101, for those skilled in the art, the first surface 101 may be divided into first regions 111 and second regions 121. The first regions 111 include at least the regions where orthographic projection of the electrodes are located on the substrate 100, and the regions on the first surface 101 other than the first regions 111 are the second regions 121. In order to ensure that the film layer in contact with the electrodes has a large doping concentration or the regions in contact with the electrodes are high-concentration regions to reduce the contact resistance, an orthographic projection area of the first region 111 is generally set to be greater than or equal to an orthographic projection area of the corresponding electrode. In other words, the orthographic projection area of the electrode on the substrate 100 is smaller than the area of the first region 111, and the orthographic projection position is necessarily within the first region 111. It should be noted that the number of the first regions 111 and the number of the second regions 121 may both be plural, and the first regions 111 and the second regions 121 are alternately arranged in the first direction X. In other words, the first region 111 may be located in an interval between adjacent second regions 121, and the second region 121 may also be located in an interval between adjacent first regions 111.

Further, in order to further reflect the difference between the first pyramids 131a and the smooth inclined surface 181, for those skilled in the art, the second region 121 may be divided into one transition region 122, one second sub-region 123, and another transition region 122 arranged in sequence in the first direction X. One transition region 122 is referred to as the region occupied by one smooth inclined surface 181 in the second region 121, and one second sub-region 123 is referred to as the region occupied by one bottom surface 131 in the second region 121. In other words, the first pyramids 131a are located in the second sub-region 123, and the smooth inclined surface 181 is located in the transition region 122. In addition, each of the two first regions 111 on two opposite sides of the same second region 121 along the first direction X is connected to one corresponding transition region 122.

The embodiments of the present disclosure will be described in more detail below with reference to the accompanying drawings.

In some embodiments, referring to FIG. 30 or FIG. 31, the reflectivity of the first region 111 provided as the third textured surface may be greater than the reflectivity of the bottom surface 131 provided as the first textured surface. In other embodiments, the reflectivity of the first region provided as the third textured surface may be almost the same as the reflectivity of the bottom surface provided as the first textured surface.

In some examples, the reflectivity of the first region 111 ranges from 10.5 to 11.5, and for example, may be 10.6, 10.7, 10.8, 10.9, 11, 11.1, 11.2, 11.3, or 11.4, etc. The reflectivity of the bottom surface 131 ranges from 10.5 to 11, and for example, may be 10.55, 10.6, 10.65, 10.7, 10.75, 10.8, 10.85, 10.9, or 10.95, etc.

In some embodiments, referring to FIG. 30 or FIG. 31, the base sizes of both the first pyramids 131a and the third pyramids 111a range from 1 µm to 2 µm, and for example, may be 1.1 µm, 1.2 µm, 1.3 µm, 1.4 µm, 1.5 µm, 1.6 µm, 1.7 µm, 1.8 µm, or 1.9 µm, etc. It should be noted that the value ranges of the base sizes of the first pyramids 131a and the third pyramids 111a may be the same, but the specific values of the base sizes of the first pyramids 131a and the third pyramids 111a may be either the same or different.

It should be noted that since the base sizes of both the first pyramids 131a and the third pyramids 111a are relatively small, within the same arrangement area, the arrangement numbers of both the first pyramids 131a and the third pyramids 111a are relatively small. On one hand, it is beneficial to increasing the surface area and specific surface area of the bottom surface 131 and the first region 111, so that the bottom surface 131 and the first region 111 have more surfaces for receiving incident light, thereby improving the ability to capture the light reflected by the smooth inclined surface 181. On the other hand, it is beneficial to reducing the gaps between adjacent first pyramids 131a and the gaps between adjacent third pyramids 111a, so that the bottom surface 131 and the first region 111 can capture incident light more effectively, thereby reducing the probability of light escaping between adjacent first pyramids 131a or adjacent third pyramids 111a. Moreover, a larger number of first pyramids 131a and a larger number of third pyramids 111a can be arranged to disperse the incident light more evenly, so that the incident light can easily enter the substrate 100 to be absorbed and utilized. On the other hand, it is beneficial to reducing the sensitivity of the bottom surface 131 and the first region 111 to the incident angle of the incident light, so that the bottom surface 131 and the first region 111 can maintain a relatively high absorption rate for light under different illumination angles.

In one example, the bases of both the first pyramids 131a and the third pyramids 111a may be quadrilaterals with a size of 1.5 µm × 1.5 µm.

It should be noted that the base size of the pyramid structure includes any one of the length, width, or diagonal length of the orthographic projection pattern of the bottom of the pyramid structure on the second surface 102. For example, taking the orthographic projection pattern of the bottom of the pyramid structure on the second surface 102 being a regular quadrilateral as an example, the base size of the pyramid structure is any one of the length, width, or diagonal length of the regular quadrilateral. In addition, the pyramid structures mentioned herein include the first pyramids 131a and the third pyramids 111a.

In practical applications, the orthographic projection pattern of the base of the pyramid structure on the second surface may also be an irregular polygon. In this case, the length, width, or diagonal length of the orthographic projection pattern of the bottom of the pyramid structure on the second surface is not absolute, but is artificially defined to characterize the base size of the pyramid structure. For example, if the orthographic projection pattern of the bottom of the pyramid structure on the second surface is an irregular quadrilateral, a length of the base of the pyramid structure may be defined as a side length of a longest side of the irregular quadrilateral, a width of the base of the pyramid structure may be defined as a side length of a shortest side of the irregular quadrilateral, and a diagonal length of the base of the pyramid structure may be defined as a length of a longest diagonal of the irregular quadrilateral. It should be understood that the above is only an exemplary description, and it may be flexibly defined according to actual needs in practice. In addition, the orthographic projection pattern of the base of the pyramid structure on the second surface may be not only an irregular quadrilateral, but also other irregular polygons, a circle, or an irregular shape similar to a circle. In this case, the base size of the pyramid structure is obtained by selecting multiple different regions with a specific area at the base of the pyramid structure. The regions with a specific area may be flexibly defined according to actual needs to calculate average values of the lengths, widths, diagonals, or diameters of the multiple different regions with a specific area.

In some embodiments, referring to FIG. 30 or FIG. 31, the heights of the first pyramids 131a and the third pyramid 111a may range from 1.5 µm to 2.5 µm, and for example, may be 1.6 µm, 1.7 µm, 1.8 µm, 1.9 µm, 2 µm, 2.1 µm, 2.2 µm, 2.3 µm, or 2.4 µm, etc. It should be noted that the value ranges of the heights of the first pyramids 131a and the third pyramids 111a may be the same, but the specific values of the heights of the first pyramids 131a and the third pyramids 111a may be either the same or different.

It should be noted that the height of the pyramid refers to the distance between the apex of the pyramid and the base of the pyramid in the second direction Y. The second direction Y is the direction in which the second surface 102 points towards the first surface 101, in other words, the second direction Y is the direction of the thickness of the substrate 100.

In some embodiments, referring to FIG. 30 or FIG. 31, vertex angles of the first pyramid 131a and the third pyramid 111a may be in a range of 65° to 80°, and for example, may be 66°, 67°, 68°, 69°, 70°, 71°, 72°, 73°, 74°, 75°, 76°, 77°, 78°, or 79°, etc. In this way, it is advantageous to capture incident light more efficiently with the aid of a pyramid with a smaller vertex angle, for example, so that light from a greater number of incident angles can all be reflected into the first face 101 to increase the total amount of light entering the first face 101.

It should be noted that the angle formed by the two lateral edges set opposite each other in the pyramid may be regarded as the vertex angle of the pyramid.

In some cases, referring to FIG. 30, in the same groove 151, along the first direction X, a length of the bottom surface 131 is the first length L1, and a length of the smooth inclined surface 181 is the second length L2. A ratio of the second length L2 to the first length L1 ranges from 0.001 to 0.005. For example, it can be 0.0015, 0.002, 0.0025, 0.003, 0.0035, 0.004, or 0.0045, etc.

It should be noted that both the first region 111 and the second region 121 extend along a third direction. Therefore, the groove 151 may be regarded as an elongated trench extending along the third direction, where the bottom surface 131 and the smooth inclined surface 181 share identical extension dimensions in the third direction. The area sizes of the bottom surface 131 and the smooth inclined surface 181 primarily depend on their respective lengths in the first direction X. In this way, by designing the ratio of the second length L2 to the first length L1 in a range of 0.001 to 0.01, a surface area of the groove 151 is mainly determined by an area of the bottom surface 131. Designing the first pyramids 131a included in the bottom surface 131 to have a higher height is beneficial to providing a larger surface area and more attachment points, so that the film layer subsequently deposited on the surface of the groove 151 can be better attached and more uniformly cover the surface of the groove 151, that is, it is advantageous to make the deposited film layer, such as a passivation layer, an inverse reduction layer, or a transparent conductive layer, cover the surface of the groove 151 more uniformly, thereby being beneficial to reducing the defects and pores in the film layer and improving the quality and performance of the film layer.

In some cases, referring to FIG. 30, along the first direction X, the first length L1 of the bottom surface 131 ranges from 200 µm to 800 µm. For example, the first length L1 may be 250 µm, 300 µm, 350 µm, 400 µm, 450 µm, 500 µm, 550 µm, 600 µm, 650 µm, 700 µm or 750 µm, etc.

In some cases, referring to FIG. 30, along the second direction Y, which is a thickness direction of the substrate 100, the depth H3 of the groove 151 ranges from 2 µm to 4 µm. In this way, the depth of the groove 151 is not greater than 4 µm, and it is a groove 151 with a relatively shallow depth.

On one hand, the penetration depth of short-wavelength light is shallow, and the groove 151 with a relatively shallow depth is beneficial to improving the absorption and utilization rate for short-wavelength light. On the other hand, the groove 151 with a relatively shallow depth is beneficial to reducing the path length of the photo-generated carriers in the second region 121 migrating to the first region 111, and reducing the recombination probability of the photo-generated carriers, so as to increase the open-circuit voltage of the photovoltaic cell, and improve the collection efficiency of the electrode located in the first region 111 for the photo-generated carriers. On the other hand, the groove 151 with a relatively shallow depth is beneficial to improving the overall flatness of the first surface 101, thereby being beneficial to forming a film layer with a uniform thickness on the first surface 101 subsequently.

It should be noted that the plane where the apexes of most of the first pyramids 131a are located is taken as a first plane, and the plane where the apexes of most of the third pyramids 111a are located is taken as a second plane. Along the second direction Y, the depth H3 of the groove 151 refers to a distance between the first plane and the second plane. In addition, the apexes of all first pyramids 131a included in the bottom surface 131 may be in different planes, but more than half of the number of apexes of the first pyramids 131a are almost in the same plane, which may serve as the first plane. The apexes of all third pyramids 111a included in the first region 111 may be in different planes, but more than half of the number of apexes of the third pyramids 111a are almost in the same plane, which may serve as the second plane.

In some examples, along the second direction Y, the depth H3 of the groove 151 may be 2.1 µm, 2.2 µm, 2.3 µm, 2.4 µm, 2.5 µm, 2.6 µm, 2.7 µm, 2.8 µm, 2.9 µm, 3 µm, 3.1 µm, 3.2 µm, 3.3 µm, 3.4 µm, 3.5 µm, 3.6 µm, 3.7 µm, 3.8 µm, or 3.9 µm, etc.

In some cases, referring to FIG. 30, the plane where the bottoms of most of the third pyramids 111a included in the first region 111 are located is taken as the third reference plane, and the plane where the bottoms of most of the first pyramids 131a included in the bottom surface 131 are located is taken as the second reference plane. Based on this, along the second direction Y, the distance H4 between the third reference plane of the first region 111 and the second reference plane of the bottom surface 131 ranges from 2.5 µm to 4.5 µm. For example, it can be 2.6 µm, 2.7 µm, 2.8 µm, 2.9 µm, 3 µm, 3.1 µm, 3.2 µm, 3.3 µm, 3.4 µm, 3.5 µm, 3.6 µm, 3.7 µm, 3.8 µm, 3.9 µm, 4 µm, 4.1 µm, 4.2 µm, 4.3 µm, or 4.4 µm, etc.

It should be noted that in the above various embodiments, in FIG. 30, the second reference plane of the bottom surface 131 and the third reference plane of the first region 111 are indicated by densely dotted lines.

In addition, the bottom surface of the first pyramid 131a is a plane where the base of the first pyramid 131a is located. The orthographic projection pattern of the base of the first pyramid 131a on the substrate 100 may be a regular quadrilateral, or may be an irregular polygon. It should be noted that, the bottom surfaces of all first pyramids 131a included in the bottom surface 131 may be in different planes, but more than half of the number of first pyramids 131a have bottom surfaces that are nearly in the same plane, which may serve as the reference plane of the bottom surface 131.

The bottom surface of the third pyramid 111a is a plane where the base of the third pyramid 111a is located. The orthographic projection pattern of the base of the third pyramid 111a on the substrate 100 may be a regular quadrilateral, or may be an irregular polygon. It should be noted that, the bottom surfaces of all third pyramid 111a included in the first region 111 may be in different planes, but more than half of the number of third pyramid 111a have bottom surfaces that are nearly in the same plane, which may serve as the reference plane of the first region 111.

In some embodiments, referring to FIG. 30, an inclination angle γ of the smooth inclined surface 181 inclined towards the second region close to the first region 111 ranges from 40° to 55°. For example, the inclination angle γ may be 40.5°, 41°, 41.5°, 42°, 42.5°, 43°, 43.5°, 44°, 44.5°, 45°, 45.5°, 46°, 46.5°, 47°, 47.5°, 48°, 48.5°, 49°, 49.5°, 50°, 50.5°, 51°, 51.5°, 52°, 52.5°, 53°, 53.5°, 54° or 54.5°, etc. It should be noted that the inclination angle γ of different smooth inclined surfaces 181 inclined toward the first region 111 may be either identical or exhibit slight variations. However, the numerical range of the inclination angle γ for any smooth inclined surface 181 inclined toward the first region 111 may be set within 40° to 55°.

It should be noted that, designing the inclination angle γ of the smooth inclined surface 181 inclined toward the first region 111 within 40° to 55° can avoid excessive steepness of the smooth inclined surface 181. As a transition region between the bottom surface 131 and the first region 111, the smooth inclined surface 181 reduces abrupt height variations between adjacent regions of the smooth inclined surface 181 along the first direction X. In other words, with the second surface 102 as the reference plane, this design minimizes height differences between adjacent regions along the first direction X across the smooth inclined surface 181, enabling a gradual morphological transition from the elevated first region 111 to the lower bottom surface 131 on the first surface 101. This smooth transition is beneficial to achieving uniform film thickness (e.g., passivation layers) on the first surface 101, thereby enhancing passivation effectiveness.

Furthermore, if the inclination angle γ of the smooth inclined surface 181 inclined toward the first region 111 is set to be less than 40°, compared with the inclination angle γ greater than or equal to 40°, in the case of the surface area of the smooth inclined surface 181 remaining unchanged, the size of the transition region 122 in the first direction X is increased, and thus the number of the first regions 111 that can be laid out on the entire first surface 101 is reduced. Therefore, designing an inclination angle γ of the smooth inclined surface 181 inclined toward the first region 111 to be greater than or equal to 40° is beneficial to ensure that the smooth inclined surface 181 has a certain surface area, while at the same time decreasing the size of the smooth inclined surface 181 as a whole in the first direction X, i.e., decreasing the proportion of the transition region 122 that is occupied by the transition region 122 across the entire first surface 101.

It should be noted that with reference to FIG. 30, the plane on which a majority number of the bottom surfaces of first pyramids 131a included in the bottom surface 131 lie is used as the reference surface of the bottom surface 131. Based on this, the inclination angle γ of the smooth inclined surface 181 inclined towards the first region 111 refers to an acute angle formed between the smooth inclined surface 181 and the reference plane of the bottom surface 131.

In some embodiments, referring to FIG. 32, FIG. 32 is a schematic diagram illustrating an eleventh partial cross-sectional view of a photovoltaic cell according to an embodiment of the present disclosure, the first protective layer 103 covers the bottom surface 131 and the smooth inclined surface 181.

In some cases, the first protective layer 103 may conformally cover the bottom surface 131 and the smooth inclined surface 181, then the surface morphology of the portion of the first protective layer 103 aligned with the bottom surface 131 also exhibits a textured morphology like the bottom surface 131. It should be noted that with reference to FIG. 30 to FIG. 32, on one hand, the first protective layer 103 is conducive to protecting the morphology of the first pyramids 131a, for example, when other film layers are subsequently formed on the second regions 121 and patterning is carried out, the first protective layer 103 can be used as an etching barrier layer, so as to avoid damage to the first pyramids 131a and the smooth inclined surface 181 by the patterning process, thereby favorably ensuring that the second regions 121 have relatively lower reflectivity.

On the other hand, the first protective layer 103 facilitates the enhancement of the optical properties of the second regions 121 to further reduce the reflection loss of the second regions 121, for example, to reduce the reflectivity of the photovoltaic cell as a whole disposed on the surface of the second regions 121 to ultimately enhance the absorption and utilization rate of the second regions 121 for light, thereby enhancing the photoelectric conversion efficiency of the photovoltaic cell.

In some cases, after the first protective layer 103 is formed by an oxygen-free high-temperature process, the reflectivity of the overall surface of the photovoltaic cell located in the second region 121 can be reduced by about 0.1 to 0.3 on the original basis. In other cases, after the first protective layer 103 is formed by an oxygen-containing high-temperature process, the reflectivity of the overall surface of the photovoltaic cell located in the second region 121 can be reduced by about 0.5 to 1 on the original basis. In still other cases, after the first protective layer 103 is formed by an in-situ doped oxidation process, the reflectivity of the overall surface of the photovoltaic cell located in the second region 121 can be reduced by about 0.5 to 1 on the original basis. The oxygen-free high-temperature process, the oxygen-containing high-temperature process, and the in-situ doped oxidation process will be described in detail later.

In some embodiments, referring to FIG. 32, the first protective layer 103 may be made from a semiconductor material doped with a doping element, silicon oxide, phosphosilicate glass, or borosilicate glass.

In some cases, the semiconductor material included in the first protective layer 103 is an elemental semiconductor material. Specifically, the elemental semiconductor material is composed of a single element. For example, it may be silicon or germanium. The elemental semiconductor material may be in a single crystal state, a polycrystalline state, an amorphous state, or a microcrystalline state (a state having both a single crystal state and an amorphous state is referred to as a microcrystalline state). For example, silicon may be at least one of single crystal silicon, polycrystalline silicon, amorphous silicon, or microcrystalline silicon. In other cases, the semiconductor material included in the first protective layer 103 is a compound semiconductor material. Common compound semiconductor materials include, but are not limited to, silicon germanide, silicon carbide, gallium arsenide, indium gallide, perovskite, cadmium telluride, or copper indium selenide and other materials.

In some cases, the doping element included in the first protective layer 103 may be an N-type doping element or a P-type doping element. The N-type doping element may be at least one of group V elements such as phosphorus (P), bismuth (Bi), antimony (Sb), or arsenic (As). The P-type doping element may be at least one of group III elements such as boron (B), aluminum (Al), gallium (Ga), or indium (In).

In some embodiments, the substrate 100 may be made from an elemental semiconductor material or a compound semiconductor material.

In some cases, the substrate 100 may be an N-type semiconductor substrate doped with an N-type doping element. In some other cases, the substrate 100 may be a P-type semiconductor substrate doped with a P-type doping element.

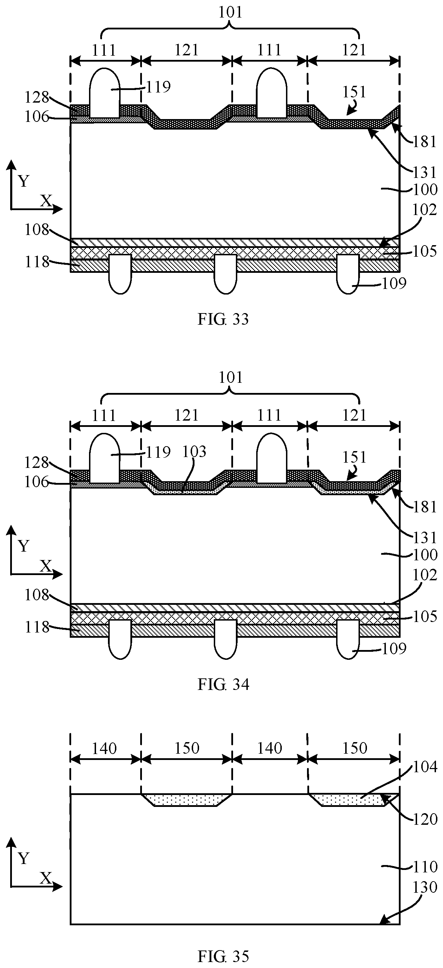

In some embodiments, referring to FIG. 33 and FIG. 34, FIG. 33 is a schematic diagram illustrating a twelfth partial cross-sectional view of a photovoltaic cell provided in an embodiment of the present disclosure, FIG. 34 is a schematic diagram illustrating a thirteenth partial cross-sectional view of a photovoltaic cell provided in an embodiment of the present disclosure, the photovoltaic cell further includes: a tunneling layer 108 located on the second surface 102, a first doped semiconductor layer 105 doped with a first doping element located on a side of the tunneling layer 108 away from the second surface 102, and a second doped semiconductor layer 106 doped with a second doping element located on the first regions 111. A conductivity type of the first doping element is different from a conductivity type of the second doping element. The photovoltaic cell further includes a first passivation layer 118 located on a side of the first doped semiconductor layer 105 away from the tunneling layer 108, a second passivation layer 128 located on a side of the second doped semiconductor layer 106 away from the substrate 100 and located on the second regions 121, first electrodes 109 in ohmic contact with the first doped semiconductor layer 105, and second electrodes 119 embedded in the second passivation layer 128 and in ohmic contact with the second doped semiconductor layer 106.

It should be noted that the second doped semiconductor layer 106, as a selective emitter structure on the first surface 101, is beneficial to ensuring that the second electrodes 119 have a good current collection efficiency based on the second doped semiconductor layer 106 while avoiding the second regions from being covered by the second doped semiconductor layer 106, thereby avoiding the parasitic absorption of the second doped semiconductor layer 106 for the light incident on the second regions 121, and enhancing the utilization of the first surface 101 for the light incident, so as to improve the photoelectric conversion efficiency of the photovoltaic cell.

In addition, the tunneling layer 108 and the first doped semiconductor layer 105 jointly form a passivated contact structure. The tunneling layer 108 chemically passivates the second surface 102, saturates the dangling bonds of the second face 102, reduces the defect state density of the second face 102, reduces the recombination probability of carriers on the second face 102, and the first doped semiconductor layer 105 field-passivates the second surface 102, reducing the concentration of minority carriers to reduce the recombination probability of carriers on the second face 102, thereby improving the photoelectric conversion efficiency of the photovoltaic cell. In addition, the first passivation layer 118 can further passivate the second surface 102 and serve as an optical optimization layer for the second surface 102 to improve the absorption and utilization rate of the second surface 102 for light. The second passivation layer 128 can passivate the first surface 101 to reduce the defect state density of the first surface 101, and serve as an optical optimization layer for the first surface 101 to improve the absorption and utilization rate of the first surface 101 for light.

In some cases, the second doped semiconductor layer 106 doped with the second doping element is formed in an initial state of the substrate 100. In other words, there is no obvious boundary line between the second doped semiconductor layer 106 and the substrate 100 located in the first region 111. In FIG. 33 and FIG. 34, for the convenience of description, different filling methods are used to draw the substrate 100 and the second doped semiconductor layer 106. On this basis, the smooth inclined surface 181 of the groove 151 formed by the substrate 100 located in the second region 121 recessed towards the second surface 102 may be regarded as being jointly formed by the second doped semiconductor layer 106 and the substrate 100 located in the first region 111.

In some cases, the material of the tunneling layer 108 may include at least one of silicon oxide, silicon nitride, silicon oxynitride, silicon carbide, or magnesium fluoride, and the material of the first doped semiconductor layer 105 may include at least one of amorphous silicon, polycrystalline silicon, or silicon carbide. Both the first doped semiconductor layer 105 and the substrate 100 may be doped with the first doping element.

In some cases, both the second passivation layer 128 and the first passivation layer 118 may be either a single-layer structure or a stacked-layer structure. In addition, the materials of both the second passivation layer 128 and the first passivation layer 118 may include at least one of aluminum oxide, silicon oxide, silicon nitride, or silicon oxynitride.

In some cases, the substrate 100 may be an N-type semiconductor substrate doped with an N-type doping element, the first doping element doped in the first doped semiconductor layer 105 is an N-type doping element, and the second doping element doped in the second doped semiconductor layer 106 is a P-type doping element. In some other cases, the substrate 100 may be a P-type semiconductor substrate doped with a P-type doping element, the first doping element doped in the first doped semiconductor layer 105 is a P-type doping element, and the second doping element doped in the second doped semiconductor layer 106 is an N-type doping element.

In summary, in order to avoid the entire second region 121 being a pyramid textured surface, the transition region between the bottom surface 131 and the first region 111 is designed to be a smooth inclined surface 181. On one hand, a height difference between the bottom surface 131 and the first region 111 is beneficial to using the smooth inclined surface 181 to efficiently reflect the light that has not been absorbed by the bottom surface 131, so that the light is finally reflected to the first region 111 to be absorbed and utilized by the first region 111, which is beneficial to achieving closed-loop utilization of light and reducing the overall reflection loss of light on the first surface 101. On the other hand, the light obliquely incident on the second region 121 relative to the first direction X can change its angle through the reflection of the smooth inclined surface 181, and is more likely to be captured by the bottom surface 131 provided as the first textured surface including the plurality of the first pyramids 131a or is more likely to be captured by the first region 111 provided as the third textured surface including the plurality of the third pyramids 111a. Then, the first surface 101 as a whole can receive light at more incident angles, so as to reduce light escape, thereby further reducing the reflection loss of light on the first surface 101 and improving the photoelectric conversion efficiency of the photovoltaic cell under weak light conditions or oblique light conditions. On the other hand, it is beneficial to improving the overall flatness of the second region 121 with the help of the smooth inclined surface 181. When a film layer is formed on the first surface 101 subsequently, the film layer can smoothly transition from the first region 111 to the bottom surface 131 with the help of the smooth inclined surface 181, which is beneficial to forming a film layer with a uniform thickness on the first surface 101. The smooth inclined surface 181 can relieve the degree of stress concentration during film deposition, thereby reducing the risk of film cracking or peeling. On the other hand, it is beneficial for the photo-generated carriers in the second region 121 to quickly migrate to the nearest first region 111 with the help of the smooth inclined surface 181, so as to reduce the lateral transmission distance of the photo-generated carriers, thereby reducing the recombination probability of the photo-generated carriers. Moreover, it is beneficial to using the smooth inclined surface 181 as a channel for guiding the photo-generated carriers, so as to avoid the problem of local concentration of photo-generated carriers caused by the conventional textured surface, thereby improving the fill factor of the photovoltaic cell and improving the photoelectric conversion efficiency of the photovoltaic cell. In addition, the groove 151 located in the second region 121 is beneficial to increasing the number of reflection and/or scattering of light in the second region 121, and increasing a surface area of the second region 121 for absorbing light, so as to further enhance the light trapping effect of the second region 121 for light.

Another embodiment of the present disclosure further provides a method for manufacturing a photovoltaic cell, which is configured to form the photovoltaic cell provided in the foregoing embodiments. The method for manufacturing the photovoltaic cell provided in another embodiment of the present disclosure with reference to the accompanying drawings will be described in detail below. FIG. 10, FIG. 35 to FIG. 38 and FIG. 15 are schematic diagrams of the partial cross-sectional structures corresponding to each operation in the method for manufacturing the photovoltaic cell provided in another embodiment of the present disclosure. It should be noted that the same or corresponding parts as those in the foregoing embodiments will not be described in detail herein.

With reference to FIG. 10, FIG. 35 to FIG. 38, and FIG. 15, the method for manufacturing the photovoltaic cell may at least include the following operations.

S1: Referring to FIG. 10, an initial substrate 110 is provided, where the initial substrate 110 has an initial first surface 120 and an initial second surface 130 opposite to each other. The initial first surface 120 has initial first regions 140 and initial second regions 150 that are alternately arranged along the first direction X.

It should be noted that the initial first surface 120 corresponds to the subsequently formed first surface, the initial first regions 140 correspond to the first regions of the subsequently formed first surface, the initial second regions 150 correspond to the second regions of the subsequently formed first surface, and the initial second surface 130 corresponds to the subsequently formed second surface.

S2: Referring to FIG. 10, FIG. 35 and FIG. 36, the initial second regions 150 is irradiated using a laser spot with a gradual change in energy to transform a portion of the thickness of the initial substrate 110, which is disposed in the initial second regions 150, into a damage layer 104, and the change in the energy of the laser spot in a direction of the center of the laser spot pointing toward the edge includes at least a first stage I, a second stage II, and a third stage III in a sequential manner, with the energy of the laser spot in the first stage I being at a first preset value, the energy of the laser spot gradually increases from the first preset value to a second preset value in the second stage II, and the energy of the laser spot gradually decreases from the second preset value to zero in the third stage III. In other words, in the direction of the center of the laser spot pointing towards the edge, the energy of the laser spot first remains unchanged, then gradually increases, and finally gradually decreases to zero.

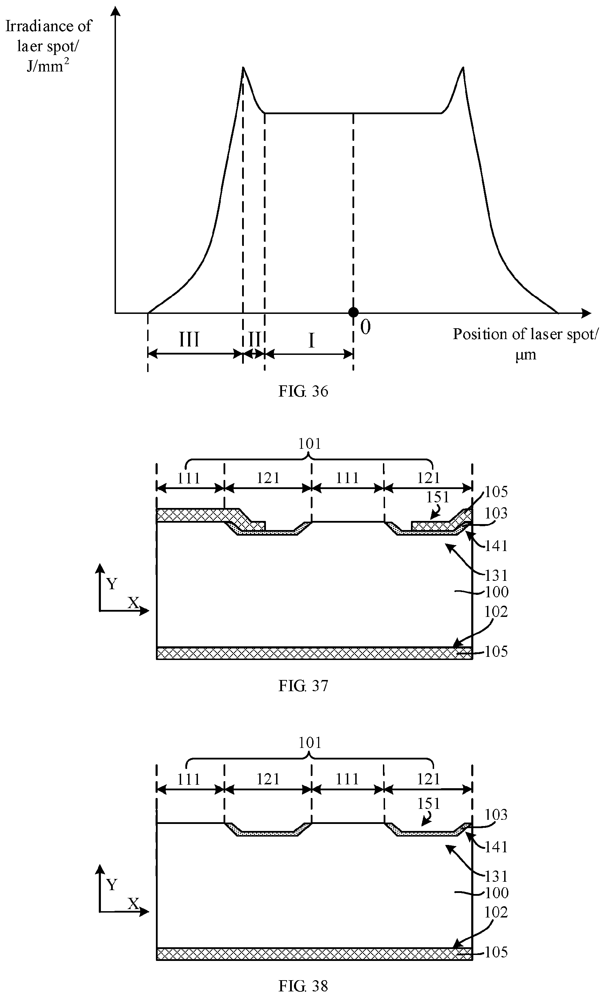

FIG. 35 is a schematic diagram illustrating a partial cross-sectional of a damage layer formed in a method for manufacturing a photovoltaic cell according to a further embodiment of the present disclosure. FIG. 36 is a further curve diagram corresponding to an energy gradient of a laser spot in a method for manufacturing a photovoltaic cell according to another embodiment of the present disclosure. In addition, the center of the laser spot is taken as point 0 in FIG. 36.

S3: Referring to FIG. 35 and FIG. 29 to FIG. 31, each initial second region 150 is subjected to a first textured process to at least remove the damage layer 104 and to form a groove 151 in the second region 121, with the remaining initial substrate 110 being the substrate 100, the initial first region 140 transformed into the first region 111 of the substrate 100, and the initial second region 150 transformed into the second region 121 of the substrate 100, and the substrate 100 including a bottom surface 131 recessed toward inside of the substrate 100 in the second region 121, and a smooth inclined surface 181 connecting the bottom surface 131 and the first region 111, the smooth inclined surface 181 inclined toward the first region 111, and the bottom surface 131 and the smooth inclined surface 181 enclosing the groove 151.

The bottom surface 131 is provided as a first textured surface including a plurality of first pyramids 131a, the region 111 is provided as a third textured surface including a plurality of third pyramids 111a.

It should be noted that during the process of irradiating the initial second regions 150 using the laser spot with gradual change in energy in operation S2, only the damage layer 104 is formed in the initial second region 150, and a stepped structure with a height difference is not be formed between the initial first region 140 and the initial second region 150. On this basis, in operation S3, by means of the difference in etching rates of the damage layer 104 in the initial second region 150 and the initial first region 140 during the first texturing treatment, the initial second region 150 is transformed into the second region 121 with the groove 151.

Further, based on the design in operation S2 that along the direction from the center to the edge of the laser spot, the energy of the laser spot remains unchanged first, then gradually increases, and finally gradually decreases to zero, which is beneficial to forming the damage layer 104 with different thickness in different regions in operation S2. Generally speaking, the portion of the initial substrate 110 irradiated by the portion with greater energy in the laser spot has a greater degree of damage caused by the laser, and the formed damage layer 104 has a greater thickness or the interior is more completely destroyed. For example, in a direction along the center of the initial second region 150 pointing toward the initial first region 140, the thickness of the damage layer 104 first remains unchanged, then gradually increases, and finally gradually decreases to zero. On this basis, in operation S3, the etching rates of different regions of the damage layer 104 during the first texturing treatment are different, and the durations spent by the first texturing treatment to remove the damage layer 104 with different thicknesses are also different. Therefore, the first texturing treatment exposes the initial substrate 110 covered by different portions of the damage layer 104 at different moments, and further performs a texturing treatment on the remaining initial substrate 110 at different moments. Consequently, it is beneficial to forming the groove 151 jointly surrounded by the bottom surface 131 and the smooth inclined surface 181, and forming the bottom surface provided as the first textured surface including the plurality of the first pyramids 131a.

In other words, under the joint cooperation of irradiating the initial second region 150 using the laser spot with gradual change in energy in operation S2 and the first texturing treatment in operation S3, the turning points of the etching rates of different regions of the film layer jointly formed by the damage layer 104 and the remaining initial substrate 110 during the first texturing treatment are different along the direction from the center of the initial second region 150 to the initial first region 140. Further, the average etching rate of the first texturing treatment on different regions of the film layer including the damage layer 104 and the remaining initial substrate 110 together is further made to be gradual change, for example, to remain unchanged and then gradually decreased to zero, thereby favoring the eventual formation of the smooth inclined surface 181.

In some embodiments, referring to FIG. 36 and FIG. 30, the position with the maximum energy of the laser spot, that is, the second preset value, irradiates the bottom surface 131 of the groove 151, and irradiates the region of the bottom surface 131 close to the smooth inclined surface 181. It should be noted that the energy of a single laser spot reaches the second preset value in two different regions, and the two second preset values irradiate the regions of the bottom surface 131 close to two different smooth inclined surface 181 respectively.

In some cases, along the first direction X, an irradiation position of the bottom surface 131 corresponding to the second preset value and a junction of the smooth inclined surface 181 and the bottom surface 131 are spaced apart by a preset distance D, and a ratio of the preset distance D to the first length L1 of the bottom surface 131 ranges from 0.0025 to 0.05. For example, the ratio may be 0.003, 0.004, 0.005, 0.006, 0.007, 0.008, 0.009, 0.01, 0.015, 0.02, 0.025, 0.03, 0.035, 0.04, or 0.045, etc.

It should be noted that the first length L1 of the smooth inclined surface 181 is formed by multiple laser lines opening the film, and the surface area of the groove 151 is mainly determined by the first length L1 of the bottom surface 131. The value range of the first length L1 is relatively large. Based on this, the value range of the ratio of the preset distance D to the first length L1 of the bottom surface 131 is also relatively large. However, compared with the first length L1 of the bottom surface 131, the preset distance D between the irradiation position of the bottom surface 131 corresponding to the second preset value and the junction of the smooth inclined surface 181 and the bottom surface 131 is relatively small. In other words, the position irradiated by the turning point of the energy decrease of the laser spot is very close to the finally formed smooth inclined surface 181.

In some examples, the preset distance D between the irradiation position of the bottom surface 131 corresponding to the second preset value and the junction of the smooth inclined surface 181 and the bottom surface 131 ranges from 5 µm to 10 µm. For example, the preset distance D may be 5.2 µm, 5.5 µm, 5.8 µm, 6 µm, 6.3 µm, 6.5 µm, 6.6 µm, 6.8 µm, 7 µm, 7.3 µm, 7.5 µm, 7.7 µm, 8 µm, 8.2 µm, 8.5 µm, 8.8 µm, 9 µm, 9.3 µm, or 9.5 µm, etc.

In some examples, an overall size of the laser spot ranges from 50 µm to 200 µm. In other words, a diameter of the laser spot ranges from 50 µm to 200 µm. For example, the diameter of the laser spot may be 60 µm, 70 µm, 80 µm, 90 µm, 100 µm, 110 µm, 120 µm, 130 µm, 140 µm, 150 µm, 160 µm, 170 µm, 180 µm, or 190 µm, etc.

In some examples, referring to FIG. 35 and FIG. 36, a single laser spot is divided into two symmetrical portions along the center. Along the first direction X, a width of the irradiation region of either of the two portions of the laser spot corresponding to the first stage I on the initial second region 150 ranges from 20 µm to 50 µm, for example, may be 21 µm, 22 µm, 23 µm, 24 µm, 25 µm, 26 µm, 27 µm, 28 µm, 29 µm, 30 µm, 31 µm, 32 µm, 33 µm, 34 µm, 35 µm, 36 µm, 37 µm, 38 µm, 39 µm, 40 µm, 41 µm, 42 µm, 43 µm, 44 µm, 45 µm, 46 µm, 47 µm, 4 8µm, or 49 µm, etc. A width of the irradiation region of either of the two portions of the laser spot corresponding to the second stage II on the initial second region 150 ranges from 2 µm to 5 µm, for example, may be 2.2 µm, 2.5 µm, 2.6 µm, 3 µm, 3.2 µm, 3.5 µm, 3.8 µm, 4 µm, 4.2 µm, 4.5 µm, or 4.8 µm, etc. A width of the irradiation region of either of the two portions of the laser spot corresponding to the third stage III on the initial second region 150 ranges from 5 µm to 10 µm, for example, may be 5.2 µm, 5.5 µm, 5.6 µm, 5.8 µm, 6 µm, 6.2 µm, 6.5 µm, 6.6 µm, 7 µm, 7.2 µm, 7.5 µm, 7.8 µm, 8 µm, 8.2 µm, 8.5 µm, 8.8 µm, 9 µm, 9.2 µm, 9.5 µm, or 9.8 µm, etc.

It should be noted that designing the width of the irradiation region of the laser spot corresponding to the second stage II on the initial second region 150 to range from 2 µm to 5 µm, and designing the width of the irradiation region of the laser spot corresponding to the third stage III on the initial second region 150 to range from 5 µm to 10 µm can shorten the irradiation range of the laser spots corresponding to the second stage II and the third stage III on the initial second region 150, which is beneficial to controlling the relatively low damage degree inside the damage layer 104 corresponding to the finally formed smooth inclined surface 181, reducing the etching degree of the damage layer 104 and the initial substrate 110 corresponding to the finally formed slope 141 during the first texturing treatment, and promoting the formation of the smooth inclined surface 181 after the first texturing treatment.

In some embodiments, referring to FIG. 36, the energy of the laser spot is irradiance of the laser spot. Along the direction from the center to the edge of the laser spot, the irradiance of the laser spot is increased by 0.016 J/mm² to 0.095 J/mm² per 1 µm distance in the second stage II, and the irradiance of the laser spot is decreased by 0.01 J/mm² to 0.04 J/mm² per 1 µm distance in the third stage III.

It should be noted that setting the growth rate of the irradiance of the laser spot in the second stage II being greater than the decrease rate of the irradiance of the laser spot in the third stage III is advantageous to eventually form a bottom surface 131 with a longer length in the first direction X, as well as to form a smooth inclined surface 181 with less steep. In addition, setting the growth rate of the irradiance of the laser spot in the second stage II to be modest is beneficial for the first texturing treatment to form the smooth inclined surface 181 and form the first pyramids 131a on the bottom surface 131.

In some examples, along the direction from the center to the edge of the laser spot, the amount of the irradiance of the laser spot increased per 1 µm distance in the second stage II may be 0.017 J/mm², 0.02 J/mm², 0.025 J/mm², 0.03 J/mm², 0.035 J/mm², 0.04 J/mm², 0.045 J/mm², 0.05 J/mm², 0.055 J/mm², 0.06 J/mm², 0.065 J/mm², 0.07 J/mm², 0.075 J/mm², 0.08 J/mm², 0.085 J/mm², or 0.09 J/mm², etc.

In some examples, along the direction from the center to the edge of the laser spot, the amount of the irradiance of the laser spot decreased per 1 µm distance in the third stage III may be 0.011 J/mm², 0.012 J/mm², 0.013 J/mm², 0.014 J/mm², 0.015 J/mm², 0.016 J/mm², 0.017 J/mm², 0.018 J/mm², 0.019 J/mm², 0.02 J/mm², 0.021 J/mm², 0.022 J/mm², 0.023 J/mm², 0.024 J/mm², 0.025 J/mm², 0.026 J/mm², 0.027 J/mm², 0.028 J/mm², 0.029 J/mm², 0.03 J/mm², 0.031 J/mm², 0.032 J/mm², 0.033 J/mm², 0.034 J/mm², 0.035 J/mm², 0.036 J/mm², 0.037 J/mm², 0.038 J/mm², or 0.039 J/mm², etc.

In some embodiments, referring to FIG. 36, the first preset value may range from 0.01J/mm² to 0.02J/mm², and for example, may be 0.011 J/mm², 0.012 J/mm², 0.013 J/mm², 0.014 J/mm², 0.015 J/mm², 0.016 J/mm², 0.017 J/mm², 0.018 J/mm², or 0.019 J/mm², etc. The second preset value may range from 0.1J/mm² to 0.2J/mm², and for example, may be 0.11 J/mm², 0.12 J/mm², 0.13 J/mm², 0.14 J/mm², 0.15 J/mm², 0.16 J/mm², 0.17 J/mm², 0.18 J/mm², or 0.19 J/mm², etc.

In some examples, irradiating the initial substrate 110 with the laser spot shown in FIG. 36 is beneficial to forming the third damage layer with thickness remaining unchanged first, then gradually increasing, and finally gradually decreasing to zero along the direction from the center of the initial second region 150 to the initial first region 140.

In some embodiments, referring to FIG. 35, and FIG. 29 to FIG. 31, the first texturing treatment uses a first etching solution that include potassium hydroxide and water, and a ratio of potassium hydroxide to water ranges from 0.002:1 to 0.01:1, and for example, may be 0.003, 0.004, 0.005, 0.006, 0.007, 0.008, or 0.009, etc.

In some embodiments, a treatment duration of the first texturing treatment ranges from 100 s to 200 s, and for example, may be 105s, 110s, 115s, 120s, 125s, 130s, 135s, 140s, 145s, 150s, 155s, 160s, 165s, 170s, 175s, 180s, 185s, 190s, or 195s, etc. It should be noted that, the irradiation range of the laser spot corresponding to the second stage II on the initial second region 150 is increased to control a higher degree of damage inside the damage layer 104 corresponding to the finally formed smooth inclined surface 181, to enhance the etching degree of the first texturing treatment on the damage layer 104 corresponding to the finally formed slope 141 and on the initial substrate 110, and also to reduce the process duration of the first texturing treatment, so that the smooth inclined surface 181 can be formed in a short time and the depth of the formed groove 151 can be reduced.

In some embodiments, a process temperature of the first texturing treatment ranges from 65°C to 75°C, and for example, may be 66°C, 67°C, 68°C, 69°C, 70°C, 71°C, 72°C, 73°C, or 74°C, etc.

In some embodiments, with reference to FIG. 29, FIG. 32, FIG. 37 and FIG. 38, the method for manufacturing the photovoltaic cell further includes:
referring to FIG. 29 and FIG. 32, performing a high-temperature treatment or a high-temperature doping treatment on the grooves 151 to form a first protective layer 103 to cover the bottom surface 131 and the smooth inclined surface 181,
referring to FIG. 32 and FIG. 37, forming a first doped semiconductor layer 105 on the second surface 102, where the first doped semiconductor layer 105 is also located on a portion of the first surface 101, and
referring to FIG. 37 and FIG. 38, performing an etching process on the first doped semiconductor layer 105 located on the first surface 101 with the first protective layer 103 as an etching barrier layer.

FIG. 37 is schematic diagram illustrating a partial cross-sectional view of forming a first doped semiconductor layer on a structure shown in FIG. 32. FIG. 38 is schematic diagram illustrating a partial cross-sectional view of performing an etching process on a structure shown in FIG. 37.

It should be noted that during the process of forming the first doped semiconductor layer 105 on the second surface 102, there may be a wrapping plating phenomenon, so the first doped semiconductor layer 105 may also be formed on some regions of the first surface 101. Subsequently, an etching process needs to be performed on the first doped semiconductor layer 105 located on the first surface 101. During the etching process, the first protective layer 103 may be used as an etching barrier layer to avoid the damage to the surface of the first pyramids 131a and the smooth inclined surfaces 181 caused by the etching process, thereby being beneficial to ensuring that the second region 121 has a relatively low reflectivity. In addition, the first protective layer 103 is beneficial to improving the optical performance of the second region 121 to further reduce the reflection loss of the second region 121. For example, the first protective layer 103 can reduce the reflectivity of the overall surface of the photovoltaic cell located in the second regions 121 to improve the absorption and utilization rate of the second region 121 of the first surface 101 for light, thereby improving the photoelectric conversion efficiency of the photovoltaic cell.

In some cases, the process temperature of the high-temperature treatment or the high-temperature doping treatment ranges from 900°C to 1050°C, and the treatment duration ranges from 2000 s to 5000 s.

In some examples, the process temperature of the high-temperature treatment or the high-temperature doping treatment may be 910°C, 920°C, 930°C, 940°C, 950°C, 960°C, 970°C, 980°C, 990°C, 1000°C, 1010°C, 1020°C, 1030°C, or 1040°C, etc.

In some examples, the treatment duration of the high-temperature treatment or the high-temperature doping treatment may be 2100 s, 2200 s, 2300 s, 2400 s, 2500 s, 2600 s, 2700 s, 2800 s, 2900 s, 3000 s, 3100 s, 3200 s, 3300 s, 3400 s, 3500 s, 3600 s, 3700 s, 3800 s, 3900 s, 4000 s, 4100 s, 4200 s, 4300 s, 4400 s, 4500 s, 4600 s, 4700 s, 4800 s, or 4900 s, etc.

In some cases, the high-temperature treatment may be an oxygen-free high-temperature process. Directly performing a high-temperature treatment on the groove 151 can transform a portion of the thickness of the substrate 100 corresponding to the groove 151 into the first protective layer 103. In some examples, the substrate 100 is a semiconductor material doped with a doping element. Based on the oxygen-free high-temperature process, it is beneficial to increasing the concentration of the doping element in a portion of the substrate 100 close to the groove 151, thereby forming the first protective layer 103 with a different doping element concentration from the doping element concentration in the remaining substrate 100. The material of the first protective layer 103 is also a semiconductor material including a doped doping element. It should be noted that after the first protective layer 103 is formed by the oxygen-free high-temperature process, the reflectivity of the overall surface of the photovoltaic cell located in the second region 121 can be reduced by about 0.1 to 0.3 on the original basis.

In some other cases, the high-temperature treatment may be an oxygen-containing high-temperature process. When a high-temperature treatment is performed on the groove 151, an oxidation treatment is also performed on the groove 151, which can oxidize a portion of the thickness of the substrate 100 corresponding to the groove 151 to form the first protective layer 103. In some examples, the substrate 100 may include a silicon material, and the first protective layer 103 including silicon oxide is formed based on the oxygen-containing high-temperature process. It should be noted that after the first protective layer 103 is formed by the oxygen-containing high-temperature process, the reflectivity of the overall surface of the photovoltaic cell located in the second regions 121 can be reduced by about 0.5 to 1 on the original basis.

In still some other cases, the high-temperature doping treatment may be an in-situ doped oxidation process. When a high-temperature treatment is performed on the groove 151, a doping treatment and an oxidation treatment are also performed on the groove 151, so that a portion of the thickness of the substrate 100 corresponding to the groove 151 is transformed into the first protective layer 103, and the first protective layer 103 includes an oxidized material doped with a doping element. In some examples, the substrate 100 may include a silicon material, and the first protective layer 103 including phosphosilicate glass or borosilicate glass is formed based on the in-situ doped oxidation process.

It should be noted that after the first protective layer 103 is formed by the source-pass high-temperature process, the reflectivity of the overall surface of the photovoltaic cell located in the second regions 121 can be reduced by about 0.5 to 1 on the original basis. In addition, phosphosilicate glass or borosilicate glass are only two examples of the first protective layer 103 formed based on the in-situ doped oxidation process. In practical applications, the doping source provided in the in-situ doped oxidation process may include other group V elements or other group III elements.

In other embodiments, in the operation of performing high temperature treatment on the groove 151, no additional film layer may be formed, and the high temperature provided by the high temperature treatment only repairs the laser damage to reduce the defect state density on the surface of the groove 151, thereby reducing the recombination center of the carriers at the groove 151, and enhancing the photovoltaic cell photovoltaic conversion efficiency.

In some cases, during the process of forming the first doped semiconductor layer 105, a first dielectric layer (not shown in the drawings) is formed on a side of the first doped semiconductor layer 105 away from the second surface 102. In one example, the substrate 100 is an N-type semiconductor substrate, the first doped semiconductor layer 105 is polysilicon doped with N-type doping elements, and the material of the first dielectric layer may be phosphor-silicon glass.

Based on this, the operation of performing the etching process on the first doped semiconductor layer 105 disposed on the first surface 101 may include: removing the first dielectric layer disposed on the first surface 101 using a chain hydrofluoric acid process, and removing the first doped semiconductor layer 105 uncovered by the first dielectric layer using an alkali polishing process, such that the first doped semiconductor layer 105 disposed on the second surface 102 is retained.

In some cases, referring to FIG. 33, prior to forming the first doped semiconductor layer 105, the manufacturing method may further include: forming a tunneling layer 108 on the second surface 102. Subsequently, forming the first doped semiconductor layer 105 on a side of the tunneling layer 108 away from the substrate 100. It should be noted that there is no limitation on the process of forming the tunneling layer 108 in the manufacturing method.

In some embodiments, referring to FIG. 10 and FIG. 15, after providing the initial substrate 110 and before irradiating the initial second surface 150 using the laser spot with gradual change in energy, the method for manufacturing the photovoltaic cell may also include:
referring to FIG. 10 and FIG. 15, performing a second texturing treatment on the initial first surface 120, so that the initial first surface 120 includes a plurality of third pyramids 111a, and
continuing to refer to FIG. 15, performing a doping treatment on the initial first surface 120 to transform a portion of a thickness of the initial substrate 110 into the second doped semiconductor layer 106, and forming a second protective layer 107 on a side of the second doped semiconductor layer 106 away from the initial substrate 110.
Referring to FIG. 15 and FIG. 30, in the operation of performing the first texturing treatment on the initial second regions 150, the second doped semiconductor layer 106 located in the initial first regions 140 is retained with the second protective layer 107 as an etching barrier layer, and the initial first regions 140 is provided as a third textured surface including a plurality of third pyramids 111a.

It should be noted that the initial first surface 120 includes a plurality of third pyramids 111a, which is beneficial to subsequently forming the first region 111 as a third textured surface including a plurality of third pyramids 111a. In addition, different texturing treatments are respectively used to form the initial first surface 120 including a plurality of third pyramids 111a and the grooves 151.

Moreover, referring to FIG. 15 and FIG. 35, during the process of irradiating the initial second region 150 using the laser spot with gradual change in energy in operation S2, both the second protective layer 107 and the second doped semiconductor layer 106 located on the initial second region 150 are transformed into the damage layer 104. Referring to FIG. 15 and FIG. 30, the second protective layer 107 located on the initial first region 140 that is not irradiated by the laser spot may be used as an etching barrier layer in operation S3 to achieve that only the first regions 111 are retained as a third textured surface including a plurality of third pyramids 111a. That is, referring to FIG. 33, the remaining second doped semiconductor layer 106 is only located on the first regions 111 to be used as a selective emitter structure on the first surface 101, which is beneficial to reducing the contact resistance between the subsequently formed second electrodes and the second doped semiconductor layer 106 and reducing the recombination probability of carriers in other regions of the first surface 101, so as to improve the photoelectric conversion efficiency of the finally formed photovoltaic cell.

In one example, the substrate 100 is an N-type semiconductor substrate, the second doped semiconductor layer 106 is a semiconductor material doped with a P-type doping element, such as a boron diffusion layer, and the material of the second protective layer 107 may be borosilicate glass.

It should be noted that the dimensional relationship between the first pyramid 131a and the third pyramid 111a is the same as in the previous embodiments and will not be repeated herein.

In some cases, referring to FIG. 37 and FIG. 38, after the alkaline polishing process is used to remove the first doped semiconductor layer 105 not covered by the first dielectric layer, to retain the first doped semiconductor layer 105 located on the second surface 102, the manufacturing method may also include: referring to FIG. 15 and FIG. 30, removing the remaining second protective layer 107 located on the initial first regions 140 by using the acid cleaning process. It should be noted that by controlling the process parameters of the acid cleaning process, such as the process duration, the second protective layer 107 is removed and the first protective layer 103 is retained by means of the acid cleaning process, or both the second protective layer 107 and the first protective layer 103 are removed by means of the acid cleaning process.

In some cases, referring to FIG. 33, after forming the first doped semiconductor layer 105 and the second doped semiconductor layer 106, the manufacturing method may further include: forming a first passivation layer 118 located on a side of the first doped semiconductor layer 105 away from the tunneling layer 108, forming a second passivation layer 128 located on a side of the second doped semiconductor layer 106 away from the substrate 100 and on the second regions 121, forming first electrodes 109 in ohmic contact with the first doped semiconductor layer 105, and forming second electrodes 119 embedded in the second passivation layer 128 and in ohmic contact with the second doped semiconductor layer 106.

In some examples, the first passivation layer 118 and the second passivation layer 128 may be formed by using an atomic layer deposition process and/or a plasma-enhanced chemical vapor deposition process. It should be noted that the second passivation layer 128 located on the first surface 101 and the first passivation layer 118 on the second surface 102 may be formed synchronously.

In some examples, the operations of forming the first electrodes 109 may include: using a screen printing process to print a metal paste on the surface of a portion of the first passivation layer 118 away from the second surface 102, and performing a sintering process on the metal paste. In some examples, the metal paste includes materials with high corrosiveness such as glass. Thus, during the sintering process, the corrosive components may at least corrode the first passivation layer 118, so that the metal paste penetrates from the first passivation layer 118 to the first doped semiconductor layer 105, thereby forming the first electrodes 109. It should be noted that the operations of forming the second electrodes 119 are similar to those of forming the first electrode 109, and reference may be made to the above description of the operations of forming the first electrodes 109.

In some examples, the metal paste may include at least one of silver, aluminum, copper, tin, gold, lead or nickel.

It should be noted that there is no restriction on the formation process of the first passivation layer 118, the second passivation layer 128, the first electrodes 109, and the second electrodes 119 in the manufacturing method provided in the embodiment of the present disclosure, and different formation processes may be selected according to the needs in practical application.

In summary, based on the design in operation S2 that along the direction from the center to the edge of the laser spot, the energy of the laser spot first remains unchanged, then gradually increases, and finally gradually decreases to zero, which is conducive to forming the damage layer 104 with different thickness in different regions or the degree of internal destruction vary in operation S2. On this basis, in operation S3, the time taken by the first texturing treatment to remove the different thicknesses of the damage layer 104 is different, the first texturing treatment exposes the initial substrate 110 covered by different portions of the damage layer 104 at different moments, so as to realize that the texturing treatment is carried out on some regions of the remaining initial substrate 110. Thus, it is advantageous to form the groove 151 jointly enclosed by the bottom surface 131 and the smooth inclined surface 181, and the bottom surface 131 is provided as a first texturing surface including a plurality of first pyramids 131a.

Another embodiment of the present disclosure further provides a photovoltaic module, which is configured to convert received light energy into electrical energy. The photovoltaic module provided in another embodiment of the present disclosure will be described in detail with reference to the accompanying drawings. It should be noted that the same or corresponding parts as those in the foregoing embodiments will not be described again herein.

Referring to FIG. 29 to FIG. 32, and FIG. 16 and FIG. 17, the photovoltaic module includes: at least one cell string, each formed by connecting a plurality of photovoltaic cells 40 provided in the embodiments shown in FIG. 29 to FIG. 34, or formed by connecting a plurality of photovoltaic cells 40 formed by the method for manufacturing the photovoltaic cell provided in the embodiments shown in FIG. 35 to FIG. 38, at least one encapsulation adhesive film 41, configured to cover a surface of the at least one cell string, and at least one cover plate 42, configured to cover a surface of the at least one encapsulation adhesive film 41 away from the at least one cell string. The photovoltaic cells 40 are electrically connected in the form of a whole sheet or multiple sheets to form the at least one cell strings, and the at least one cell strings are electrically connected in series and/or in parallel.

Those skilled in the art can understand that the above various implementation manners are specific embodiments for implementing the present disclosure. In practical applications, various changes can be made in form and details without departing from the spirit and scope of the embodiments of the present disclosure. Any skilled in the art can make various modifications and alterations without departing from the spirit and scope of the embodiments of the present disclosure. Therefore, the protection scope of the embodiments of the present disclosure should be subject to the scope defined by the claims.

## Claims

1. A photovoltaic cell, comprising:
a substrate, having a first side and a second side opposite to each other, wherein the first side includes first regions and second regions alternately arranged in a first direction; and
grooves, recessed into the substrate, wherein a respective groove of the grooves is located in a respective second region of the second regions on the first side and has a bottom surface, and a side wall connecting the bottom surface to two adjacent first region sandwiching the respective second region; at least one section of the side wall is inclined towards one of the two adjacent first regions connected to the sidewall;
wherein the bottom surface has a first textured surface that includes a plurality of first pyramids, the side wall has a second textured surface that includes a plurality of second pyramids, and a first pyramid of the plurality of first pyramids has a height greater than a height of a second pyramid of the plurality of second pyramids.

2. The photovoltaic cell according to claim 1, wherein the side wall includes one slope, forming the second textured surface including the plurality of second pyramids.

3. The photovoltaic cell according to claim 2, wherein a portion of the plurality of second pyramids have pits at their apexes.

4. The photovoltaic cell according to claim 3, wherein a volume ratio of a single pit to the second pyramid having the single pit is in a range of 0.01 to 0.2.

5. The photovoltaic cell according to any one of claims 2 to 4, wherein in a same groove, along the first direction, the bottom surface has a first length, the slope has a second length, and a ratio of the second length to the first length is in a range of 0.001 to 0.01.

6. The photovoltaic cell according to any one of claims 2 to 5, wherein an inclination angle of the slope inclined towards the first region is in a range of 40° to 55°.

7. The photovoltaic cell according to any one of claims 2 to 6, wherein the single groove has a depth in a range of 4 µm to 6 µm.

8. The photovoltaic cell according to any one of claims 1 to 7, wherein a single first region of the first regions is provided as a third textured surface including a plurality of third pyramids;
the first pyramids, the second pyramids and the third pyramids satisfy any one or any combination of the following relationships:
a base size of a single third pyramid is smaller than a base size of the single second pyramid and a base size of the single first pyramid;
a height of the single second pyramid is less than a height of the single third pyramid;
a reflectivity of the second textured surface is less than a reflectivity of the first textured surface and a reflectivity of the third textured surface; and
vertex angles of the first pyramids, the second pyramids and the third pyramids are in a range of 65° to 80°.

9. The photovoltaic cell according to any one of claims 1 to 8, further comprising: a first protective layer at least covering surface of the plurality of first pyramids.

10. The photovoltaic cell according to claim 9, wherein the first protective layer covers the bottom surface and the side wall.

11. The photovoltaic cell according to claim 9 or claim 10, wherein the first protective layer is made from at least one of a semiconductor material doped with a doping element, silicon oxide, phosphosilicate glass and borosilicate glass.

12. The photovoltaic cell according to any one of claims 1 to 11, further comprising: electrodes at least located on the first surface, and the electrodes are used to extract the photo-generated carriers generated in the substrate;
wherein the first regions include at least regions where orthographic projection of the electrodes on the substrate are located.

13. The photovoltaic cell according to any one of claims 1 to 12, further comprising:
a tunneling layer, located on the second surface;
a first doped semiconductor layer, doped with a first doping element and located on a side of the tunneling layer away from the second surface;
a second doped semiconductor layer, doped with a second doping element and located on the first regions, a conductivity type of the first doping element being different from a conductivity type of the second doping element;
a first passivation layer, located on a side of the first doped semiconductor layer away from the tunneling layer;
a second passivation layer, located on a side of the second doped semiconductor layer away from the substrate and located on the second regions;
first electrodes, in ohmic contact with the first doped semiconductor layer; and
second electrodes, embedded in the second passivation layer and in ohmic contact with the second doped semiconductor layer.

14. The photovoltaic cell according to any one of claims 1 to 12, further comprising:
a tunneling layer, located on the second surface;
a first doped semiconductor layer, doped with a first doping element and located on a side of the tunneling layer away from the second surface;
a second doped semiconductor layer, doped with a second doping element and located on the first regions, a conductivity type of the first doping element being different from a conductivity type of the second doping element;
a first protective layer, located on the second regions;
a first passivation layer, located on a side of the first doped semiconductor layer away from the tunneling layer;
a second passivation layer, located on a side of the second doped semiconductor layer away from the substrate and located on the second regions;
first electrodes, in ohmic contact with the first doped semiconductor layer; and
second electrodes, embedded in the second passivation layer and in ohmic contact with the second doped semiconductor layer.

15. A photovoltaic module, comprising:
at least one cell string, each formed by connecting a plurality of photovoltaic cells according to any one of claims 1 to 14;
at least one encapsulation adhesive film, configured to cover a surface of the at least one cell string; and
at least one cover plate, configured to cover a surface of the at least one encapsulation adhesive film away from the at least one cell string.
